# EUROPÄISCHE PATENTSCHRIFT

(11) **EP 4 419 926 B1**
(45) Veröffentlichungstag und Bekanntmachung des Hinweises auf die Patenterteilung: **29.10.2025**
(21) Anmeldenummer: 22790227.7
(22) Anmeldetag: 30.09.2022
(51) Int. Cl.: G01R 19/25

(54) **VORRICHTUNG UND VERFAHREN ZUR ERFASSUNG EINES ELEKTRISCHEN LEITUNGSSTROMES MIT OPTIMIERTER ABTASTRATE**
DEVICE AND METHOD FOR DETECTING AN ELECTRICAL CURRENT WITH AN OPTIMISED SAMPLING RATE
DISPOSITIF ET PROCÉDÉ DE DÉTECTION D'UN COURANT ÉLECTRIQUE AVEC FRÉQUENCE D'ÉCHANTILLONNAGE OPTIMISÉE

(30) Priorität: 19.10.2021 DE 102021127119; 19.10.2021 DE 102021127122; 19.10.2021 DE 102021127129
(43) Veröffentlichungstag der Anmeldung: 28.08.2024
(73) Patentinhaber: Elmos Semiconductor SE, 51379 Leverkusen (DE)
(72) Erfinder: WAGENKNECHT, Christian, 01219 Dresden (DE)
(86) Internationale Anmeldenummer: PCT/DE2022/100731
(87) Internationale Veröffentlichungsnummer: WO 2023/066423

(56) Entgegenhaltungen:
- DE-B3- 102011 078 698
- US-A1- 2006 158 363
- RITO0NIEMI T ET AL: "FULLY DIFFERENTIAL CMOS SIGMA-DELTA MODULATOR FOR HIGH PERFORMANCE ANALOG-TO-DIGITAL CONVERSION WITH 5 V OPERATING VOLTAGE", PROCEEDINGS OF THE INTERNATIONAL SYMPOSIUM ON CIRCUITS AND SYSTEMS. ESPOO, FINLAND, JUNE 7 - 9, 1988; [PROCEEDINGS OF THE INTERNATIONAL SYMPOSIUM ON CIRCUITS AND SYSTEMS], NEW YORK, IEEE, US, vol. 3 OF 03, 7 June 1988 (1988-06-07), pages 2321 - 2326, XP000094408, ISBN: 978-951-721-241-0, DOI: 10.1109/ISCAS.1988.15409

## Beschreibung

Die Erfindung betrifft eine Vorrichtung und ein Verfahren zu Erfassung eines Stromwerts eines Leitungsstromes mittels eines Shunt-Widerstands. Dabei treten auch sehr kleine Ströme auf. Diese sehr kleinen Ströme führen zu sehr kleinen Spannungsabfällen an dem Shunt-Widerstand.

Bei einer Analog-Digital-Wandlung solcher, sehr kleiner Eingangssignale mit sehr kleinen Spannungswerten für den Spannungsabfall an dem Shunt-Widerstand führt die zur Rauschunterdrückung benötigte Mittelung mehrerer Messwerte zu langen Wandelzeiten. Diese langen Wandelzeiten sind jedoch in vielen Anwendungen kritisch.

Bei der Analog-Digital-Wandlung von sehr kleinen Eingangssignalen führt Rauschen bei konstantem Eingangssignal zu verschiedenen Digital-Werten. Eine Überabtastung durch ein Mitteln über mehrere Zyklen kann diesen Einfluss reduzieren (Over-Sampling und Decimation - OSR). Dadurch erhöht sich jedoch die Zeit bis ein gültiger Wert der Messung zur Verfügung steht. Für Eingangssignale mit einer größeren Amplitude spielt dieser Effekt eine untergeordnete Rolle, da in diesem Bereich andere Störgrößen die Gesamtgenauigkeit bestimmen wie zum Beispiel die Referenz, der Temperaturgang und der Verstärkungs-Fehler.

Zur Erhöhung des Rauschabstands (Englisch Signal-to-Noise-Ratios [SNR]) bei kleinen Eingangssignalen erhöht die Vorrichtung die Anzahl der Messungen (Englisch Over-Sampling Rate[OSR]), wobei die Vorrichtung die Messungen anschließend mittelt. Für jede Verdoppelung der Genauigkeit benötigt die Vorrichtung eine Vervierfachung der Anzahl der Messungen, die die Vorrichtung zur Ermittlung des Messergebnisses benötigt. Dieser Bedarf führt schnell zu einer sehr hohen Anzahl notwendiger Abtastungen (Messungen), die die Vorrichtung für einen Messdurchgang mittelt. Diese hohe Anzahl an Messungen führt sehr langen Wandelzeiten.

Die DE 10 2011 078 698 B3 offenbart eine Vorrichtung zur Erfassung eines elektrischen Leitungsstromes in einer Leitung. Jedoch ist es mit der in der DE 10 2011 078 698 B3 offenbarten Vorrichtung nicht möglich eine Strommessung mit einem guten Rauschabstand auch bei kleinen Eingangssignale zu erzielen.

Aufgabe der Erfindung ist es eine Lösung zu schaffen, die die obigen Nachteile des Stands der Technik nicht aufweist und weitere Vorteile aufweist. Insbesondere soll eine verbesserte Vorrichtung zur Strommessung bereitzustellen.

Zur Lösung der Aufgabe wird eine Vorrichtung, sowie ein Verfahren gemäß den unabhängigen Ansprüchen vorgeschlagen.

Weitere vorteilhafte Ausgestaltungen der Erfindung sind den abhängigen Ansprüchen, der Beschreibung, sowie den Figuren zu entnehmen.

Die Erfindung umfasst eine dynamische Anpassung der Mittelung der Messwerte, welche Messwerte von einer Auswerteelektronik an einem Sensorelement eines Sensors erfasst werden.

Die Auswerteelektronik umfasst einen Analog-Digital-Wandler.

Während der Erfassung der Messwerte passt die Auswerteelektronik eine Geschwindigkeit ihres Analog-Digital-Wandlers entsprechend einer Größe eines Eingangssignals der Auswerteelektronik dynamisch an, so dass eine für das Eingangssignal optimale Wandlung erfolgt.

Die Anzahl der Messungen, die die Auswertelektronik an dem Sensorelement je Zeiteinheit durchführt, ist damit dann abhängig von der Größe des Eingangssignales, also dem Pegel am Sensorelement des Sensors. Für kleine Eingangssignale wählt die Auswerteelektronik eine deutlich größere Anzahl an Abtastpunkten und damit Messwerten, um in diesem Bereich eine gute Rauschunterdrückung (Englisch Signal-to-Noise-Ratio [SNR]) zu erhalten. Im Bereich größerer Eingangsspannungen wählt die Auswerteelektronik eine kleinere Abtastrate und damit eine kleinere Überabtastungsrate (Englisch Over-Sampling Rate[OSR]). Gleichzeitig kann die Auswerteelektronik bei geeigneter Struktur die Geschwindigkeit ihres Untersystems aus Analog-Digital-Wandler und des nachfolgenden Überabtastungs- und Dezimations-Filters invers zur Überabtastungsrate (OSR) ändern. Die Geschwindigkeit der Vorrichtung ergibt sich aus der Abtastrate des Analog-Digital-Wandlers multipliziert mit der Anzahl der Abtastwerte, die der nachfolgende Überabtastungs- und Dezimations-Filter für die Mittelung verwendet. Dies ist möglich, da bei kleinen Eingangsspannungen auch die Einschwingzeit auf 1 LSB kürzer ist, als bei großen Eingangsspannungen.

Die Erfindung betrifft eine Vorrichtung zur Erfassung eines elektrischen Leitungsstromes I_{LTG} in einer Leitung. Der elektrische Leitungsstrom I_{LTG} fließt dabei von einem ersten Knoten zu einem dritten Knoten. Die Vorrichtung weist einen Shunt-Widerstand auf. Die Vorrichtung umfasst einen ersten Widerstand. Der Wert des ersten Widerstands kann 0 Ohm sein. Der erste Widerstand kann also auch nur ein Leitungsstück einer elektrischen Leitung sein. Die Vorrichtung umfasst einen zweiten Widerstand. Der Wert des zweiten Widerstands kann 0 Ohm sein. Der zweite Widerstand kann also auch nur ein Leitungsstück einer elektrischen Leitung sein.

Der Shunt-Widerstand weist typischerweise einen ersten Anschluss und einen zweiten Anschluss auf. Der erste Widerstand weist einen ersten Anschluss und einen zweiten Anschluss auf. Der zweite Widerstand weist einen ersten Anschluss und einen zweiten Anschluss auf.

Der erste Knoten verbindet den ersten Anschluss des Shunt-Widerstands direkt oder indirekt elektrisch mit dem ersten Anschluss des ersten Widerstands.

Der dritte Knoten verbindet den zweiten Anschluss des Shunt-Widerstands direkt oder indirekt elektrisch mit dem ersten Anschluss des zweiten Widerstands.

Der elektrische Leitungsstrom I_{LTG} durchströmt den Shunt-Widerstand.

Die Vorrichtung hat den Zweck, den Wert des elektrischen Leitungsstroms I_{LTG} zu ermitteln.

Insbesondere umfasst die Vorrichtung einen Verstärker und einen Analog-Digital-Wandler. Insbesondere umfasst die Vorrichtung einen Überarbeitungs- und Dezimationsfilter.

Insbesondere ist der Überarbeitungs- und Dezimationsfilter ein linearer Filter. Dies hat zur Folge, dass eine Erhöhung des Eingangssignals eine entsprechende proportionale Änderung des Ausgangssignals zur Folge hat.

Insbesondere umfasst die Vorrichtung einen Signalpfad. Insbesondere erstreckt sich der Signalpfad von dem Shunt-Widerstand bis zu dem Ausgang des Überabtastungs- und Dezimations-Filters. Dabei dient der Shunt-Widerstand als Signalquelle und der Überabtastungs- und Dezimations-Filter als Messwertausgabe.

Insbesondere umfasst der Signalpfad den Verstärker und den Analog-Digital-Wandler. Insbesondere ist der Verstärker zwischen dem Shunt-Widerstand und dem Ausgang des Überabtastungs- und Dezimations-Filters angeordnet.

Insbesondere ist der Analog-Digital-Wandler zwischen dem Shunt-Widerstand und dem Ausgang des Überabtastungs- und Dezimations-Filters angeordnet.

Der Verstärker weist einen positiven Eingang (+) auf. Weiter weist der Verstärker einen negativen Eingang (-) auf. Weiter weist der Verstärker einen Ausgang in Form eines Ausgangssignals des Verstärkers auf.

Der Analog-Digital-Wandler weist einen analogen Eingang und ein digitales Ausgangssignal auf.

Der Überarbeitungs- und Dezimationsfilter weist einen digitalen Eingang und einen Ausgang mit einem Ausgangssignal auf.

Ein zweiter Knoten verbindet den zweiten Anschluss des ersten Widerstands direkt oder indirekt elektrisch über einen Vorfilter mit dem positiven Eingang + des Verstärkers.

Ein vierter Knoten verbindet den zweiten Anschluss des zweiten Widerstands direkt oder indirekt elektrisch über den Vorfilter mit dem negativen Eingang - des Verstärkers.

Der Ausgang des Verstärkers ist mit dem Eingang des Analog-Digital-Wandlers elektrisch verbunden. Der digitale Ausgang des Analog-Digital-Wandlers ist elektrisch mit dem Eingang des Überabtastungs- und Dezimationsfilters verbunden. Der digitale Ausgang des Analog-Digital-Wandlers kann typischerweise mehrere elektrische Leitungen umfassen. Der Analog-Digital-Wandler tastet zu Abtastzeitpunkten den analogen Wert des Eingangssignals des Analog-Digital-Wandlers ab. Bevorzugt sind die Abtastzeitpunkte periodisch mit einer zeitlichen Abtastperiode. Der Kehrwert der Abtastperiode ist im Sinne dieser Schrift die Abtastfrequenz. Die Abtastfrequenz geteilt durch 2π ist im Sinne dieser Schrift die Abtastrate. Zur Bestimmung einer Abtastperiode erfasst im Sinne dieser Schrift eine geeignete Messvorrichtung den zeitlichen Abstand zwischen einem ersten Abtastzeitpunkt und einem unmittelbar zeitlich nachfolgenden zweiten Abtastzeitpunkt. Zu diesen Abtastzeitpunkten wandelt der Analog-Digital-Wandler den analogen Wert des Eingangssignals des Analog-Digital-Wandlers in einen digitalen Wert. Der Analog-Digital-Wandler gibt diesen digitalen Wert als digitales Ausgangssignal aus. Der Analog-Digital-Wandler signalisiert nach dieser Abtastung mittels des digitalen Ausgangssignals den betreffenden Abtastwert an den Eingangs des Überabtastungs- und Dezimations-Filters.

Die Ausgangswerte des Ausgangssignals des Überarbeitungs- und Dezimationsfilters stellen dabei zumindest zeitweise die durch die Vorrichtung erfassten Stromwerte für einen Leitungsstrom I_{LTG} durch den Shunt-Widerstand dar. Die Begrenzung auf "zeitweise" kommt dadurch zustande, dass der Analog-Digital-Wandler nur zu den Abtastzeitpunkten den Stromwert des Leitungsstromes I_{LTG} erfassen kann. Im Gegensatz zum Stand der Technik schlägt die hier vorgelegte Schrift nun vor, dass die Vorrichtung zusätzlich eine Zeitgebereinheit umfasst. Insbesondere erfasst die Zeitgebereinheit zumindest ein Zeitgebereingangswertsignal. Der Wert eines solchen Zeitgebereingangswertsignals bezeichnet die hier vorgelegte Schrift im Folgenden auch als Zeitgebereingangswert.

Insbesondere erfasst die Zeitgebereinheit zumindest einen jeweiligen Zeitgebereingangswert. Bevorzugt erfasst die Zeitgebereinheit mehrere Zeitgebereingangswerte.

Auf die Natur der beispielhaft vorgeschlagenen Zeitgebereingangswertsignale und der zugehörigen beispielhaft vorgeschlagenen Zeitgebereingangswert geht die hier vorgelegte Schrift im Folgenden noch genauer ein
Die Kernidee der Erfindung ist, dass die Zeitgebereinheit zumindest eine Signalübertragungseigenschaft einer Teilvorrichtung innerhalb des Signalpfads zwischen dem Shunt-Widerstand und dem Ausgangssignal des Überabtastungs- und Dezimations-Filters in Abhängigkeit von zumindest einen erfassten jeweiligen Zeitgebereingangswert zumindest zeitweise beeinflusst.

Im Sinne dieser Schrift sind die beispielhaften Teilvorrichtungen innerhalb des Signalpfads zwischen dem Shunt-Widerstand und dem Ausgangssignal des Überabtastungs- und Dezimations-Filters
a) ein Vorfilter,
b) der Verstärker und
c) der Analog-Digital-Wandler und der Überabtastungs- und Dezimations-Filter.

Mögliche Zeitgebereingangswertsignale im Sinne dieser Schrift sind:
- die Eingangsspannung Uₑ des Verstärkers,
- das Verstärkerausgangssignal des Verstärkers,
- das Eingangssignal des Analog-Digital-Wandlers,
- das Ausgangssignal des Analog-Digital-Wandlers,
- das Eingangssignal des Überabtastungs- und Dezimations-Filters bzw. das Dezimationsfiltereingangssignal, und
- das Ausgangssignal des Überabtastungs- und Dezimations-Filters bzw. das Dezimationsfilterausgangssignal.

Insbesondere ist die Verwendung folgender Zeitgebereingangswertsignale bevorzugt:
- das Verstärkerausgangssignal des Verstärkers,
- das Eingangssignal des Analog-Digital-Wandlers und
- das Ausgangssignal des Überabtastungs- und Dezimations-Filters bzw. des Dezimationsfilterausgangssignals.

Diese Vorrichtung hat den Vorteil, dass die Vorrichtung bei kleinen Signalamplituden die Abtastrate erhöhen kann, während die Vorrichtung bei großen Signalamplituden eine längere Einschwingzeit berücksichtigen kann. Hierdurch optimiert die Vorrichtung die relative Auflösung bzw. die Zeit bis diese Auflösung erreicht wird.

In einer Ausgestaltung der Vorrichtung kann die Zeitgebereinheit zumindest einen, insbesondere mehrere, insbesondere alle Abtastzeitpunkte des Analog-Digital-Wandlers beeinflussen. Diese Beeinflussung ist eine Beeinflussung einer Signalübertragungseigenschaft in einer Teilvorrichtung im besagten Signalpfad. In dem Fall dieser Ausgestaltung ist die besagte Teilvorrichtung der Analog-Digital-Wandler. Vorschlagsgemäß führt die Vorrichtung diese Beeinflussung der Signalübertragungseigenschaft des Analog-Digital-Wandlers in dieser Ausgestaltung in Abhängigkeit von dem zumindest einen erfassten jeweiligen Zeitgebereingangswert durch. Mögliche Zeitgebereingangswerte sind weiter oben beschrieben. In dieser Ausgestaltung der Vorrichtung kann die Zeitgebereinheit beispielsweise auch eine Filter- oder Verstärkereigenschaft in dem Signalpfad zwischen dem Shunt-Widerstand und dem Ausgangssignal des Überabtastungs- und Dezimations-Filters als Signalübertragungseigenschaft in Abhängigkeit von dem zumindest einen erfassten jeweiligen Zeitgebereingangswert beeinflussen. Hierdurch kann die Zeitgebereinheit der Vorrichtung die Abtastrate an einen Pegel es Eingangssignals, also an den Stromwert des Leitungsstromes I_{LTG} anpassen. Hierdurch kann darüber hinaus die Zeitgebereinheit der Vorrichtung auch die Filter umkonfigurieren. Dies ermöglicht eine optimale Anpassung der Filterung im Vorfilter und/oder eine optimale Anpassung der Filterung im Überabtastungs- und Dezimations-Filter an die Abtastrate des Analog zu Digital-Wandlers.

Eine weitere Ausgestaltung der Vorrichtung befasst sich mit einzelnen Abtastzeitpunkten.

In dieser Ausgestaltung der Vorrichtung erfasst die Zeitgebereinheit die Abtastzeitpunkte des Analog-Digitalwandlers in Abhängigkeit von dem zumindest einem erfassten jeweiligen Zeitgebereingangswert. Hierdurch kann die Zeitgebereinheit der Vorrichtung a) die Abtastrate an den Pegel es Eingangssignals, also an den Stromwert des Leitungsstromes I_{LTG}, optimal anpassen.

In einer weiteren Ausgestaltung der Vorrichtung beeinflusst die Zeitgebereinheit der Vorrichtung Eigenschaften des Überarbeitungs- und Dezimationsfilters in Abhängigkeit von dem zumindest einem erfassten jeweiligen Zeitgebereingangswert. Mögliche Zeitgebereingangswerte sind oben erläutert. Hierdurch kann die Zeitgebereinheit der Vorrichtung das Überarbeitungs- und Dezimationsfilter derart umkonfigurieren, dass die Filterung im Überabtastungs- und Dezimations-Filter beispielsweise an die Abtastrate des Analog zu Digital-Wandlers optimal angepasst ist.

In einer weiteren Ausgestaltung der Vorrichtung beeinflusst die Zeitgebereinheit der Vorrichtung Eigenschaften des Überarbeitungs- und Dezimationsfilters in Form von Filterfrequenzen und/oder Dämpfungen und/oder Verstärkungen des Überarbeitungs- und Dezimationsfilters in Abhängigkeit von dem zumindest einem erfassten jeweiligen Zeitgebereingangswert. Mögliche Zeitgebereingangswerte sind oben erläutert. Hierdurch kann die Zeitgebereinheit der Vorrichtung das Überarbeitungs- und Dezimationsfilter so umkonfigurieren, dass die Filterung im Überabtastungs- und Dezimations-Filter beispielsweise an die Abtastrate des Analog zu Digital-Wandlers optimal angepasst ist.

In einer weiteren Ausgestaltung der Vorrichtung beeinflusst die Zeitgebereinheit Eigenschaften des Vorfilters in Abhängigkeit von dem zumindest einem erfassten jeweiligen Zeitgebereingangswert.

In einer weiteren Ausgestaltung der Vorrichtung beeinflusst die Zeitgebereinheit Eigenschaften des Vorfilters in Form von Filterfrequenzen und/oder Dämpfungen und/oder Verstärkungen des Vorfilters in Abhängigkeit von dem zumindest einem erfassten jeweiligen Zeitgebereingangswert. Bevorzugt handelt es sich im Sinne dieser Schrift bei dem Vorfilter um einen Tiefpass- oder Bandpassfilter mit einer oberen Grenzfrequenz f_{oV}.

In einer weiteren Ausgestaltung der Vorrichtung ist beispielhaft ein Zeitgebereingangswertsignal das Eingangssignal des Analog-Digital-Wandlers. Der zugehörige Zeitgebereingangswert ist dann bevorzugt ein ADC-Eingangswert des Eingangssignals des Analog-Digital-Wandlers. Auch in dieser Variante kann die Vorrichtung den Relativen Fehler an den Signalpegel anpassen.

In einer weiteren Ausgestaltung der Vorrichtung erfasst beispielsweise die Zeitgebereinheit zumindest zeitweise Werte des Eingangssignals des Analog-Digitalwandlers in Form erfasster ADC-Eingangswerte als Zeitgebereingangswerte eines Zeitgebereingangswertsignals. Die Zeitgebereinheit beeinflusst dabei bevorzugt Abtastzeitpunkte des Analog-Digital-Wandlers in Abhängigkeit von erfassten ADC-Eingangswerten. Auch in dieser Variante kann die Vorrichtung den relativen Fehler an den Signalpegel anpassen.

In einer weiteren Ausgestaltung der Vorrichtung erfasst die Zeitgebereinheit zumindest zeitweise Werte des Eingangssignals des Analog-Digitalwandlers in Form erfasster ADC-Eingangswerte als Zeitgebereingangswerte eines Zeitgebereingangswertsignals. Die Zeitgebereinheit beeinflusst dabei bevorzugt Eigenschaften des Überarbeitungs- und Dezimationsfilters, insbesondere die Filterfrequenzen und/oder die Verstärkung und/oder die Dämpfung des Überarbeitungs- und Dezimationsfilters, in Abhängigkeit von erfassten ADC-Eingangswerten. Dies ermöglicht die optimale Anpassung des Überarbeitungs- und Dezimationsfilters, an die optimierte Abtastrate und den Signalpegel des Leitungsstromwerts des Leitungsstroms I_{LTG}.

In einer weiteren Ausgestaltung der Vorrichtung erfasst die Zeitgebereinheit zumindest zeitweise Werte des Eingangssignals des Analog-Digitalwandlers in Form erfasster ADC-Eingangswerte als Zeitgebereingangswerte eines Zeitgebereingangswertsignals. Dabei beeinflusst die Zeitgebereinheit Eigenschaften des Vorfilters, insbesondere die Filterfrequenzen und/oder die Verstärkung und/oder die Dämpfung des Vorfilters, in Abhängigkeit von erfassten ADC-Eingangswerten. Hierdurch passt die Vorrichtung den Vorfilter an die ggf. geänderten Abtastraten des Analog-Digital-Wandlers an.

In einer weiteren Ausgestaltung der Vorrichtung erfasst die Zeitgebereinheit zumindest zeitweise Werte des Eingangssignals des Analog-Digitalwandlers in Form erfasster ADC-Eingangswerte. Diese erfassten ADC-Eingangswerte dienen dann beispielsweise als Zeitgebereingangswerte eines Zeitgebereingangswertsignals. Diese Zeitgebereingangswerte des Zeitgebereingangswertsignals beeinflussen dann Eigenschaften des Verstärkers in Abhängigkeit von den so erfassten ADC-Eingangswerten. Die beeinflussten Eigenschaften des Verstärkers können insbesondere die Verstärkung und/oder die Dämpfung des Verstärkers umfassen. Hierdurch passt die Vorrichtung das Verhalten und Eigenschaften des Verstärkers an die ggf. geänderten Abtastraten des Analog-Digital-Wandlers und/oder die Amplitude des Leitungsstromwerts des Leitungsstromes I_{LTG} besser an.

In einer weiteren Ausgestaltung der Vorrichtung ist ein Zeitgebereingangswertsignal das Ausgangssignal des Analog-Digital-Wandlers. Ein zugehöriger Zeitgebereingangswert des Zeitgebereingangswertsignals ist dann ein ADC-Ausgangswert des Ausgangssignals des Analog-Digital-Wandlers.

In einer weiteren Ausgestaltung der Vorrichtung erfasst die Zeitgebereinheit bevorzugt zumindest zeitweise Werte des Ausgangssignals des Analog-Digitalwandlers in Form erfasster ADC-Ausgangswerte als Zeitgebereingangswerte eines Zeitgebereingangswertsignals und beeinflusst Abtastzeitpunkte in Abhängigkeit von erfassten ADC-Ausgangswerten. Bevorzugt beeinflusst die Zeitgebereinheit mehrere oder alle Abtastzeitpunkte in Abhängigkeit von erfassten ADC-Ausgangswerten.

In einer weiteren Ausgestaltung der Vorrichtung erfasst die Zeitgebereinheit zumindest zeitweise Werte des Ausgangssignals des Analog-Digitalwandlers. Diese erfassten Werte des Ausgangssignals des Analog-Digitalwandlers liegen bevorzugt in Form erfasster ADC-Ausgangswerte vor. Diese erfassten ADC-Ausgangswerte dienen als Zeitgebereingangswerte eines Zeitgebereingangswertsignals. Diese Zeitgebereingangswerte des Zeitgebereingangswertsignals beeinflussen Eigenschaften des Überarbeitungs- und Dezimationsfilters in Abhängigkeit von erfassten ADC-Ausgangswerten. Die beeinflussten Eigenschaften des Überarbeitungs- und Dezimationsfilters können insbesondere die Filterfrequenzen und/oder die Verstärkung und/oder die Dämpfung des Überarbeitungs- und Dezimationsfilters umfassen.

In einer weiteren Ausgestaltung der Vorrichtung erfasst die Zeitgebereinheit bevorzugt zumindest zeitweise Werte des Ausgangssignals des Analog-Digitalwandlers. Die erfassten Werte des Ausgangssignals des Analog-Digitalwandlers liegen bevorzugt in Form erfasster ADC-Ausgangswerte vor. Diese erfassten ADC-Ausgangswerte dienen bevorzugt als Zeitgebereingangswerte eines Zeitgebereingangswertsignals. Die Zeitgebereingangswerte des Zeitgebereingangswertsignals beeinflussen bevorzugt Eigenschaften des Vorfilters in Abhängigkeit von erfassten ADC-Ausgangswerten. Die beeinflussten Eigenschaften des Vorfilters können insbesondere die Filterfrequenzen und/oder die Verstärkung und/oder die Dämpfung des Vorfilters umfassen.

In einer weiteren Ausgestaltung der Vorrichtung erfasst die Zeitgebereinheit zumindest zeitweise Werte des Ausgangssignals des Analog-Digitalwandlers. Die Werte des Ausgangssignals des Analog-Digitalwandlers liegen bevorzugt in Form erfasster ADC-Ausgangswerte vor. Diese erfassten erfasster ADC-Ausgangswerte dienen bevorzugt als Zeitgebereingangswerte eines Zeitgebereingangswertsignals. Die erfassten Zeitgebereingangswerte des Zeitgebereingangswertsignals beeinflussen Eigenschaften des Verstärkers in Abhängigkeit von erfassten ADC-Ausgangswerten. Die beeinflussten Eigenschaften des Verstärkers können insbesondere die Verstärkung und/oder die Dämpfung des Verstärkers umfassen.

In einer weiteren Ausgestaltung der Vorrichtung ist ein Zeitgebereingangswertsignal das Eingangssignal des Überabtastungs- und Dezimations-Filters. Dabei ist dann ein zugehöriger Zeitgebereingangswert ein Dezimationsfilter-Eingangswert des Eingangssignals des Überabtastungs- und Dezimations-Filters.

In einer weiteren Ausgestaltung der Vorrichtung erfasst die Zeitgebereinheit zumindest zeitweise Werte des Eingangssignals des Überabtastungs- und Dezimations-Filters. Die erfassten Werte des Eingangssignals des Überabtastungs- und Dezimations-Filters liegen bevorzugt in Form erfasster Dezimationsfilter-Eingangswerte vor. Diese erfassten Dezimationsfilter-Eingangswerte dienen bevorzugt als Zeitgebereingangswerte eines Zeitgebereingangswertsignals. Die Zeitgebereingangswerte des Zeitgebereingangswertsignals beeinflussen die Abtastzeitpunkte in Abhängigkeit von erfassten Dezimationsfilter-Eingangswerten.

In einer weiteren Ausgestaltung der Vorrichtung erfasst die Zeitgebereinheit zumindest zeitweise Werte des Eingangssignals des Überabtastungs- und Dezimations-Filters. Die erfassten Werte des Eingangssignals des Überabtastungs- und Dezimations-Filters liegen bevorzugt in Form erfasster Dezimationsfilter-Eingangswerte vor. Die erfassten Dezimationsfilter-Eingangswerte dienen bevorzugt als Zeitgebereingangswerte eines Zeitgebereingangswertsignals. Diese Zeitgebereingangswerte des Zeitgebereingangswertsignals beeinflussen bevorzugt Eigenschaften des Überarbeitungs- und Dezimationsfilters in Abhängigkeit von erfassten Dezimationsfilter-Eingangswerten. Solche Eigenschaften des Überarbeitungs- und Dezimationsfilters können dabei insbesondere die Filterfrequenzen und/oder die Verstärkung und/oder die Dämpfung des Überarbeitungs- und Dezimationsfilters sein.

In einer weiteren Ausgestaltung der Vorrichtung erfasst die Zeitgebereinheit zumindest zeitweise Werte des Eingangssignals des Überabtastungs- und Dezimations-Filters. Bevorzugt liegen die erfassten Werte des Eingangssignals des Überabtastungs- und Dezimations-Filters in Form erfasster Dezimationsfilter-Eingangswerte vor. Diese erfassten Dezimationsfilter-Eingangswerte dienen bevorzugt als Zeitgebereingangswerte eines Zeitgebereingangswertsignals. Diese Zeitgebereingangswerte des Zeitgebereingangswertsignals beeinflussen Eigenschaften des Vorfilters in Abhängigkeit von erfassten Dezimationsfilter-Eingangswerten. Dabei können Eigenschaften des Vorfilters insbesondere die Filterfrequenzen und/oder die Verstärkung und/oder die Dämpfung des Vorfilters sein.

In einer weiteren Ausgestaltung der Vorrichtung erfasst die Zeitgebereinheit zumindest zeitweise Werte des Eingangssignals des Überabtastungs- und Dezimations-Filters. Die Werte des Eingangssignals des Überabtastungs- und Dezimations-Filters liegen bevorzugt in Form erfasster Dezimationsfilter-Eingangswerte vor. Die erfassten Dezimationsfilter-Eingangswerte dienen dabei bevorzugt als Zeitgebereingangswerte eines Zeitgebereingangswertsignals. Die Zeitgebereinheit beeinflusst mittels dieser Zeitgebereingangswerte des Zeitgebereingangswertsignals die Eigenschaften des Verstärkers. Die Zeitgebereinheit beeinflusst somit in Abhängigkeit von erfassten Dezimationsfilter-Eingangswerten die Eigenschaften des Verstärkers. Dabei kann eine solche beeinflusste Eigenschaft des Verstärkers beispielsweise die Verstärkung und/oder die Dämpfung des Verstärkers sein.

In einer weiteren Ausgestaltung der Vorrichtung ist ein Zeitgebereingangswertsignal das Ausgangssignal des Überabtastungs- und Dezimations-Filters. In dieser Ausgestaltung ist beispielsweise ein entsprechender Zeitgebereingangswert ein Dezimationsfilter-Ausgangswert des Ausgangssignals des Überabtastungs- und Dezimations-Filters.

In einer weiteren Ausgestaltung der Vorrichtung erfasst die Zeitgebereinheit zumindest zeitweise Werte des Ausgangssignals des Überabtastungs- und Dezimations-Filters. Dieser Erfassung der Werte des Ausgangssignals des Überabtastungs- und Dezimations-Filters erfolgt bevorzugt in Form erfasster Dezimationsfilter-Ausgangswerte. Diese erfassten Dezimationsfilter-Ausgangswerte dienen bevorzugt als Zeitgebereingangswerte eines Zeitgebereingangswertsignals und beeinflusst Abtastzeitpunkte in Abhängigkeit von erfassten Dezimationsfilter-Ausgangswerten.

In einer weiteren Ausgestaltung der Vorrichtung erfasst die Zeitgebereinheit zumindest zeitweise Werte des Ausgangssignals des Überabtastungs- und Dezimations-Filters. Die Werte des Ausgangssignals des Überabtastungs- und Dezimations-Filters liegen bevorzugt in Form erfasster Dezimationsfilter-Ausgangswerte vor. Die erfassten Dezimationsfilter-Ausgangswerte dienen bevorzugt als Zeitgebereingangswerte eines Zeitgebereingangswertsignals. Die Zeitgebereingangswerte des Zeitgebereingangswertsignals beeinflussen bevorzugt Eigenschaften des Überarbeitungs- und Dezimationsfilters in Abhängigkeit von erfassten Dezimationsfilter-Ausgangswerten. Solche Eigenschaften des Überarbeitungs- und Dezimationsfilters können beispielsweise insbesondere die Filterfrequenzen und/oder die Verstärkung und/oder die Dämpfung des Überarbeitungs- und Dezimationsfilters sein.

In einer weiteren Ausgestaltung der Vorrichtung erfasst die Zeitgebereinheit zumindest zeitweise Werte des Ausgangssignals des Überabtastungs- und Dezimations-Filters in Form erfasster Dezimationsfilter-Ausgangswerte als Zeitgebereingangswerte eines Zeitgebereingangswertsignals. In dieser Ausgestaltung beeinflusst die Zeitgebereinheit Eigenschaften des Vorfilters in Abhängigkeit von erfassten Dezimationsfilter-Ausgangswerten. Solche Eigenschaften des Vorfilters können beispielsweise insbesondere die Filterfrequenzen und/oder die Verstärkung und/oder die Dämpfung des Vorfilters sein.

Im Sinne der hier vorgelegten Schrift stellt eine Abtastperiode die Zeit zwischen einem ersten Abtastzeitpunkt und einem zweiten Abtastzeitpunkt dar. Der erste Abtastzeitpunkt ist ein Zeitpunkt der Abtastung des analogen Werts des Eingangssignals des Analog-Digitalwandlers durch den Analog-Digitalwandler. Der zweite Abtastzeitpunkt ist ein zweiter Zeitpunkt der Abtastung des analogen Werts des Eingangssignals des Analog-Digitalwandlers durch den Analog-Digitalwandler, wobei der zweite Abtastzeitpunkt zeitlich unmittelbar dem ersten Abtastzeitpunkt nachfolgt.

In einer weiteren Ausgestaltung der Vorrichtung beeinflusst die Zeitgebereinheit die Abtastperiode des Analog-Digitalwandlers in Abhängigkeit von dem zumindest einem erfassten jeweiligen Zeitgebereingangswert.

Gemäß einer weiteren Ausgestaltung der Vorrichtung liegt die Dauer der Abtastperiode über dem Wert eines Abtastperiodengrenzwerts, wenn Beträge der erfassten ADC-Eingangswerte unter einem ersten ADC-Eingangsschwellwert liegen. Im entgegengesetzten Fall liegt die Dauer der Abtastperiode unter dem Wert des Abtastperiodengrenzwerts, wenn Beträge der erfassten ADC-Eingangswerte über dem ersten ADC-Eingangsschwellwert liegen.

Gemäß einer weiteren Ausgestaltung der Vorrichtung liegt die Dauer der Abtastperiode über einem Abtastperiodengrenzwert, wenn Beträge der erfassten ADC-Ausgangswerte unter einem ersten ADC-Ausgangsschwellwert liegen. Entgegengesetzt liegt in dieser Ausgestaltung der Vorrichtung die Abtastperiode bevorzugt unter dem Abtastperiodengrenzwert, wenn Beträge der erfassten ADC-Ausgangswerte über dem ersten ADC-Ausgangsschwellwert liegen.

Gemäß einer weiteren Ausgestaltung der Vorrichtung liegt die Abtastperiode über einem Abtastperiodengrenzwert, wenn Beträge der erfassten Dezimationsfilter-Eingangswerte unter einem ersten Dezimationsfilter-Eingangsschwellwert liegen. Insbesondere liegt die Abtastperiode unter dem Abtastperiodengrenzwert, wenn Beträge der erfassten Dezimationsfilter-Eingangswerte über dem ersten Dezimationsfilter-Eingangsschwellwert liegen.

Gemäß einer weiteren Ausgestaltung der Vorrichtung liegt die Abtastperiode über einem Abtastperiodengrenzwert, wenn Beträge der erfassten Dezimationsfilter-Ausgangswerte unter einem ersten Dezimationsfilter-Ausgangsschwellwert liegen. Insbesondere liegt die Abtastperiode unter dem Abtastperiodengrenzwert, wenn Beträge der erfassten Dezimationsfilter-Ausgangswerte über dem ersten Dezimationsfilter-Ausgangsschwellwert liegen.

Bevorzugt weist der Überabtastungs- und Dezimations-Filter eine obere Grenzfrequenz fₒ auf.

Gemäß einer weiteren Ausgestaltung der Vorrichtung dämpft der Überabtastungs- und Dezimations-Filter Signalanteile mit einer Signalanteilsfrequenz oberhalb der oberen Grenzfrequenz fₒ stärker als Signalanteile mit einer Signalanteilsfrequenz unmittelbar unterhalb der oberen Grenzfrequenz fₒ. Das bedeutet, dass der Überabtastungs- und Dezimations-Filter Signalanteile mit einer Signalanteilsfrequenz zumindest in der Nähe der Grenzfrequenz fₒ des Überabtastungs- und Dezimations-Filters ähnlich einem Tiefpassfilter verhält. Die hier vorgelegte technische Lehre weist ausdrücklich darauf hin, dass der Überabtastungs- und Dezimations-Filter beispielsweise auch ein Bandpassfilter oder ein anderer Filter mit teilweisem Tiefpasscharakter sein kann. Bevorzugt beeinflusst in dieser Ausgestaltung der Vorrichtung die Zeitgebereinheit die oberen Grenzfrequenz fₒ des Überabtastungs- und Dezimations-Filters in Abhängigkeit von dem zumindest einem erfassten jeweiligen Zeitgebereingangswert.

Gemäß einer weiteren Ausgestaltung der Vorrichtung liegt in einer ersten Unterkonfiguration die obere Grenzfrequenz fₒ des Überabtastungs- und Dezimations-Filters über einem Dezimationsgrenzfrequenzgrenzwert, wenn Beträge der erfassten ADC-Eingangswerte unter einem zweiten ADC-Eingangsschwellwert liegen. In einer zweiten Unterkonfiguration liegt die obere Grenzfrequenz fₒ des Überabtastungs- und Dezimations-Filters unter dem Dezimationsgrenzfrequenzgrenzwert, wenn Beträge der erfassten ADC-Eingangswerte über dem zweiten ADC-Eingangsschwellwert liegen.

Gemäß einer weiteren Ausgestaltung der Vorrichtung liegt in ersten Unterkonfiguration die obere Grenzfrequenz fₒ des Überabtastungs- und Dezimations-Filters über einem Dezimationsgrenzfrequenzgrenzwert, wenn Beträge der erfassten ADC-Ausgangswerte unter einem zweiten ADC-Ausgangsschwellwert liegen. In einer zweiten Unterkonfiguration liegt die obere Grenzfrequenz fₒ des Überabtastungs- und Dezimations-Filters unter dem Dezimationsgrenzfrequenzgrenzwert, wenn Beträge der erfassten ADC-Ausgangswerte über dem zweiten ADC-Ausgangsschwellwert liegen.

Gemäß einer weiteren Ausgestaltung der Vorrichtung liegt in einer ersten Unterkonfiguration die obere Grenzfrequenz fₒ des Überabtastungs- und Dezimations-Filters über einem Dezimationsgrenzfrequenzgrenzwert, wenn Beträge der erfassten Dezimationsfilter-Eingangswerte unter einem zweiten Dezimationsfilter-Eingangsschwellwert liegen. In einer zweiten Unterkonfiguration liegt die obere Grenzfrequenz fₒ des Überabtastungs- und Dezimations-Filters unter dem Dezimationsgrenzfrequenzgrenzwert, wenn Beträge der erfassten Dezimationsfilter-Eingangswerte über dem zweiten Dezimationsfilter-Eingangsschwellwert liegen.

Gemäß einer weiteren Ausgestaltung der Vorrichtung liegt in einer ersten Unterkonfiguration die obere Grenzfrequenz fₒ des Überabtastungs- und Dezimations-Filters über einem Dezimationsgrenzfrequenzgrenzwert, wenn Beträge der erfassten Dezimationsfilter-Ausgangswerte unter einem zweiten Dezimationsfilter-Ausgangsschwellwert liegen. In einer zweiten Unterkonfiguration liegt die obere Grenzfrequenz fₒ des Überabtastungs- und Dezimations-Filters über dem Dezimationsgrenzfrequenzgrenzwert, wenn Beträge der erfassten Dezimationsfilter-Ausgangswerte über dem zweiten Dezimationsfilter-Ausgangsschwellwert liegen.

Gemäß einer weiteren Ausgestaltung der Vorrichtung weist der Vorfilter bevorzugt eine obere Grenzfrequenz f_{oV} auf. Bevorzugt dämpft der Vorfilter Signalanteile mit einer Signalanteilsfrequenz oberhalb der oberen Grenzfrequenz f_{oV} stärker als Signalanteile mit einer Signalanteilsfrequenz unmittelbar unterhalb der oberen Grenzfrequenz f_{oV}. Gemäß dieser Ausgestaltung der Vorrichtung beeinflusst die Zeitgebereinheit die oberen Grenzfrequenz f_{oV} des Vorfilters in Abhängigkeit von dem zumindest einem erfassten jeweiligen Zeitgebereingangswert.

Gemäß einer weiteren Ausgestaltung der Vorrichtung liegt in einer ersten Unterkonfiguration die obere Grenzfrequenz f_{oV} des Vorfilters über einem Vorfiltergrenzfrequenzgrenzwert, wenn Beträge der erfassten ADC-Eingangswerte unter einem dritten ADC-Eingangsschwellwert liegen. In einer zweiten Unterkonfiguration liegt die obere Grenzfrequenz f_{oV} des Vorfilters unter dem Vorfiltergrenzfrequenzgrenzwert, wenn Beträge der erfassten ADC-Eingangswerte über dem dritten ADC-Eingangsschwellwert liegen.

Gemäß einer weiteren Ausgestaltung der Vorrichtung liegt in einer ersten Unterkonfiguration die obere Grenzfrequenz f_{oV} des Vorfilters über einem Vorfiltergrenzfrequenzgrenzwert, wenn Beträge der erfassten ADC-Ausgangswerte unter einem dritten ADC-Ausgangsschwellwert liegen. In einer zweiten Unterkonfiguration liegt die obere Grenzfrequenz f_{oV} des Vorfilters unter dem Vorfiltergrenzfrequenzgrenzwert, wenn Beträge der erfassten ADC-Ausgangswerte über dem dritten ADC-Ausgangsschwellwert liegen.

Gemäß einer weiteren Ausgestaltung der Vorrichtung liegt in einer ersten Unterkonfiguration die obere Grenzfrequenz f_{oV} des Vorfilters über einem Vorfiltergrenzfrequenzgrenzwert, wenn Beträge der erfassten Dezimationsfilter-Eingangswerte unter einem dritten Dezimationsfilter-Eingangsschwellwert liegen. In einer zweiten Unterkonfiguration liegt die obere Grenzfrequenz f_{oV} des Vorfilters unter einem Vorfiltergrenzfrequenzgrenzwert, wenn Beträge der erfassten Dezimationsfilter-Eingangswerte über dem dritten Dezimationsfilter-Eingangsschwellwert liegen.

Gemäß einer weiteren Ausgestaltung der Vorrichtung liegt in einer ersten Unterkonfiguration die obere Grenzfrequenz f_{oV} des Vorfilters über einem Vorfiltergrenzfrequenzgrenzwert, wenn Beträge der erfassten Dezimationsfilter-Ausgangswerte unter einem dritten Dezimationsfilter-Ausgangsschwellwert liegen. In einer zweiten Unterkonfiguration liegt die obere Grenzfrequenz f_{oV} des Vorfilters über einem Vorfiltergrenzfrequenzgrenzwert, wenn Beträge der erfassten Dezimationsfilter-Ausgangswerte über dem dritten Dezimationsfilter-Ausgangsschwellwert liegen.

Gemäß einer weiteren Ausgestaltung der Vorrichtung weist der Verstärker Eigenschaften mit Eigenschaftswerten auf. Die Zeitgebereinheit beeinflusst diese Eigenschaft des Verstärkers in Abhängigkeit von dem zumindest einem erfassten jeweiligen Zeitgebereingangswert. Solche Eigenschaften des Verstärkers können insbesondere eine Verstärkung und/oder eine Dämpfung des Verstärkers sein.

Eine weitere Ausgestaltung der Vorrichtung ist in zwei verschiedenen Unterausprägungen möglich. In der ersten Unterausprägung liegt ein Eigenschaftswert einer Eigenschaft des Verstärkers über einem Verstärkereigenschaftsgrenzwert, wenn Beträge der erfassten ADC-Eingangswerte unter einem vierten ADC-Eingangsschwellwert liegen. In der ersten Unterausprägung liegt der Eigenschaftswert der Eigenschaft des Verstärkers unter dem Verstärkereigenschaftsgrenzwert, wenn Beträge der erfassten ADC-Eingangswerte über dem vierten ADC-Eingangsschwellwert liegen. In der zweiten, alternativen Unterausprägung liegt ein Eigenschaftswert einer Eigenschaft des Verstärkers unter einem Verstärkereigenschaftsgrenzwert, wenn Beträge der erfassten ADC-Eingangswerte unter einem vierten ADC-Eingangsschwellwert liegen. In der zweiten, alternativen Unterausprägung liegt der Eigenschaftswert der Eigenschaft des Verstärkers über dem Verstärkereigenschaftsgrenzwert, wenn Beträge der erfassten ADC-Eingangswerte über dem vierten ADC-Eingangsschwellwert liegen. Die hier vorgelegte Schrift sieht also die Varianten a) und b) dieser Ausprägung ausdrücklich alternativ zueinander.

Gemäß einer weiteren Ausgestaltung der Vorrichtung steuert die Vorrichtung einen Eigenschaftswert einer Eigenschaft des Verstärkers auf eine erste Weise und eine zweite Weise. Bei einer Steuerung in der ersten Weise liegt in einer ersten Unterkonfiguration ein Eigenschaftswert einer Eigenschaft des Verstärkers über einem Verstärkereigenschaftsgrenzwert, wenn Beträge der erfassten ADC-Ausgangswerte unter einem vierten ADC-Ausgangsschwellwert liegen. Bei einer Steuerung in der ersten Weise liegt in einer zweiten Unterkonfiguration ein Eigenschaftswert einer Eigenschaft des Verstärkers unter dem Verstärkereigenschaftsgrenzwert, wenn Beträge der erfassten ADC-Ausgangswerte über dem vierten ADC-Ausgangsschwellwert liegen. Bei einer Steuerung in der zweiten Weise liegt in einer ersten Unterkonfiguration ein Eigenschaftswert einer Eigenschaft des Verstärkers unter einem Verstärkereigenschaftsgrenzwert, wenn Beträge der erfassten ADC-Ausgangswerte unter einem vierten ADC-Ausgangsschwellwert liegen. Bei einer Steuerung in der zweiten Weise liegt in einer zweiten Unterkonfiguration ein Eigenschaftswert einer Eigenschaft des Verstärkers über dem Verstärkereigenschaftsgrenzwert, wenn Beträge der erfassten ADC-Ausgangswerte über dem vierten ADC-Ausgangsschwellwert liegen. Die hier vorgelegte Schrift sieht also die Varianten der Steuerung einen Eigenschaftswert einer Eigenschaft des Verstärkers gemäß der ersten Weise und gemäß der zweiten Weise ausdrücklich alternativ zueinander vor.

Gemäß einer weiteren Ausgestaltung der Vorrichtung steuert die Vorrichtung einen Eigenschaftswert einer Eigenschaft des Verstärkers auf eine erste Weise und eine zweite Weise. Bei einer Steuerung in der ersten Weise liegt in einer ersten Unterkonfiguration ein Eigenschaftswert einer Eigenschaft des Verstärkers über einem Verstärkereigenschaftsgrenzwert, wenn Beträge der erfassten Dezimationsfilter-Eingangswerte unter einem vierten Dezimationsfilter-Eingangsschwellwert liegen. Bei einer Steuerung in der ersten Weise liegt in einer zweiten Unterkonfiguration ein Eigenschaftswert einer Eigenschaft des Verstärkers unter dem Verstärkereigenschaftsgrenzwert, wenn Beträge der erfassten Dezimationsfilter-Eingangswerte über dem vierten Dezimationsfilter-Eingangsschwellwert liegen. Bei einer Steuerung in der zweiten Weise liegt in einer ersten Unterkonfiguration ein Eigenschaftswert einer Eigenschaft des Verstärkers unter einem Verstärkereigenschaftsgrenzwert, wenn Beträge der erfassten Dezimationsfilter-Eingangswerte unter einem vierten Dezimationsfilter-Eingangsschwellwert liegen. Bei einer Steuerung in der zweiten Weise liegt in einer zweiten Unterkonfiguration ein Eigenschaftswert einer Eigenschaft des Verstärkers über dem Verstärkereigenschaftsgrenzwert, wenn Beträge der erfassten Dezimationsfilter-Eingangswerte über dem vierten Dezimationsfilter-Eingangsschwellwert liegen. Die hier vorgelegte Schrift sieht also die Varianten der Steuerung einen Eigenschaftswert einer Eigenschaft des Verstärkers gemäß der ersten Weise und gemäß der zweiten Weise ausdrücklich alternativ zueinander vor.

Gemäß einer weiteren Ausgestaltung der Vorrichtung steuert die Vorrichtung einen Eigenschaftswert einer Eigenschaft des Verstärkers auf eine erste Weise und eine zweite Weise. Bei einer Steuerung in der ersten Weise liegt in einer ersten Unterkonfiguration ein Eigenschaftswert einer Eigenschaft des Verstärkers unter einem Verstärkereigenschaftsgrenzwert, wenn Beträge der erfassten Dezimationsfilter-Ausgangswerte unter einem vierten Dezimationsfilter-Ausgangsschwellwert liegen. Bei einer Steuerung in der ersten Weise liegt in einer zweiten Unterkonfiguration ein Eigenschaftswert einer Eigenschaft des Verstärkers über dem Verstärkereigenschaftsgrenzwert, wenn Beträge der erfassten Dezimationsfilter-Ausgangswerte über dem dritten Dezimationsfilter-Ausgangsschwellwert liegen. Bei einer Steuerung in der zweiten Weise liegt in einer ersten Unterkonfiguration ein Eigenschaftswert einer Eigenschaft des Verstärkers über einem Verstärkereigenschaftsgrenzwert, wenn Beträge der erfassten Dezimationsfilter-Ausgangswerte unter einem vierten Dezimationsfilter-Ausgangsschwellwert liegen. Bei einer Steuerung in der zweiten Weise liegt in einer zweiten Unterkonfiguration ein Eigenschaftswert einer Eigenschaft des Verstärkers unter dem Verstärkereigenschaftsgrenzwert, wenn Beträge der erfassten Dezimationsfilter-Ausgangswerte über dem dritten Dezimationsfilter-Ausgangsschwellwert liegen. Die hier vorgelegte Schrift sieht also die Varianten der Steuerung einen Eigenschaftswert einer Eigenschaft des Verstärkers gemäß der ersten Weise und gemäß der zweiten Weise ausdrücklich alternativ zueinander vor.

Der obigen Vorrichtung entspricht ein Verfahren. Es handelt sich dabei um ein Verfahren zur Erfassung eines elektrischen Leitungsstromes I_{LTG} in einer Leitung. Dabei fließt der elektrische Leitungsstrom durch einen Shunt-Widerstand. Über den Shunt-Widerstand fällt in Folge dieses Stromflusses eine Shunt-Widerstandsspannung U_{S} ab.

Das Verfahren umfasst ein Erfassen und Vorfiltern der Shunt-Widerstandsspannung U_{S} zu einer Verstärkereingangsspannung Uₑ mittels eines Vorfilters.

Weiter umfasst das Verfahren ein Erfassen und Verstärken der Verstärkereingangsspannung Uₑ zu dem besagten Verstärkerausgangssignal mittels eines Verstärkers.

Weiter umfasst das Verfahren im Signalpfad ein Abtasten des Verstärkerausgangssignals mit einer Abtastrate zu einem Dezimationsfiltereingangssignal mittels eines Analog-Digitalwandlers.

Weiter umfasst das Verfahren im Signalpfad ein Filtern des Dezimationsfiltereingangssignals zu einem Dezimationsfilterausgangssignal mittels eines Überabtastungs- und Dezimations-Filters.

Weiter umfasst das Verfahren ein Bereitstellen des Dezimationsfilterausgangssignals als Messwertsignal für zumindest einen Wert des elektrischen Leitungsstromes I_{LTG} in einer Leitung. Dabei repräsentiert der typischerweise digitale Wert des Dezimationsfilterausgangssignals den Stromwert des elektrischen Leitungsstroms I_{LTG}.

Das hier vorgestellte Verfahren zeichnet sich in einer ersten Ausprägung dadurch aus, dass das Vorfiltern der Shunt-Widerstandsspannung U_{S} zu einer Verstärkereingangsspannung Uₑ von einem Wert des Verstärkerausgangssignals als Zeitgebereingangswert abhängt.

Das hier vorgestellte Verfahren zeichnet sich in einer zweiten Ausprägung dadurch aus, dass das Vorfiltern der Shunt-Widerstandsspannung U_{S} zu einer Verstärkereingangsspannung Uₑ von einem Wert des Dezimationsfiltereingangssignals als Zeitgebereingangswert abhängt.

Das hier vorgestellte Verfahren zeichnet sich in einer dritten Ausprägung dadurch aus, dass das Vorfiltern der Shunt-Widerstandsspannung U_{S} zu einer Verstärkereingangsspannung Uₑ von einem Wert des Dezimationsfilterausgangssignals als Zeitgebereingangswert abhängt.

Das hier vorgestellte Verfahren zeichnet sich in einer vierten Ausprägung dadurch aus, dass das Erfassen und Verstärken der Verstärkereingangsspannung Uₑ zu einem Verstärkerausgangssignal von einem Wert des Verstärkerausgangssignals als Zeitgebereingangswert abhängt.

Das hier vorgestellte Verfahren zeichnet sich in einer fünften Ausprägung dadurch aus, dass das Erfassen und Verstärken der Verstärkereingangsspannung Uₑ zu einem Verstärkerausgangssignal von einem Wert des Dezimationsfiltereingangssignals als Zeitgebereingangswert abhängt.

Das hier vorgestellte Verfahren zeichnet sich in einer sechsten Ausprägung dadurch aus, dass das Erfassen und Verstärken der Verstärkereingangsspannung Uₑ zu einem Verstärkerausgangssignal von einem Wert des Dezimationsfilterausgangssignals als Zeitgebereingangswert abhängt.

Das hier vorgestellte Verfahren zeichnet sich in einer siebten Ausprägung dadurch aus, dass das Abtasten des Verstärkerausgangssignals mit einer Abtastrate zu einem Dezimationsfiltereingangssignal von einem Wert des Verstärkerausgangssignals als Zeitgebereingangswert abhängt.

Das hier vorgestellte Verfahren zeichnet sich in einer achten Ausprägung dadurch aus, dass das Abtasten des Verstärkerausgangssignals mit einer Abtastrate zu einem Dezimationsfiltereingangssignal von einem Wert des Dezimationsfiltereingangssignals als Zeitgebereingangswert abhängt.

Das hier vorgestellte Verfahren zeichnet sich in einer neunten Ausprägung dadurch aus, dass das Abtasten des Verstärkerausgangssignals mit einer Abtastrate zu einem Dezimationsfiltereingangssignal von einem Wert des Dezimationsfilterausgangssignals als Zeitgebereingangswert abhängt.

Das hier vorgestellte Verfahren zeichnet sich in einer zehnten Ausprägung dadurch aus, dass das Filtern des Dezimationsfiltereingangssignals zu einem Dezimationsfilterausgangssignal von einem Wert des Verstärkerausgangssignals als Zeitgebereingangswert abhängt.

Das hier vorgestellte Verfahren zeichnet sich in einer elften Ausprägung dadurch aus, dass das Filtern des Dezimationsfiltereingangssignals zu einem Dezimationsfilterausgangssignal von einem Wert des Dezimationsfiltereingangssignals als Zeitgebereingangswert abhängt.

Das hier vorgestellte Verfahren zeichnet sich in einer zwölften Ausprägung dadurch aus, dass das Filtern des Dezimationsfiltereingangssignals zu einem Dezimationsfilterausgangssignal von einem Wert des Dezimationsfilterausgangssignals als Zeitgebereingangswert abhängt.

Eine Nacharbeit der technischen Lehre der hier vorgelegten Schrift kann ggf. die erste bis zwölfte Ausprägung des Verfahrens auch miteinander kombinieren. Einige der Ausprägungen stellen Rückkoppelungen dar, die zu Instabilitäten führen können. Daher ist es sinnvoll, wenn die Zeitgebereinheit in diesen Fällen einen Tiefpasscharakter hat und den Änderungen nicht beliebig schnell folgt.

In einer dreizehnten Ausprägung des hier vorgestellten Verfahrens hängt eine Filtereigenschaft des Vorfilterns der Shunt-Widerstandsspannung U_{S} zu einer Verstärkereingangsspannung Uₑ, insbesondere eine Vorfiltergrenzfrequenz f_{oV}, von dem Zeitgebereingangswert ab. Hinsichtlich der Zeitgebereingangswerte verweist die hier vorgelegte Schrift wieder auf den vorausgehenden Text.

In einer vierzehnten Ausprägung des hier vorgestellten Verfahrens hängt eine Eigenschaft des Erfassens und Verstärken der Verstärkereingangsspannung Uₑ zu einem Verstärkerausgangssignal, insbesondere eine Verstärkung oder eine Dämpfung, von dem Zeitgebereingangswert ab.

In einer fünfzehnten Ausprägung des hier vorgestellten Verfahrens hängt eine Eigenschaft des Abtastens des Verstärkerausgangssignals zu einem Dezimationsfiltereingangssignal, insbesondere ein Abtastzeitpunkt und/oder eine mit einer Abtastperiode, von dem Zeitgebereingangswert ab.

In einer sechzehnten Ausprägung des hier vorgestellten Verfahrens hängt eine Eigenschaft des Filterns des Dezimationsfiltereingangssignals zu einem Dezimationsfilterausgangssignal, insbesondere eine Filtergrenzfrequenz fₒ, von dem Zeitgebereingangswert ab.

In einer siebzehnten Ausprägung des hier vorgestellten Verfahrens führt das Verfahren den Verfahrensschritt der Vorfilterung auf eine erste Weise oder eine zweite Weise durch. Bei der Durchführung des Verfahrensschritts der Vorfilterung in der ersten Weise liegt im Falle einer ersten Unterkonfiguration die Vorfiltergrenzfrequenz f_{oV} über einem Vorfiltergrenzwert, wenn Beträge von Zeitgebereingangswerten unter einem ersten Eingangsschwellwert liegen. Bei der Durchführung des Verfahrensschritts der Vorfilterung in der ersten Weise liegt im Falle einer zweiten Unterkonfiguration unter dem Vorfiltergrenzwert, wenn Beträge von Zeitgebereingangswerten über dem ersten Eingangsschwellwert liegen. Bei der Durchführung des Verfahrensschritts der Vorfilterung in der zweiten Weise liegt im Falle einer ersten Unterkonfiguration die Vorfiltergrenzfrequenz f_{oV} unter einem Vorfiltergrenzwert, wenn Beträge von Zeitgebereingangswerten unter dem ersten Eingangsschwellwert liegen.

Insbesondere besteht der erste Eingangsschwellenwert aus zwei verschiedenen Schwellen. Insbesondere besteht der erste Eingangsschwellenwert aus einer höheren Schwelle zum Zuschalten und eine niedrigere Schwelle zum Rücksetzen. Auf diese Weise wird verhindert, dass permanent umgeschaltet wird, wenn Beträge von Zeitgebereingangswerten nahe dem ersten Eingangsschwellwert liegen.

Bei der Durchführung des Verfahrensschritts der Vorfilterung in der zweiten Weise liegt im Falle einer zweiten Unterkonfiguration die Vorfiltergrenzfrequenz f_{oV} über dem Vorfiltergrenzwert, wenn Beträge von Zeitgebereingangswerten über dem ersten Eingangsschwellwert liegen. Die hier vorgelegte Schrift sieht also die Varianten der Durchführung des Verfahrensschritts der Vorfilterung gemäß der ersten Weise und gemäß der zweiten Weise ausdrücklich alternativ zueinander vor.

In einer achtzehnten Ausprägung des hier vorgestellten Verfahrens führt das Verfahren den Verfahrensschritt der Verstärkung auf eine erste Weise oder eine zweite Weise durch. Bei der Durchführung des Verfahrensschritts der Verstärkung in der ersten Weise liegt im Falle einer ersten Unterkonfiguration der Betrag der Verstärkung über einem Verstärkungsgrenzwert, wenn Beträge von Zeitgebereingangswerten unter einem zweiten Eingangsschwellwert liegen. Bei der Durchführung des Verfahrensschritts der Verstärkung in der ersten Weise liegt im Falle einer zweiten Unterkonfiguration der Betrag der Verstärkung unter dem Verstärkungsgrenzwert, wenn Beträge von Zeitgebereingangswerten über dem zweiten Eingangsschwellwert liegen. Bei der Durchführung des Verfahrensschritts der Verstärkung in der zweiten Weise liegt im Falle einer ersten Unterkonfiguration der Betrag der Verstärkung unter einem Verstärkungsgrenzwert, wenn Beträge von Zeitgebereingangswerten unter dem zweiten Eingangsschwellwert liegen.

Insbesondere besteht der zweite Eingangsschwellenwert aus zwei verschiedenen Schwellen. Insbesondere besteht der zweite Eingangsschwellenwert aus einer höheren Schwelle zum Zuschalten und eine niedrigere Schwelle zum Rücksetzen. Auf diese Weise wird verhindert, dass permanent umgeschaltet wird, wenn Beträge von Zeitgebereingangswerten nahe dem zweiten Eingangsschwellwert liegen.

Bei der Durchführung des Verfahrensschritts der Verstärkung in der zweiten Weise liegt im Falle einer zweiten Unterkonfiguration der Betrag der Verstärkung über dem Verstärkungsgrenzwert, wenn Beträge von Zeitgebereingangswerten über dem zweiten Eingangsschwellwert liegen. Die hier vorgelegte Schrift sieht also die Varianten der Durchführung des Verfahrensschritts der Verstärkung gemäß der ersten Weise und gemäß der zweiten Weise ausdrücklich alternativ zueinander vor.

In einer neunzehnten Ausprägung des hier vorgestellten Verfahrens führt das Verfahren den Verfahrensschritt der Abtastung auf eine erste Weise oder eine zweite Weise durch. Bei der Durchführung des Verfahrensschritts der Abtastung in der ersten Weise liegt im Falle einer ersten Unterkonfiguration die Abtastperiode über einem Abtastperiodengrenzwert, wenn Beträge von Zeitgebereingangswerten unter einem dritten Eingangsschwellwert liegen.

Insbesondere besteht der dritte Eingangsschwellenwert aus zwei verschiedenen Schwellen. Insbesondere besteht der dritte Eingangsschwellenwert aus einer höheren Schwelle zum Zuschalten und eine niedrigere Schwelle zum Rücksetzen. Auf diese Weise wird verhindert, dass permanent umgeschaltet wird, wenn Beträge von Zeitgebereingangswerten nahe dem dritten Eingangsschwellwert liegen.

Bei der Durchführung des Verfahrensschritts der Abtastung in der ersten Weise liegt im Falle einer zweiten Unterkonfiguration die Abtastperiode unter dem Abtastperiodengrenzwert, wenn Beträge von Zeitgebereingangswerten über dem dritten Eingangsschwellwert liegen. Bei der Durchführung des Verfahrensschritts der Abtastung in der zweiten Weise liegt im Falle einer ersten Unterkonfiguration die Abtastperiode unter dem Abtastperiodengrenzwert, wenn Beträge von Zeitgebereingangswerten unter dem dritten Eingangsschwellwert liegen. Bei der Durchführung des Verfahrensschritts der Abtastung in der zweiten Weise liegt im Falle einer zweiten Unterkonfiguration die Abtastperiode über dem Abtastperiodengrenzwert, wenn Beträge von Zeitgebereingangswerten über dem dritten Eingangsschwellwert liegen. Die hier vorgelegte Schrift sieht also die Varianten der Durchführung des Verfahrensschritts der Abtastung gemäß der ersten Weise und gemäß der zweiten Weise ausdrücklich alternativ zueinander vor.

In einer zwanzigsten Ausprägung des hier vorgestellten Verfahrens führt das Verfahren den Verfahrensschritt des Filterns auf einer erste Weise oder eine zweite Weise durch. Bei der Durchführung des Verfahrensschritts des Filterns in der ersten Weise liegt im Falle einer ersten Unterkonfiguration der Betrag der Filtergrenzfrequenz fₒ über einem Filtergrenzfrequenzgrenzwert, wenn Beträge von Zeitgebereingangswerten unter einem vierten Eingangsschwellwert liegen. Bei der Durchführung des Verfahrensschritts des Filterns in der ersten Weise liegt im Falle einer zweiten Unterkonfiguration der Betrag der Filtergrenzfrequenz fₒ unter dem Filtergrenzfrequenzgrenzwert, wenn Beträge von Zeitgebereingangswerten über dem vierten Eingangsschwellwert liegen. Bei der Durchführung des Verfahrensschritts des Filterns in der zweiten Weise liegt im Falle einer ersten Unterkonfiguration der Betrag der Filtergrenzfrequenz fₒ unter dem Filtergrenzfrequenzgrenzwert, wenn Beträge von Zeitgebereingangswerten unter einem vierten Eingangsschwellwert liegen.

Insbesondere besteht der vierte Eingangsschwellenwert aus zwei verschiedenen Schwellen. Insbesondere besteht der vierte Eingangsschwellenwert aus einer höheren Schwelle zum Zuschalten und eine niedrigere Schwelle zum Rücksetzen. Auf diese Weise wird verhindert, dass permanent umgeschaltet wird, wenn Beträge von Zeitgebereingangswerten nahe dem vierten Eingangsschwellwert liegen.

Bei der Durchführung des Verfahrensschritts des Filterns in der zweiten Weise liegt im Falle einer zweiten Unterkonfiguration der Betrag der Filtergrenzfrequenz fₒ über dem Filtergrenzfrequenzgrenzwert liegt, wenn Beträge von Zeitgebereingangswerten über dem vierten Eingangsschwellwert liegen. Die hier vorgelegte Schrift sieht also die Varianten der Durchführung des Verfahrensschritts des Filterns gemäß der ersten Weise und gemäß der zweiten Weise ausdrücklich alternativ zueinander vor.

Die erfindungsgemäße Vorrichtung und das erfindungsgemäße Verfahren ermöglichen Sensormessungen mit sehr kleinen Spannungsabfällen über dem Sensorelement des Sensors und daraus folgenden sehr kleinen Eingangsspannungen.

Durch die Kombination dieser beiden Prinzipien bleibt die Zeit bis zum gemittelten Ergebnis unabhängig von der Eingangsspannung.

Bei kleinen Eingangsspannungen wird der Signal-Rausch-Abstand (SNR) gegenüber dem Stand der Technik erhöht, ohne dass die Messzeit erhöht wird.

Für große Eingangsspannungen ist das SNR nicht mehr der begrenzende Parameter für die Genauigkeit. Im angehängten Beispiel wird die Zeit für eine Messung ohne Genauigkeitsverlust von 5,6ms auf etwa 2,05ms reduziert.

Weitere vorteilhafte Ausgestaltungen, Merkmale und Funktionen der Erfindung sind in Zusammenhang mit den in den Figuren gezeigten Beispielen erklärt.

Hierbei zeigt:
- Fig. 1: eine schematische Darstellung einer Vorrichtung gemäß dem Stand der Technik;
- Fig. 2: ein Ausführungsbeispiel der erfindungsgemäßen Vorrichtung in einer schematischen Darstellung;
- Fig. 3: ein weiteres Ausführungsbeispiel der erfindungsgemäßen Vorrichtung in einer schematischen Darstellung;
- Fig. 4: ein weiteres Ausführungsbeispiel der erfindungsgemäßen Vorrichtung in einer schematischen Darstellung;
- Fig. 5: ein weiteres Ausführungsbeispiel der erfindungsgemäßen Vorrichtung in einer schematischen Darstellung;
- Fig. 6: ein weiteres Ausführungsbeispiel der erfindungsgemäßen Vorrichtung in einer schematischen Darstellung;
- Fig. 7: ein weiteres Ausführungsbeispiel der erfindungsgemäßen Vorrichtung in einer schematischen Darstellung;
- Fig. 8: ein Beispiel für eine dynamische Überabtastung in Abhängigkeit von der Verstärkereingangsspannung Uₑ am Verstärker einer erfindungsgemäßen Vorrichtung;
- Fig. 9: eine Gesamtwandelzeit T_{G} in Abhängigkeit der Verstärkereingangsspannung Uₑ und Betriebsbereiche einer erfindungsgemäßen Vorrichtung; und
- Fig. 10: einen Restfehler e durch Rauschen in Abhängigkeit von der Verstärkereingangsspannung Uₑ.

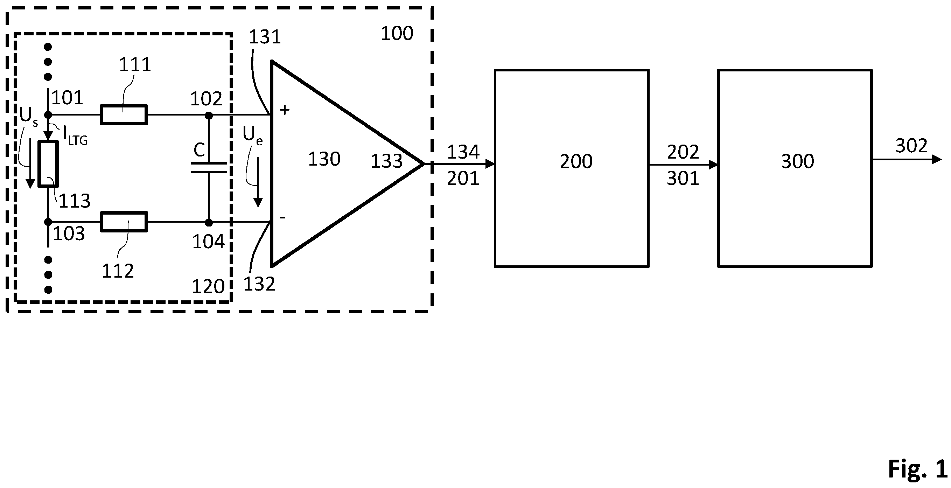

Fig. 1 zeigt beispielhaft die Verwendung eines Überabtastungs- und Dezimations-Filters 300 gemäß dem Stand der Technik (SdT).

Die gezeigte Beispielanwendung umfasst eine Schaltungseinheit 100 und einen Analog-Digital-Wandler 200 und einen Überabtastungs- und Dezimations-Filter 300.

Die Schaltungseinheit 100 gemäß dem Stand der Technik umfasst einen ersten Knoten 101, einen zweiten Knoten 102, einen dritten Knoten 103 und einen vierten Knoten 104.

Weiter umfasst die Schaltungseinheit 100 einen ersten Widerstand 111, einen zweiten Widerstand 112 und einen Shunt-Widerstand 113.

Der erste Widerstand 111 kann einen Wert von 0 Ohm aufweisen. Der erste Widerstand 111 kann also auch nur ein Leitungsstück einer elektrischen Leitung sein.

Der zweite Widerstand 112 kann einen Wert von 0 Ohm aufweisen. Der zweite Widerstand 112 kann also auch nur ein Leitungsstück einer elektrischen Leitung sein.

Der erste Knoten 101 ist mit einem ersten Anschluss des ersten Widerstands 111 und einem ersten Anschluss des Shunt-Widerstands 113 verbunden.

Ein zweiter Anschluss des ersten Widerstands 111 ist mit dem zweiten Knoten 102 verbunden.

Ein zweiter Anschluss des Shunt-Widerstands 113 ist mit dem dritten Knoten 103 verbunden.

Weiter ist ein erster Anschluss des zweiten Widerstands 112 mit dem dritten Knoten 103 verbunden. Weiter ist ein zweiter Anschluss des zweiten Widerstands 112 mit dem vierten Knoten 104 verbunden.

Somit ist der erste Anschluss des Shunt-Widerstands 113 direkt oder indirekt mit dem ersten Anschluss des ersten Widerstands 111 und mit dem ersten Knoten 101 elektrisch verbunden. Weiter ist der zweite Anschluss des Shunt-Widerstands 113 mit dem ersten Anschluss des zweiten Widerstands 112 und mit dem dritten Knoten 103 elektrisch direkt oder indirekt verbunden.

Die Schaltungseinheit 100 umfasst weiter einen Kondensator C und einen Verstärker 130.

Der Analog-Digital-Wandler 200 ist mit dem Verstärker 130 elektrisch verbunden. Weiter ist der Überabtastungs- und Dezimations-Filter 300 mit dem Analog-Digital-Wandler 200 elektrisch verbunden.

Ein Signalpfad erstreckt sich von dem Shunt-Widerstand 113 bis zu einem Ausgang des Überabtastungs- und Dezimations-Filters 300. Der Signalpfad umfasst den Shunt-Widerstand 113, den Verstärker 130, den Analog-Digital-Wandler 200 und den Überabtastungs- und Dezimations-Filter 300. Dabei ist der Ausgang des Verstärkers 130 mit dem Eingang des Analog-Digital-Wandlers 200 elektrisch verbunden. Weiter ist der Ausgang des Analog-Digital-Wandlers 200 mit dem Eingang des Überabtastungs- und Dezimations-Filters 300 elektrisch verbunden.

Insbesondere dient der Shunt-Widerstand 113 als Signalquelle.

Insbesondere dient der Ausgang des Überabtastungs- und Dezimations-Filters 300 als Messwertausgabe.

Die Schaltungseinheit 100 ist hier eine Schaltung für eine Shunt-Messung eines Stromes I_{LTG} in einer Leitung. Bei der Leitung kann es sich beispielsweise um eine Datenbusleitung handeln. Beispielsweise kann der Shunt-Widerstand 113 ein Bus-Shunt-Widerstand für eine Autoadressierungsvorrichtung zur Verwendung in einem Autoadressierungsverfahren eines LIN-Datenbusses oder CAN-Datenbusses oder eines anderen automobilen Datenbusses sein.

Der elektrische Leitungsstrom I_{LTG} fließt von dem ersten Knoten 101 über den Shunt-Widerstand 113 zu dem dritten Knoten 103. An dem Shunt-Widerstand 113 fällt dabei eine Shunt-Widerstandsspannung U_{S} ab.

Ein erster Anschluss des Kondensators C ist mit dem zweiten Konten 102 verbunden und ein zweiter Anschluss des Kondensators C ist mir dem vierten Knoten 104 verbunden.

Ein erster Verstärkereingang 131 des Verstärkers 130 ist mit dem zweiten Knoten 102 verbunden und ein zweiter Verstärkereingang 132 des Verstärkers 130 ist mir dem vierten Knoten 104 verbunden. Somit ist der zweite Anschluss des ersten Widerstands 111 und der erste Anschluss des Kondensators C über den zweiten Knoten 102 mit dem ersten Verstärkereingang 131 verbunden.

Weiter ist der zweite Anschluss des zweiten Widerstands 112 und der zweite Anschluss des Kondensators C über den vierten Knoten 104 mit dem zweiten Verstärkereingang 132 verbunden. Insbesondere ist der erste Verstärkereingang 131 ein positiver Eingang (+) des Verstärkers 130. Insbesondere ist der zweite Verstärkereingang 132 ein negativer Eingang (-) des Verstärkers 130.

Der Kondensator C bildet mit dem ersten Widerstand 111 und dem zweiten Widerstand 112 und dem Shunt-Widerstand 113 in dem in Fig. 1 dargestellten Beispiel einen Vorfilter 120.

Der Vorfilter 120 filtert die Shunt-Widerstandsspannung U_{S} zu einer Verstärkereingangsspannung Uₑ des Verstärkers 130.

Die Verstärkereingangsspannung Uₑ fällt zwischen dem positiven Eingang (+) 131 des Verstärkers 130 und dem negativen Eingang (-) 132 des Verstärkers 130 ab. Der Verstärker 130 weist einen Verstärkerausgang 133 auf. Der Verstärkerausgang 133 gibt ein Verstärker-Ausgangssignal 134 aus. Der Verstärker 130 bildet mittels einer linearen Abbildung aus der Verstärkereingangsspannung Uₑ den Wert des Verstärker-Ausgangssignals 134. Das Verstärker-Ausgangssignal 134 dient als Eingangssignal des Analog-Digital-Wandlers 200.

Insbesondere entspricht das Verstärker-Ausgangssignal 134 einem analogen Eingangssignal 201 des Analog-Digital-Wandlers 200.

Der Analog-Digital-Wandler 200 tastet den analogen Wert des Eingangssignals 201 zu Abtastzeitpunkten ab. Bevorzugt sind die Abtastzeitpunkte periodisch mit einer zeitlichen Abtastperiode. Der Kehrwert der Abtastperiode ist im Sinne dieser Schrift die Abtastfrequenz. Die Abtastfrequenz geteilt durch 2π ist im Sinne dieser Schrift die Abtastrate. Zur Bestimmung einer Abtastperiode erfasst im Sinne dieser Schrift eine geeignete Messvorrichtung den zeitlichen Abstand zwischen einem ersten Abtastzeitpunkt und einem unmittelbar zeitlich nachfolgenden zweiten Abtastzeitpunkt.

Der Analog-Digital-Wandler 200 wandelt das analoge Eingangssignal 201 in ein digitales Ausgangssignal 202 um.

Dabei wandelt der Analog-Digital-Wandler 200 den analogen Wert des Eingangssignals 201 an diesen Abtastzeitpunkten in einen digitalen Wert des digitalen Ausgangssignals 202 um.

Der Ausgang des Analog-Digital-Wandlers 200 kann mehrere elektrische Leitungen umfassen.

Der Überarbeitungs- und Dezimationsfilter 300 weist einen digitalen Eingang und einen Ausgang auf.

Das digitale Ausgangssignal 202 des Analog-Digital-Wandlers 200 dient als Dezimationsfiltereingangssignal 301.

Dabei signalisiert der Analog-Digital-Wandler 200 nach der Abtastung mittels des digitalen Ausgangssignals 202 den betreffenden Abtastwert an den Eingang des Überabtastungs- und Dezimations-Filters 300.

An seinem Ausgang gibt der Überarbeitungs- und Dezimationsfilter 300 ein Dezimationsfilterausgangssignal 302 aus.

Insbesondere stellen die Ausgangswerte des Dezimationsfilterausgangssignals 302 zumindest zeitweise die durch die Vorrichtung erfassten Stromwerte für einen Leitungsstrom I_{LTG} durch den Shunt-Widerstand 113 dar. Die Begrenzung auf "zeitweise" kommt dadurch zustande, dass der Analog-Digital-Wandler 200 nur zu den Abtastzeitpunkten den Stromwert des Leitungsstromes I_{LTG} erfassen kann.

Insbesondere ist der Überarbeitungs- und Dezimationsfilter 300 ein linearer Filter. Dies hat zur Folge, dass bevorzugt eine Erhöhung des Eingangssignals eine entsprechende proportionale Änderung des Ausgangssignals zur Folge hat.

Gemäß dem Stand der Technik kann der erste Knoten 101 mit weiteren hier nicht dargestellten Schaltungen oder einer oder mehreren ebenfalls nicht dargestellten Spannungs- und/oder Stromquellen verbunden sein. Beispielsweise kann die in Fig. 1 schematisch und vereinfacht gezeichnete Vorrichtung mit einem oder mehreren nachfolgenden und/oder vorausgehende Busknoten oder einem Busmaster verbunden sein, wenn der Shunt-Widerstand 113 ein Bus-Shunt-Widerstand in einem LIN-Datenbus mit Autoadressierung ist.

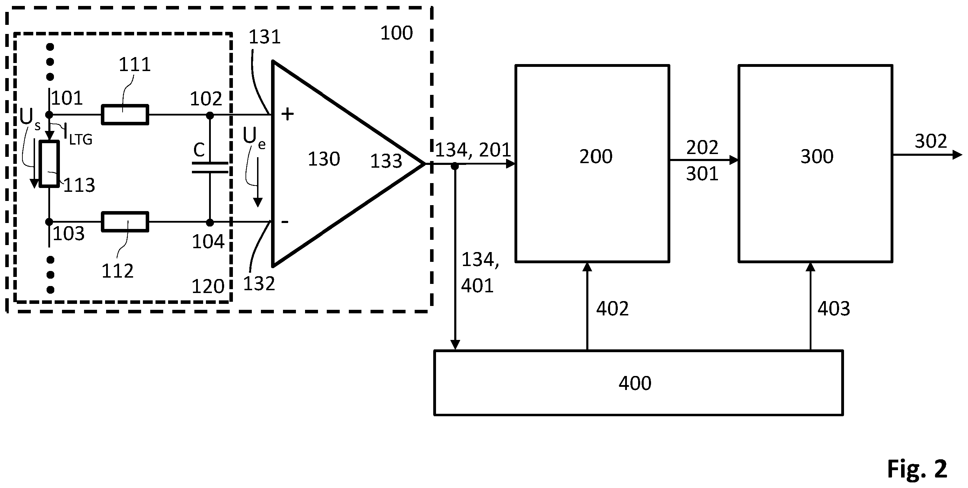

Fig. 2 zeigt in beispielhafter Weise das Grundprinzip der erfindungsgemäßen Vorrichtung.

Die in Fig. 2 dargestellte erfindungsgemäße Vorrichtung umfasst gegenüber dem in Fig. 1 dargestellten Stand der Technik zusätzlich eine Zeitgebereinheit 400. Die Zeitgebereinheit 400 erfasst zumindest ein Zeitgebereingangswertsignal 401.

In der in Fig. 2 dargestellten Ausgestaltung der Erfindung dient das Verstärker-Ausgangssignal 134 als Zeitgebereingangswertsignal bzw. als Zeitgebereingangswert 401.

Das Verstärker-Ausgangssignal 134 entspricht in dem in Fig. 2 dargestellten Beispiel zugleich auch als analoges Eingangssignal 201 des Analog-Digital-Wandlers 200. Es ist denkbar, dass zwischen dem Verstärkerausgang 133 und dem Eingang des Analog-Digital-Wandlers 200 weitere Signalverarbeitungsteilvorrichtungen wie Filter, oder ähnliches im Signalpfad angeordnet sind. Das analoge Eingangssignal 201 des Analog-Digital-Wandlers 200 umfasst das das Verstärker-Ausgangssignal 134. Bei einer Verwendung weiterer Signalverarbeitungsteilvorrichtungen entspricht das analoge Eingangssignal 201 des Analog-Digital-Wandlers 200 nicht zwangsläufig dem Verstärker-Ausgangssignal 134.

In dem in Fig. 2 dargestellten Beispiel steuert die Zeitgebereinheit 400 in Abhängigkeit von dem Wert des Zeitgebereingangswertsignals 401 die Abtastrate und/oder die Abtastzeitpunkte des Analog-Digital-Wandlers 200.

Die Zeitgebereinheit 400 signalisiert dem Analog-Digital-Wandler 200 über eine Abtaststeuerungsleitung 402 Betriebsparameter des Analog-Digitalwandlers 200. Im einfachsten Fall kann die Abtaststeuerungsleitung 402 einen Takt an den Analog-Digital-Wandler 200 signalisieren. Beispielsweise kann der Takt ein Abtasttakt mit einer Taktrate sein. Diese Taktrate ist dann typischerweise die Abtastrate des Analog-Digital-Wandlers 200. Der Analog-Digital-Wandler 200 kann diese Taktrate des Takts beispielsweise auch mittels einer PLL oder dergleichen in eine Abtastrate eines Abtasttakts des Analog-Digital-Wandlers 200 umwandeln. Es kann sich aber auch je nach Implementierung um einen seriellen oder parallelen Datenbus oder dergleichen mit einem Datenbusprotokoll handeln.

Die Abtastung erfordert in der Regel die Einhaltung des Nyquist-Theorems.

Der Widerstandswert des ersten Widerstands 111 und des zweiten Widerstands 112 sind bevorzugt von 0 Ohm verschieden, sodass durch eine Abtastung im auf die Schaltungseinheit 100 nachfolgenden Analog-Digital-Wandler 200 die Nyquist-Bedingung erfüllt bleibt.

Die Abtastung des Eingangssignals 201 des Analog-Digital-Wandlers 200 bzw. des Verstärkerausgangssignals 134 durch den Analog-Digital-Wandler 200 erzeugt Artefakte. Zur Vermeidung dieser Artefakte sind zum einen der Vorfilter 120 vorgesehen und zum anderen der Überabtastungs- und Dezimations-Filter 300 vorgesehen.

Bei einer Änderung der Abtastrate sollte bevorzugt die Vorrichtung bzw. das vorgeschlagene Verfahren die Grenzfrequenzen anpassen.

Die Zeitgebereinheit 400 passt daher die Filtereigenschaften des Überabtastungs- und Dezimations-Filters 300 an die Abtastrate des Analog-Digitalwandlers 200 an. Da die Abtastrate des Analog-Digitalwandlers 200 von dem Zeitgebereingangswert 401 abhängt, hängen damit auch die Filtereigenschaften des Überabtastungs- und Dezimations-Filters 300von dem Zeitgebereingangswert 401 ab. Bevorzugt ist eine relevante Filtereigenschaft des Überabtastungs- und Dezimations-Filters 300 eine obere Grenzfrequenz fₒ des Überabtastungs- und Dezimations-Filters 300.

Insbesondere ist der Überabtastungs- und Dezimations-Filter 300 ein Tiefpass. Es sind aber auch komplexere frequenzabhängige spektrale Filterverläufe des Überabtastungs- und Dezimations-Filters 300 denkbar, die dann aber typischerweise immer eine obere Grenzfrequenz fₒ aufweisen.

Bevorzugt steuert die Zeitgebereinheit 400 zumindest eine Filtereigenschaft des Überabtastungs- und Dezimations-Filters 300 mittels einer Dezimationsfiltersteuerleitung 403. Die Dezimationsfiltersteuerleitung 403 kann dabei eine oder mehrere Leitungen umfassen. Typischerweise ist der Überabtastungs- und Dezimations-Filter 300 ein digitaler Filter. Bevorzugt repräsentieren die Leitungen der Dezimationsfiltersteuerleitung 403 dann ein Steuerwort, das der Überabtastungs- und Dezimations-Filter 300 konfiguriert. Auch ist es denkbar, dass es sich bei der Dezimationsfiltersteuerleitung 403 um einen seriellen oder parallelen Datenbus handelt.

In dem in Fig. 2 dargestellten Beispiel steuert die Zeitgebereinheit 400 über die Dezimationsfiltersteuerleitung 403 Parameter des Überabtastungs- und Dezimations-Filters 300. Bei diesen Parametern des Überabtastungs- und Dezimations-Filters 300, die die Zeitgebereinheit 400 über die Dezimationsfiltersteuerleitung 403 steuert, handelt es sich beispielsweise um den Frequenzgang und/oder die Verstärkung oder die Dämpfung des Überabtastungs- und Dezimations-Filters 300. Insbesondere handelt es sich um die besagte obere Grenzfrequenz fₒ des Überabtastungs- und Dezimations-Filters 300.

Weiter steuert die Zeitgebereinheit 400 in dem in Fig. 2 dargestellten Beispiel über die Abtaststeuerungsleitung 402 Parameter des Analog-Digital-Wandlers 200. Bei diesen Parametern es Analog-Digital-Wandlers 200, die die Zeitgebereinheit 400 über die Abtaststeuerungsleitung 402 steuert, handelt es sich beispielsweise um die Abtastrate oder Abtastzeitpunkte es Analog-Digital-Wandlers 200.

In einer Variante umfasst der Vorfilter 120 nicht den zweiten Widerstand 112. Bei einem Vorfilter 120 ohne den zweiten Widerstand 112 bildet der dritte Knoten 103 und der vierte Knoten 104 ein Bezugspotential (gemeinhin Ground genannt).

In einer weiteren Variante ist der Vorfilter 120 zumindest teilweise, insbesondere vollständig, in dem Verstärker 130 integriert.

In einer weiteren Variante, ist der Verstärker 130 nicht getaktet ausgebildet. Insbesondere arbeitet der Verstärker 130 kontinuierlich.

Insbesondere ist bei Verwendung eines nicht getaktet ausgebildeten Verstärkers 130 der Vorfilter 120 zumindest teilweise, insbesondere vollständig, vor dem Verstärker 130 angeordnet.

Insbesondere ist bei Verwendung eines nicht getaktet ausgebildeten Verstärkers 130 der Vorfilter 120 zumindest teilweise, insbesondere vollständig, in dem Verstärker 130 integriert.

Insbesondere ist bei Verwendung eines nicht getaktet ausgebildeten Verstärkers 130 der Vorfilter 120 zumindest teilweise, insbesondere vollständig, hinter dem Verstärker 130 angeordnet.

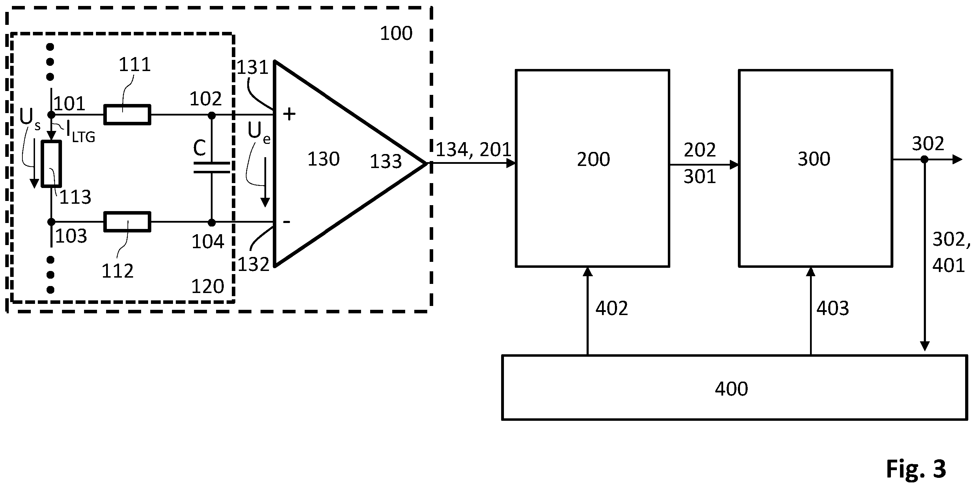

Fig. 3 zeigt eine weitere Ausgestaltung der erfindungsgemäßen Vorrichtung. Das in Fig. 3 dargestellte Ausführungsbeispiel entspricht im Wesentlichen dem in Fig. 2 dargestellten Ausführungsbeispiel.

Das in Fig. 3 dargestellte Ausführungsbeispiel unterscheidet sich von dem in Fig. 2 dargestellte Ausführungsbeispiel dadurch, dass das Zeitgebereingangswertsignal 401 der Zeitgebereinheit 400 nicht wie in dem Beispiel der Fig. 2 dem analogen Eingangssignal 201 des Analog-Digital-Wandlers 200 bzw. dem Verstärkerausgangssignal 134 entspricht. In dem in Fig. 3 dargestellten Ausführungsbeispiel entspricht das Zeitgebereingangswertsignal 401 der Zeitgebereinheit 400 dem Dezimationsfilterausgangssignal 302.

In einer bevorzugten Ausgestaltung, in der alle Komponenten, also der Verstärker 130, der Analog-Digital-Wandler 200 und der Überabtastungs- und Dezimations-Filter 400 linear sind, kann das Steuerverhalten einer Vorrichtung gemäß der Figur 3 in ein System der Figur 2 und umgekehrt überführen werden.

Während in dem in Fig. 2 dargestellten Ausführungsbeispiel das Zeitgebereingangswertsignal 401 ein analoges Signal ist, ist das in dem in Fig. 3 dargestellten Ausführungsbeispiel das Zeitgebereingangswertsignal 401 ein digitales Signal. In Folge dessen unterscheiden sich die spektralen Eigenschaften des Zeitgebereingangswertsignals 401.

In dem in Fig. 2 dargestellten Ausführungsbeispielumfasst die Zeitgebereinheit 400 typischerweise Komparatoren und ggf. analoge Schwellwertgeber zum Vergleich des Eingangssignals 201 des Analog-Digital-Wandlers 200 bzw. des Verstärkerausgangssignals 134 mit Schwellwerten solcher erzeugter Schwellwertsignale der analogen Schwellwertgeber.

Bei Verwendung des Dezimationsfilterausgangssignals 302 als Zeitgebereingangswertsignal 401 muss das Verhalten der Zeitgebereinheit 400 die Artefakte durch die Abtastung berücksichtigen.

In dem in Fig. 3 dargestellten Beispiel steuert die Zeitgebereinheit 400 über die Dezimationsfiltersteuerleitung 403 Parameter des Überabtastungs- und Dezimations-Filters 300. Bei diesen Parametern des Überabtastungs- und Dezimations-Filters 300, die die Zeitgebereinheit 400 über die Dezimationsfiltersteuerleitung 403 steuert, handelt es sich beispielsweise um den Frequenzgang und/oder die Verstärkung oder die Dämpfung des Überabtastungs- und Dezimations-Filters 300. Insbesondere handelt es sich um die besagte obere Grenzfrequenz fₒ des Überabtastungs- und Dezimations-Filters 300.

Weiter steuert die Zeitgebereinheit 400 in dem in Fig. 3 dargestellten Beispiel Parameter des Analog-Digital-Wandlers 200 über die Abtaststeuerungsleitung 402. Bei diesen Parametern es Analog-Digital-Wandlers 200, die die Zeitgebereinheit 400 über die Abtaststeuerungsleitung 402 steuert, handelt es sich beispielsweise um die Abtastrate oder Abtastzeitpunkte es Analog-Digital-Wandlers 200.

In einer Variante umfasst der Vorfilter 120 nicht den zweiten Widerstand 112. Bei einem Vorfilter 120 ohne den zweiten Widerstand 112 bildet der dritte Knoten 103 und der vierte Knoten 104 ein Bezugspotential (gemeinhin Ground genannt).

In einer weiteren Variante ist der Vorfilter 120 zumindest teilweise, insbesondere vollständig, in dem Verstärker 130 integriert.

In einer weiteren Variante, ist der Verstärker 130 nicht getaktet ausgebildet. Insbesondere arbeitet der Verstärker 130 kontinuierlich.

Insbesondere ist bei Verwendung eines nicht getaktet ausgebildeten Verstärkers 130 der Vorfilter 120 zumindest teilweise, insbesondere vollständig, vor dem Verstärker 130 angeordnet.

Insbesondere ist bei Verwendung eines nicht getaktet ausgebildeten Verstärkers 130 der Vorfilter 120 zumindest teilweise, insbesondere vollständig, in dem Verstärker 130 integriert.

Insbesondere ist bei Verwendung eines nicht getaktet ausgebildeten Verstärkers 130 der Vorfilter 120 zumindest teilweise, insbesondere vollständig, hinter dem Verstärker 130 angeordnet.

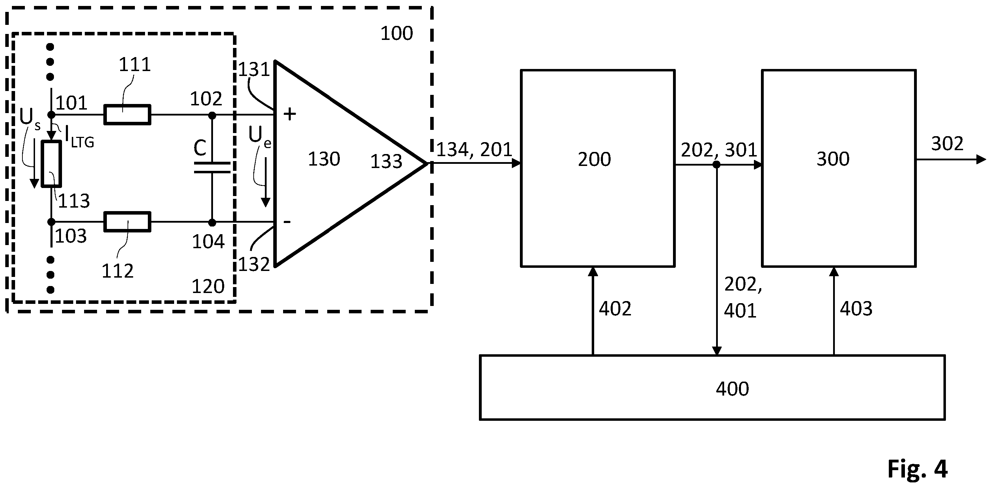

Fig. 4 zeigt ein weiteres Ausführungsbeispiel der erfindungsgemäßen Vorrichtung.

Fig. 4 entspricht im Wesentlichen der Figur 2 und der Figur 3.

Fig. 4 unterscheidet sich von den Fig. 2 und Fig. 3 dadurch, dass das Zeitgebereingangswertsignal 401 der Zeitgebereinheit 400 in dem in Fig. 4 dargestellten Ausführungsbeispiel dem Ausgangssignal 202 des Analog-Digital-Wandlers 200 bzw. dem Dezimationsfiltereingangssignal 301 entspricht.

In dem in Fig. 4 dargestellten Beispiel steuert die Zeitgebereinheit 400 über die Dezimationsfiltersteuerleitung 403 Parameter des Überabtastungs- und Dezimations-Filters 300. Bei diesen Parametern des Überabtastungs- und Dezimations-Filters 300, die die Zeitgebereinheit 400 über die Dezimationsfiltersteuerleitung 403 steuert, handelt es sich beispielsweise um den Frequenzgang und/oder die Verstärkung oder die Dämpfung des Überabtastungs- und Dezimations-Filters 300. Insbesondere handelt es sich um die besagte obere Grenzfrequenz fₒ des Überabtastungs- und Dezimations-Filters 300.

In dem in Fig. 4 dargestellten Beispiel steuert die Zeitgebereinheit 400 über die Abtaststeuerungsleitung 402 Parameter des Analog-Digital-Wandlers 200. Bei diesen Parametern es Analog-Digital-Wandlers 200, die die Zeitgebereinheit 400 über die Abtaststeuerungsleitung 402 steuert, handelt es sich beispielsweise um die Abtastrate oder Abtastzeitpunkte es Analog-Digital-Wandlers 200.

In einer Variante umfasst der Vorfilter 120 nicht den zweiten Widerstand 112. Bei einem Vorfilter 120 ohne den zweiten Widerstand 112 bildet der dritte Knoten 103 und der vierte Knoten 104 ein Bezugspotential (gemeinhin Ground genannt).

In einer weiteren Variante ist der Vorfilter 120 zumindest teilweise, insbesondere vollständig, in dem Verstärker 130 integriert.

In einer weiteren Variante, ist der Verstärker 130 nicht getaktet ausgebildet. Insbesondere arbeitet der Verstärker 130 kontinuierlich.

Insbesondere ist bei Verwendung eines nicht getaktet ausgebildeten Verstärkers 130 der Vorfilter 120 zumindest teilweise, insbesondere vollständig, vor dem Verstärker 130 angeordnet.

Insbesondere ist bei Verwendung eines nicht getaktet ausgebildeten Verstärkers 130 der Vorfilter 120 zumindest teilweise, insbesondere vollständig, in dem Verstärker 130 integriert.

Insbesondere ist bei Verwendung eines nicht getaktet ausgebildeten Verstärkers 130 der Vorfilter 120 zumindest teilweise, insbesondere vollständig, hinter dem Verstärker 130 angeordnet.

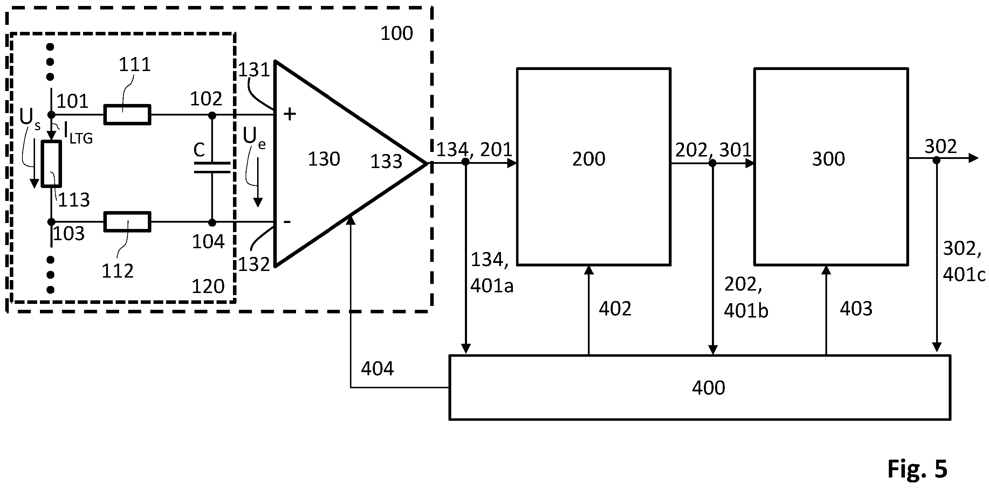

Fig. 5 zeigt ein weiteres Ausführungsbeispiel der erfindungsgemäßen Vorrichtung.

In dem in Fig. 5 dargestellten Ausführungsbeispiel erfasst die Zeitgebereinheit 400 mehrere Zeitgebereingangswerte 401.

In dem in Fig. 5 dargestellten Beispiel entspricht ein erster Zeitgebereingangswert 401a der Zeitgebereinheit 400 dem Verstärker-Ausgangssignal 134 bzw. dem analogen Eingangssignal 201 des Analog-Digital-Wandlers 200. Ein zweiter Zeitgebereingangswert 401b der Zeitgebereinheit 400 entspricht in dem in Fig. 5 dargestellten Beispiel dem digitalen Ausgangssignal 202 des Analog-Digital-Wandlers 200 bzw. dem Dezimationsfiltereingangssignal 301. Ein dritter Zeitgebereingangswert 401c der Zeitgebereinheit 400 entspricht in dem in Fig. 5 dargestellten Beispiel dem Dezimationsfilterausgangssignal 302.

Die Zeitgebereinheit 400 steuert in dem in Fig. 5 dargestellten Beispiel Parameter des Analog-Digital-Wandlers 200 und/oder des Überabtastungs- und Dezimations-Filters 300 in Abhängigkeit von Zeitgebereingangswerten der Zeitgebereingangswertsignale 401. Ein gesteuerter Parameter des Analog-Digital-Wandlers 200 können dabei Abtastzeitpunkte und/oder Abtastraten sein. Ein gesteuerter Parameter des Überabtastungs- und Dezimations-Filters 300 kann dabei beispielsweise die besagte obere Grenzfrequenz fₒ des Überabtastungs- und Dezimations-Filters 300 sein.

In dem in Fig. 5 dargestellten Beispiel steuert die Zeitgebereinheit 400 über eine Verstärkersteuerungsleitung 404 Parameter des Verstärkers 130. Bei diesen Parametern des Verstärkers 130, die die Zeitgebereinheit 400 über die Verstärkersteuerungsleitung 404 steuert, handelt es sich beispielsweise um den Frequenzgang und/oder die Verstärkung oder die Dämpfung des Verstärkers 130.

In dem in Fig. 5 dargestellten Beispiel steuert die Zeitgebereinheit 400 über die Dezimationsfiltersteuerleitung 403 Parameter des Überabtastungs- und Dezimations-Filters 300. Bei diesen Parametern des Überabtastungs- und Dezimations-Filters 300, die die Zeitgebereinheit 400 über die Dezimationsfiltersteuerleitung 403 steuert, handelt es sich beispielsweise um den Frequenzgang und/oder die Verstärkung oder die Dämpfung des Überabtastungs- und Dezimations-Filters 300. Insbesondere handelt es sich um die besagte obere Grenzfrequenz fₒ des Überabtastungs- und Dezimations-Filters 300.

In dem in Fig. 5 dargestellten Beispiel steuert die Zeitgebereinheit 400 über die Abtaststeuerungsleitung 402 Parameter des Analog-Digital-Wandlers 200. Bei diesen Parametern es Analog-Digital-Wandlers 200, die die Zeitgebereinheit 400 über die Abtaststeuerungsleitung 402 steuert, handelt es sich beispielsweise um die Abtastrate oder Abtastzeitpunkte es Analog-Digital-Wandler.

Bevorzugt ist das Zeitverhalten der Zeitgebereinheit 400 bei der Erzeugung des Signals der Verstärkersteuerungsleitung 404 so eingestellt, dass ein Aufschwingen des Systems ausgeschlossen ist.

Es empfiehlt sich daher mittels einer Systemsimulation das Verhalten des Systems beispielsweise mit einem Programm wie Maple zu modellieren und die Eigenfrequenzen der geöffneten Regelschleife zu bestimmen und so die Pole der Schleifenfunktion geeignet zu manipulieren.

In einer Variante umfasst der Vorfilter 120 nicht den zweiten Widerstand 112. Bei einem Vorfilter 120 ohne den zweiten Widerstand 112 bildet der dritte Knoten 103 und der vierte Knoten 104 ein Bezugspotential (gemeinhin Ground genannt).

In einer weiteren Variante ist der Vorfilter 120 zumindest teilweise, insbesondere vollständig, in dem Verstärker 130 integriert.

In einer weiteren Variante, ist der Verstärker 130 nicht getaktet ausgebildet. Insbesondere arbeitet der Verstärker 130 kontinuierlich.

Insbesondere ist bei Verwendung eines nicht getaktet ausgebildeten Verstärkers 130 der Vorfilter 120 zumindest teilweise, insbesondere vollständig, vor dem Verstärker 130 angeordnet.

Insbesondere ist bei Verwendung eines nicht getaktet ausgebildeten Verstärkers 130 der Vorfilter 120 zumindest teilweise, insbesondere vollständig, in dem Verstärker 130 integriert.

Insbesondere ist bei Verwendung eines nicht getaktet ausgebildeten Verstärkers 130 der Vorfilter 120 zumindest teilweise, insbesondere vollständig, hinter dem Verstärker 130 angeordnet.

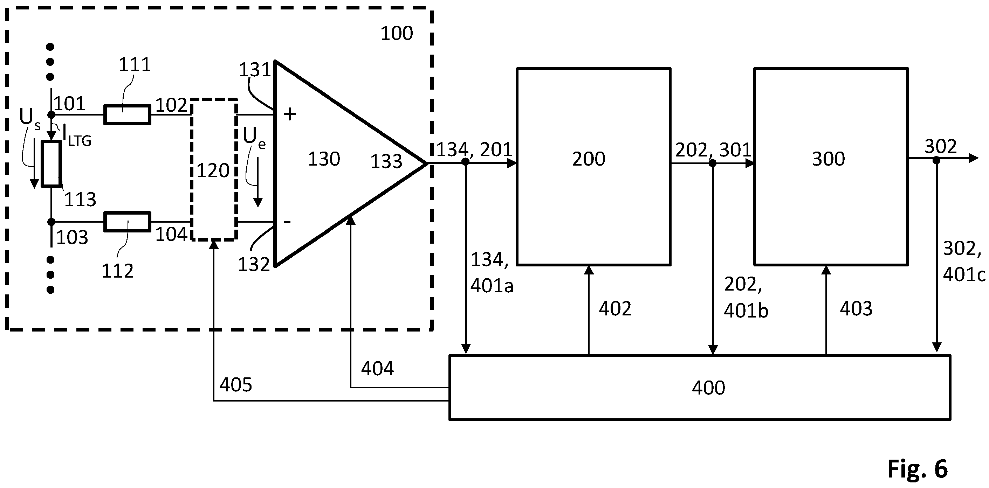

Fig. 6 zeigt ein weiteres Aufführungsbeispiel der erfindungsgemäßen Vorrichtung.

Fig. 6 entspricht im Wesentlichen dem in Fig. 5 dargestellten Ausführungsbeispiel, wobei das in Fig. 6 dargestellte Ausführungsbeispiel einen schaltbaren Vorfilter 120 umfasst.

In dem in Fig. 6 dargestellten Ausführungsbeispiel, konfiguriert die Zeitgebereinheit 400 nicht nur die Grenzfrequenz fₒ des Überabtastungs- und Dezimations-Filters 300 um, sondern auch einen oder mehrere Parameter des Vorfilters 120. Hierzu signalisiert die Zeitgebereinheit 400 dem Vorfilter 120 über eine Vorfiltersteuerleitung 405, welche Parameter der Vorfilter 120 für die Filterung verwenden soll.

Bevorzugt erfasst die Zeitgebereinheit 400 mehrere Zeitgebereingangswerte 401.

In dem in Fig. 6 dargestellten Beispiel erfasst die Zeitgebereinheit den ersten Zeitgebereingangswert 401a, welcher dem analogen Eingangssignal 201 des Analog-Digital-Wandlers 200 bzw. dem Verstärkerausgangssignal 134 entspricht. Der zweite Zeitgebereingangswert 401b des Zeitgebers 400 entspricht in dem in Fig. 6 dargestellten Beispiel dem digitalen Ausgangssignal202 des Analog-Digital-Wandlers 200 bzw. dem Dezimationsfiltereingangssignal301. Der dritte Zeitgebereingangswert 401c des Zeitgebers 400 entspricht in dem in Fig. 6 dargestellten Beispiel dem Dezimationsfilterausgangssignal 302.

Die Zeitgebereinheit 400 steuert in dem in Fig. 6 dargestellten Beispiel Parameter des Analog-Digital-Wandlers 200 und/oder des Überabtastungs- und Dezimations-Filters 300 in Abhängigkeit von Zeitgebereingangswerten der Zeitgebereingangswertsignale 401. Ein gesteuerter Parameter des Analog-Digital-Wandlers 200 können dabei Abtastzeitpunkte und/oder Abtastraten sein. Ein gesteuerter Parameter des Überabtastungs- und Dezimations-Filters 300 kann dabei beispielsweise die besagte obere Grenzfrequenz fₒ des Überabtastungs- und Dezimations-Filters 300 sein.

In dem in Fig. 6 dargestellten Beispiel steuert die Zeitgebereinheit 400 über die Verstärkersteuerungsleitung 404 Parameter des Verstärkers 130. Bei diesen Parametern des Verstärkers 130, die die Zeitgebereinheit 400 über die Verstärkersteuerungsleitung 404 steuert, handelt es sich beispielsweise um den Frequenzgang und/oder die Verstärkung oder die Dämpfung des Verstärkers 130.

In dem in Fig. 6 dargestellten Beispiel steuert die Zeitgebereinheit 400 über die Dezimationsfiltersteuerleitung 403 Parameter des Überabtastungs- und Dezimations-Filters 300. Bei diesen Parametern des Überabtastungs- und Dezimations-Filters 300, die die Zeitgebereinheit 400 über die Dezimationsfiltersteuerleitung 403 steuert, handelt es sich beispielsweise um den Frequenzgang und/oder die Verstärkung oder die Dämpfung des Überabtastungs- und Dezimations-Filters 300. Insbesondere handelt es sich um die besagte obere Grenzfrequenz fₒ des Überabtastungs- und Dezimations-Filters 300.

In dem in Fig. 6 dargestellten Beispiel steuert die Zeitgebereinheit 400 über die Vorfiltersteuerungsleitung 405 Parameter des Vorfilters 120. Bei diesen Parametern des Vorfilters 120, die die Zeitgebereinheit 400 über die Vorfiltersteuerungsleitung 405 steuert, handelt es sich beispielsweise um den Frequenzgang und/oder die Verstärkung oder die Dämpfung und/oder die obere Vorfiltergrenzfrequenz f_{oV} des Vorfilters 120. Bevorzugt erhöht die Zeitgebereinheit 400 die obere Vorfiltergrenzfrequenz f_{oV} des Vorfilters 120, wenn die Zeitgebereinheit 400 die Abtastrate des Analog-Digital-Wandlers 200 erhöht. Bevorzugt erniedrigt die Zeitgebereinheit 400 die obere Vorfiltergrenzfrequenz f_{oV} des Vorfilters 120, wenn die Zeitgebereinheit 400 die Abtastrate des Analog-Digital-Wandlers 200 erniedrigt.

In einer Variante umfasst der Vorfilter 120 nicht den zweiten Widerstand 112. Bei einem Vorfilter 120 ohne den zweiten Widerstand 112 bildet der dritte Knoten 103 und der vierte Knoten 104 ein Bezugspotential (gemeinhin Ground genannt).

In einer weiteren Variante ist der Vorfilter 120 zumindest teilweise, insbesondere vollständig, in dem Verstärker 130 integriert.

In einer weiteren Variante, ist der Verstärker 130 nicht getaktet ausgebildet. Insbesondere arbeitet der Verstärker 130 kontinuierlich.

Insbesondere ist bei Verwendung eines nicht getaktet ausgebildeten Verstärkers 130 der Vorfilter 120 zumindest teilweise, insbesondere vollständig, vor dem Verstärker 130 angeordnet.

Insbesondere ist bei Verwendung eines nicht getaktet ausgebildeten Verstärkers 130 der Vorfilter 120 zumindest teilweise, insbesondere vollständig, in dem Verstärker 130 integriert.

Insbesondere ist bei Verwendung eines nicht getaktet ausgebildeten Verstärkers 130 der Vorfilter 120 zumindest teilweise, insbesondere vollständig, hinter dem Verstärker 130 angeordnet.

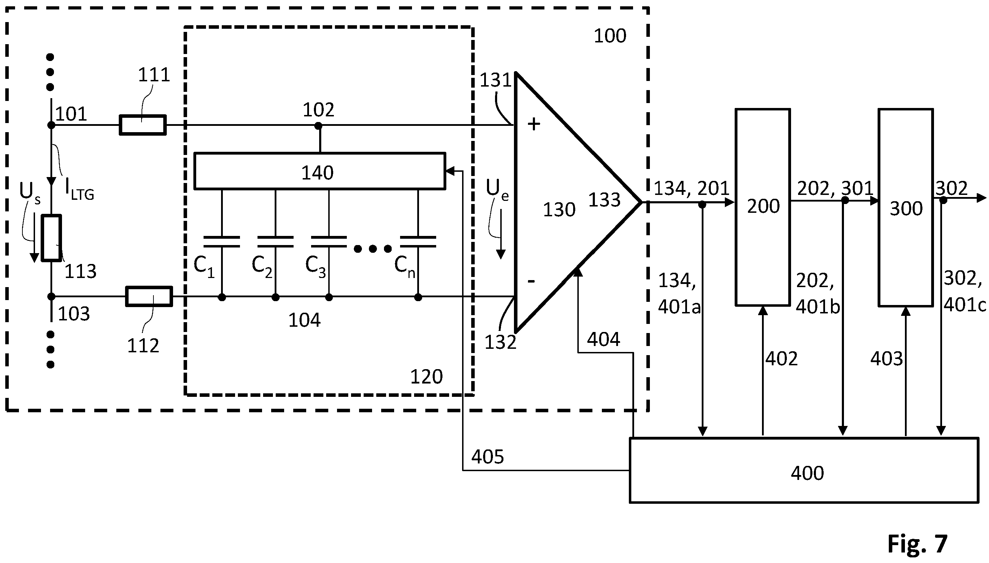

Figur 7 zeigt eine weitere Ausführungsform der erfindungsgemäßen Vorrichtung.

Dabei zeigt Figur 7 eine beispielhafte Implementierung eines schaltbaren Vorfilters 120 gemäß dem in Fig. 6 dargestellten Ausführungsbeispiels.

In dem in Fig. 7 dargestellten Ausführungsbeispiel umfasst der schaltbare Vorfilter 120 einen Analogmultiplexer oder ein analoger Verbindungsschalter 140 und eine Mehrzahl Kapazitäten C₁-Cₙ.

Der Analogmultiplexer oder ein analoger Verbindungsschalter 140 ist über eine Vorfiltersteuerungsleitung 405 mit der Zeitgebereinheit 400 verbunden.

Entsprechend einer Signalisierung der Zeitgebereinheit 400 über die Vorfiltersteuerungsleitung 405 verbindet der Analogmultiplexer oder analoge Verbindungsschalter 140 den zweiten Knoten 102 mit einer Kapazität oder mit mehreren Kapazitäten C₁ bis Cₙ. Diese Verschaltung führt zu einer Einstellbarkeit eines Kapazitätswerts des Kondensators C in Abhängigkeit eines mittels der Vorfiltersteuerungsleitung 405 übermittelten Werts.

In einer Variante umfasst der Vorfilter 120 nicht den zweiten Widerstand 112. Bei einem Vorfilter 120 ohne den zweiten Widerstand 112 bildet der dritte Knoten 103 und der vierte Knoten 104 ein Bezugspotential (gemeinhin Ground genannt).

In einer weiteren Variante ist der Vorfilter 120 zumindest teilweise, insbesondere vollständig, in dem Verstärker 130 integriert.

In einer weiteren Variante, ist der Verstärker 130 nicht getaktet ausgebildet. Insbesondere arbeitet der Verstärker 130 kontinuierlich.

Insbesondere ist bei Verwendung eines nicht getaktet ausgebildeten Verstärkers 130 der Vorfilter 120 zumindest teilweise, insbesondere vollständig, vor dem Verstärker 130 angeordnet.

Insbesondere ist bei Verwendung eines nicht getaktet ausgebildeten Verstärkers 130 der Vorfilter 120 zumindest teilweise, insbesondere vollständig, in dem Verstärker 130 integriert.

Insbesondere ist bei Verwendung eines nicht getaktet ausgebildeten Verstärkers 130 der Vorfilter 120 zumindest teilweise, insbesondere vollständig, hinter dem Verstärker 130 angeordnet.

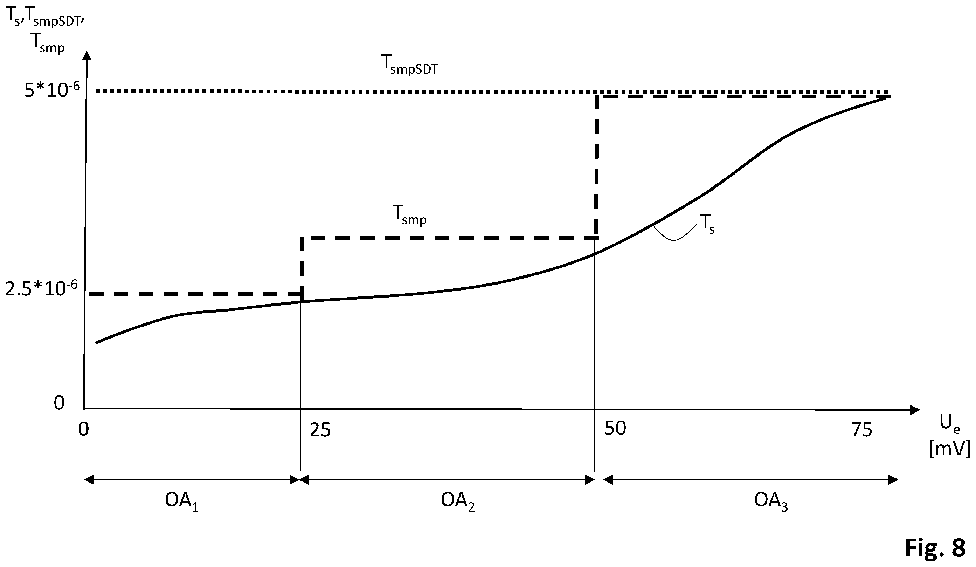

Figur 8 zeigt ein Beispiel für eine dynamische Überabtastung (englisch Oversampling) in Abhängigkeit von der Verstärkereingangsspannung Uₑ am Verstärker einer erfindungsgemäßen Vorrichtung.

Das in Figur 8 dargestellte Diagramm zeigt eine Einschwingzeit T_{S} an dem Verstärker einer erfindungsgemäßen Vorrichtung in Abhängigkeit von der Verstärkereingangsspannung Uₑ. Weiter zeigt das in Fig. 8 dargestellte Diagramm eine Abtastperiode Tₛₘₚ der erfindungsgemäßen Vorrichtung in Abhängigkeit der Verstärkereingangsspannung Uₑ gegenüber einer entsprechenden Abtastperiode T_{smpSDT} einer Vorrichtung gemäß dem Stand der Technik.

Das in Fig. 8 dargestellte Diagramm zeigt die Einschwingzeit T_{S} an dem Verstärker und die Abtastperiode Tₛₘₚ der erfindungsgemäßen Vorrichtung, sowie die Abtastperiode T_{smpSDT} einer Vorrichtung gemäß dem Stand der Technik für eine Verstärkereingangsspannung Uₑ in einem Bereich von 0mV bis 80mV.

In dem in Fig. 8 dargestellten beispielhaften Diagramm weist der Analog-Digital-Wandler eine Auflösung von 12 Bit ohne Überabtastung auf. Der Messfehler liegt dabei beispielhaft innerhalb eines Verstärkungsfehlers von ±0,5% zuzüglich ±4 LSB als Offset. Das Rauschverhalten der Messung beträgt in dem Beispiel ca. 32 LSB/Sigma. Die benötigte Überabtastungsrate (englisch Over-Sampling-Rate) für 1 LSB/Sigma beträgt in dem dargestellten Beispiel 1024.

Die Einschwingzeit Tₛ am Verstärker ist stark abhängig von der Verstärkereingangsspannung Uₑ. Damit kann eine Messung der Einschwingzeit T_{S} bei kleinen Verstärkereingangsspannungen Uₑ und damit bei kleinen Leitungsströmen I_{LTG} deutlich schneller erfolgen als bei gewöhnlichen Vorrichtungen.

Aufgrund der starken Abhängigkeit der Einschwingzeit Tₛ am Verstärker einer erfindungsgemäßen Vorrichtung kann die durch die Zeitgebereinheit eingestellte Abtastperiode Tₛₘₚ bei kleinen Verstärkereingangsspannungen Uₑ deutlich kleiner sein als bei großen Verstärkereingangsspannungen Uₑ.

In dem in dem in Fig. 8 dargestellten Diagramm gezeigten Beispiel liegt die Abtastperiode Tₛₘₚ des Analog-Digital-Wandlers in einem ersten Betriebsbereich OA₁ bei einem ersten Wert, beispielhaft bei 2µs. In einem zweiten Betriebsbereich OA₂ liegt die Abtastperiode Tₛₘₚ des Analog-Digital-Wandlers bei einem zweiten Wert, bei beispielhaft 3µs. In einem dritten Betriebsbereich OA₃ liegt die Abtastperiode Tₛₘₚ des Analog-Digital-Wandlers bei einem dritten Wert, bei beispielhaft 5,5µs.

Die Abtastperiode T_{smpSDT} einer Vorrichtung gemäß dem Stand der Technik dagegen richtet sich nach der notwendigen Abtastrate für die maximal mögliche Verstärkereingangsspannung Uₑ.

Dadurch ergibt sich für eine Vorrichtung gemäß dem Stand der Technik der Nachteil, dass für kleine Verstärkereingangsspannung Uₑ und damit für kleine Leitungsströme I_{LTG} die Abtastrate T_{smpSDT} bei Vorrichtungen gemäß dem Stand der Technik schlechter ist als die Abtastperiode Tₛₘₚ bei der erfindungsgemäßen Vorrichtung.

Im Bereich kleiner Verstärkereingangsspannung Uₑ ist ein Fehler durch das Rauschen dominant und spielt jedoch bei großer Verstärkereingangsspannung Uₑ eine untergeordnete Rolle. Dies ermöglicht eine Anpassung der Überabtastung des Analog-Digital-Wandlers, so dass die erfindungsgemäße Vorrichtung bei kleinen Verstärkereingangsspannung Uₑ über eine größere Anzahl Messwerte aus einer größeren Anzahl von Messungen mitteln kann, als bei großen Verstärkereingangsspannung Uₑ. Beispielsweise kann der Überabtastungs- und Dezimations-Filter diese Mittelung ausführen.

Insbesondere parametrisiert die Zeitgebereinheit der erfindungsgemäßen Vorrichtung den Überabtastungs- und Dezimations-Filter in Abhängigkeit von der durch die Zeitgebereinheit eingestellten Abtastperiode Tₛₘₚ um, um somit die Auswertung der Messwerte zu optimieren.

Insbesondere übermittelt der Analog-Digital-Wandler die jeweilige Abtastwerte des Eingangssignals des Analog-Digital-Wandlers an den Überabtastungs- und Dezimations-Filter mit einem jeweiligen Zeitstempel des jeweiligen Abtastwerts. Ein solcher Zeitstempel des jeweiligen Abtastwerts repräsentiert den Abtastzeitpunkt des Abtastwerts und ermöglicht somit dem Überabtastungs- und Dezimations-Filter Abtastwerte des Analog-Digital-Wandlers zu verarbeiten, die der Analog-Digital-Wandler nicht zu äquidistanten Abtastzeitpunkten abgetastet hat. Der Überabtastungs- und Dezimations-Filter kann beispielsweise zweistufig ausgeführt sein. Der Analog-Digital-Wandler übermittelt dem Überabtastungs- und Dezimations-Filter somit zeitlich nicht äquidistante Abtastwerten des Analog-Digital-Wandlers über das Ausgangssignal des Analog-Digital-Wandlers. Eine erste Stufe des Überabtastungs- und Dezimations-Filters erzeugt dabei aus diesen zeitlich nicht äquidistanten Abtastwerten des Analog-Digital-Wandlers beispielsweise mittels polynominaler Interpolation einen Datenstrom interpolierter und bevorzugt zeitlich äquidistanter interpolierter Abtastwerte. Eine zweite Stufe des Überabtastungs- und Dezimations-Filters erzeugt dann beispielsweise aus den nun zeitlich äquidistanten interpolierten Abtastwerten einen Datenstrom aus gefilterten und zeitlich äquidistanten, interpolierten Abtastwerten. Der Überabtastungs- und Dezimations-Filter gibt dann den Datenstrom aus gefilterten und zeitlich äquidistanten, interpolierten Abtastwerten als Dezimationsfilterausgangssignal aus.

Insbesondere bleibt die Gesamtwandelzeit pro Messung zur Aufwandsminimierung identisch. Dies ist wichtig für die Weiterverarbeitung. Bevorzugt passt die Zeitgebereinheit eine Samplezeit invers zur Anzahl der Mittelungen an.

Wie zuvor ausgeführt, kann die erfindungsgemäße Vorrichtung bzw. das erfindungsgemäße Verfahren auch äquivalente Werte an anderen Stellen im Signalpfad verwenden.

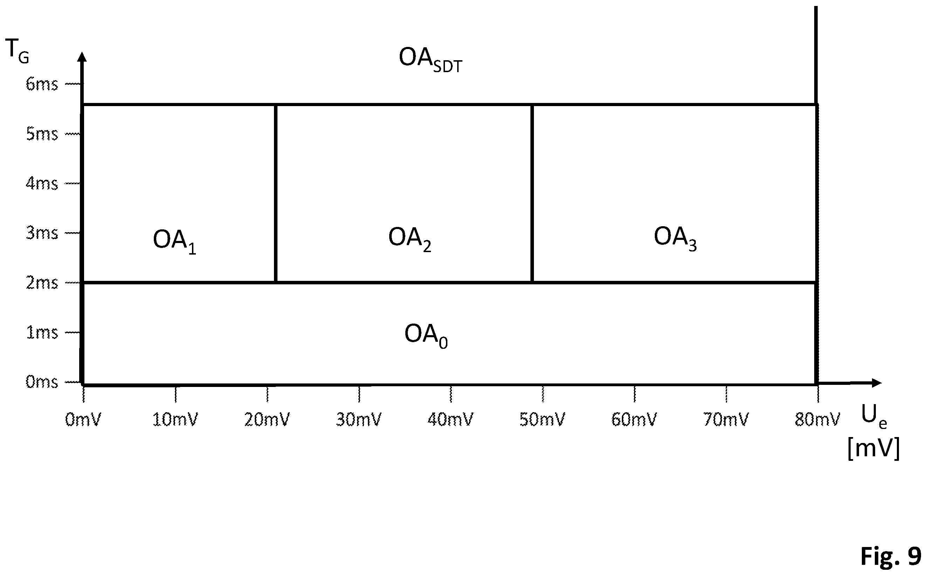

Figur 9 zeigt eine Gesamtwandelzeit T_{G} in Abhängigkeit der Verstärkereingangsspannung Uₑ und die zugehörigen Betriebsbereiche OA₀, OA₁, OA₂, OA₃ für eine Verstärkereingangsspannung Uₑ von 0mV bis 80mV. Dabei entsprechen die Betriebsbereiche OA₁, OA₂, OA₃ der Fig. 9 denjenigen in Fig. 8.Die Gesamtwandelzeit T_{G} ist hierbei die Zeit zwischen einem ersten Ausgabezeitpunkt der Ausgabe eines ersten Messwerts über das Dezimationsfilterausgangssignal und einem zweiten Ausgabezeitpunkt der Ausgabe des ersten Messwerts über das Dezimationsfilterausgangssignal. Die Gesamtwandelzeit T_{G} ermittelt sich aus der aktuellen Abtastperiode Tₛₘₚ des Analog-Digital-Wandlers multipliziert mit der Anzahl der Abtastwerte des Analog-Digitalwandlers über die der Überabtastungs- und Dezimations-Filter für die Ausgabe eines Messwerts über das Dezimationsfilterausgangssignal mittelt.

Ein nullter Betriebsbereich OA₀ unterhalb einer Mindestwandelzeit von beispielhaft 2,05ms ist weder für die vorschlagsgemäße Vorrichtung noch für eine Vorrichtung aus dem Stand der Technik in dem in Fig. 9 dargestellten Bereich der Verstärkereingangsspannung Uₑ erreichbar.

In dem ersten Betriebsbereich OA₁ einer erfindungsgemäßen Vorrichtung mittelt der Überabtastungs- und Dezimations-Filter über beispielsweise 1024 Abtastwerte des Analog-Digital-Wandlers. Die Zeitgebereinheit stellt in diesem ersten Arbeitsbereich OA₁ den Überabtastungs- und Dezimations-Filter so ein, dass der Überabtastungs- und Dezimations-Filter in diesem ersten Arbeitsbereich OA₁ über die besagten 1024 Abtastwerte des Analog-Digital-Wandlers mittelt. Die Zeitgebereinheit stellt in diesem ersten Arbeitsbereich OA₁ in dem in Fig. 9 dargestellten Beispiel den Analog-Digital-Wandler gleichzeitig so ein, dass die Abtastperiode T_{SMP} des Analog-Digital-Wandlers in diesem ersten Arbeitsbereich OA₁ eine beispielhafte zeitliche Länge von 2µs aufweist. Die Gesamtwandelzeit T_{G} ergibt sich dann als Multiplikation der 1024 Abtastwerte mit den 2µs pro Abtastwert, also der Abtastperiode Tₛₘₚ, zu beispielhaften 2,05ms.

In dem in Fig. 9 dargestellten Beispiel begrenzt eine ein beispielhafter oberer erster Eingangsspannungsgrenzwert von ca. 21mV den ersten Betriebsbereich OA₁ zu höheren Eingangsspannungswerten der Eingangsspannung Uₑ des Verstärkers hin. Eine beispielhafte Verstärkereingangsspannung von 0V begrenzt in dem in Fig. 9 dargestellten Beispiel den ersten Eingangsspannungsbereich der Verstärkereingangsspannung Uₑ im ersten Betriebsbereichs OA₁ nach unten hin.

In einem zweiten Betriebsbereich OA₂ einer erfindungsgemäßen Vorrichtung mittelt der Überabtastungs- und Dezimations-Filter über beispielsweise 682 Abtastwerte des Analog-Digital-Wandlers. Die Zeitgebereinheit stellt in diesem zweiten Arbeitsbereich OA₂ den Überabtastungs- und Dezimations-Filter ein, dass der Überabtastungs- und Dezimations-Filter in diesem zweiten Arbeitsbereich OA₂ über die besagten 682 Abtastwerte des Analog-Digital-Wandlers mittelt. Die Zeitgebereinheit stellt in diesem zweiten Arbeitsbereich OA₂ in dem in Fig. 9 dargestellten Beispiel den Analog-Digital-Wandler gleichzeitig so ein, dass die Abtastperiode T_{SMP} des Analog-Digital-Wandlers in diesem zweiten Arbeitsbereich OA₂ eine beispielhafte zeitliche Länge von nun 3µs aufweist. Die Gesamtwandelzeit T_{G} ergibt sich dann als Multiplikation der 682 Abtastwerte mit den 3µs pro Abtastwert, also der Abtastperiode Tₛₘₚ, wieder zu beispielhaften 2,05ms. Die Gesamtwandelzeit T_{G} ändert sich also im zweiten Betriebsbereich OA₂ im Vergleich zur Gesamtwandelzeit T_{G} im ersten Betriebsbereich OA₁ nicht wesentlich.

In dem in Fig. 9 dargestellten Beispiel begrenzt ein beispielhafter oberer zweiter Eingangsspannungsgrenzwert von ca. 48mV den zweiten Betriebsbereich OA₂ zu höheren Eingangsspannungswerten der Verstärkereingangsspannung Uₑ hin.

In dem in Fig. 9 dargestellten Beispiel begrenzt der beispielhafte obere erste Eingangsspannungsgrenzwert von ca. 21mV den zweiten Betriebsbereich OA₂ zu niedrigeren Eingangsspannungswerten der Verstärkereingangsspannung Uₑ hin.

In einem dritten Betriebsbereich OA₃ einer erfindungsgemäßen Vorrichtung mittelt der Überabtastungs- und Dezimations-Filter über beispielsweise 372 Abtastwerte des Analog-Digital-Wandlers. Die Zeitgebereinheit stellt in diesem dritten Arbeitsbereich OA₃ den Überabtastungs- und Dezimations-Filter ein, dass der Überabtastungs- und Dezimations-Filter in diesem dritten Arbeitsbereich OA₃ über die besagten 372 Abtastwerte des Analog-Digital-Wandlers mittelt. Die Zeitgebereinheit stellt in diesem dritten Arbeitsbereich OA₃ in dem in Fig. 9 dargestellten Beispiel den Analog-Digital-Wandler gleichzeitig so ein, dass die Abtastperiode T_{SMP} des Analog-Digital-Wandlers in diesem dritten Arbeitsbereich OA₃ eine beispielhafte zeitliche Länge von nun 5,5µs aufweist. Die Gesamtwandelzeit T_{G} ergibt sich dann als Multiplikation der 372 Abtastwerte mit den 5,5µs pro Abtastwert, also der Abtastperiode Tₛₘₚ, wieder zu beispielhaften 2,05ms. Die Gesamtwandelzeit T_{G} ändert sich also im dritten Betriebsbereich OA₃ im Vergleich zur Gesamtwandelzeit T_{G} im ersten Betriebsbereich OA₁ und im Vergleich zur Gesamtwandelzeit T_{G} im zweiten Betriebsbereich OA₂ nicht wesentlich.

In dem in Fig. 9 dargestellten Beispiel begrenzt ein beispielhafter oberer dritter Eingangsspannungsgrenzwert von ca. 80mV den dritten Betriebsbereich OA₃ zu höheren Eingangsspannungswerten der Verstärkereingangsspannung Uₑ hin.

In dem in Fig. 9 dargestellten Beispiel begrenzt der beispielhafte obere zweite Eingangsspannungsgrenzwert von ca. 48mV den dritten Betriebsbereich OA₃ zu niedrigeren Eingangsspannungswerten der Verstärkereingangsspannung Uₑ hin.

In dem in Fig. 9 dargestellten Beispiel ist der dritte Eingangsspannungsgrenzwert von ca. 80mV gleichzeitig die beispielhafte Spezifikationsgrenze für den Eingangsspannungswert der Verstärkereingangsspannung Uₑ.

Vorzugsweise wertet die Zeitgebereinheit eine Gesamtwandelzeitvorgabe aus. Die Zeitgebereinheit berechnet in Abhängigkeit von dieser Gesamtwandelzeitvorgabe und den jeweiligen Zeitgebereingangswerten der verwendeten Zeitgebereingangswertsignale die Anzahl der Abtastwerte und die Abtastperiode Tₛₘₚ.

Wie zuvor entspricht dabei die Anzahl der Abtastwerte der Anzahl der Abtastwerte des Analog-Digital-Wandlers. Der Überabtastungs- und Dezimations-Filter verwendet diese Anzahl der Abtastwerte für die Berechnung eines Ausgabewerts für die Ausgabe eines Messwerts über das Dezimationsfilterausgangssignal.

Bei der Verwendung mehrerer Zeitgebereingangswerte verschiedener Zeitgebereingangswertsignale kann die Zeitgebereinheit für diese Berechnung beispielsweise ein Polynom mit mehreren verschiedenen Variablen verwenden. Die verschiedenen Variablen dieses Polynoms können dann die verschiedenen Zeitgebereingangswerte der verschiedenen Zeitgebereingangswertsignale sein.

Bevorzugt verhält sich daher in einer vorschlagsgemäßen Variante die erfindungsgemäße Vorrichtung wie eine Vorrichtung aus dem Stand der Technik, wenn die der Zeitgebereinheit vorgegebene Gesamtwandelzeit T_{G} in Form der besagten Gesamtwandelzeitvorgabe oberhalb eines Gesamtwandelzeitgrenzwerts liegt.

Ein Betriebsbereich OA_{SDT} einer Vorrichtung gemäß dem Stand der Technik liegt oberhalb einer Gesamtwandelzeit T_{G} von 5,5ms.

Dieser Gesamtwandelzeitgrenzwert ergibt sich aus einer Abtastperiode Tₛₘₚ=T_{SDT} von 5,5µs und einer Mittelung über 1024 Abtastwerte des Analog-Digital-Wandlers im Überabtastungs- und Dezimations-Filter. Eine Multiplikation der beispielhaften Abtastperiode Tₛₘₚ=T_{SDT} von 5,5µs mit der Anzahl von 1024 Abtastwerten des Analog-Digital-Wandlers für die Mittelung im Überabtastungs- und Dezimations-Filter ergibt diesen Gesamtwandelzeitgrenzwert von im Wesentlichen 5,5ms.

Bevorzugt erfolgt die Vorgabe der vorgegebene Gesamtwandelzeit T_{G} gegenüber der Zeitgebereinheit mittels einer Datenübertragung von einem übergeordneten Rechnersystem an die Zeitgebereinheit und einer damit einhergehenden Programmierung eines entsprechenden Registers in der Zeitgebereinheit. Typischerweise ergibt sich der Gesamtwandelzeitgrenzwert aus der Konstruktion der vorschlagsgemäßen Vorrichtung und den Eigenschaften der zur Herstellung der erfindungsgemäßen Vorrichtung verwendeten technischen Lehre (verwendete Halbleitertechnologie). Außerdem spielen auch die Eigenschaften des Anwendungssystems, in dem die erfindungsgemäße Vorrichtung Verwendung findet, eine Rolle. Ein weiterer Einflussfaktor sind die konkret gewählte Realisierungsform des Analog-Digital-Wandlers und die damit einhergehenden Eigenschaften des besagten Analog-Digital-Wandlers. Natürlich ist es auch denkbar, die Gesamtwandelzeit T_{G} gegenüber der Zeitgebereinheit werksseitig bereits konstruktiv vorzugeben.

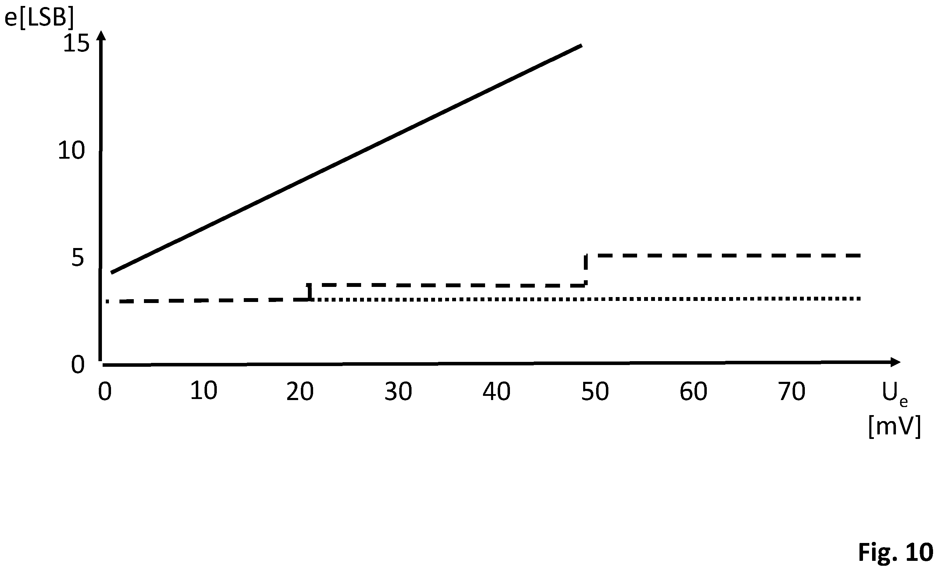

Figur 10 zeigt beispielhaft passend zu den Figuren 8 und 9 einen Restfehler e durch Rauschen in Abhängigkeit der Verstärkereingangsspannung Uₑ. Die in Fig. 10 gezeigte durchgezogene Linie entspricht einer beispielhaften, nur der Verdeutlichung dienende Spezifikationsgrenze.

Die gestrichelte Linie gibt für eine erfindungsgemäße Vorrichtung einen Anstieg des Rauschens durch die Reduktion der Anzahl der Abtastpunkte mit steigender Verstärkereingangsspannung Uₑ wieder.

Die gepunktete Linie gibt das Rauschen für eine Vorrichtung aus dem Stand der Technik wieder.

Zwar steigt das Rauschen für eine erfindungsgemäße Vorrichtung durch die Reduktion der Anzahl der für die Mittelung im Überabtastungs- und Dezimations-Filter verwendeten Abtastwerte des Analog-Digital-Wandlers vom ersten Betriebsbereich OA₁ zum zweiten Betriebsbereich OA₂ und vom zweiten Betriebsbereich OA₃ zum dritten Betriebsbereich OA₃ an, allerdings liegt das Rauschen immer noch unter der Spezifikationsgrenze.

Insbesondere muss bei der Konstruktion der erfindungsgemäßen Vorrichtung das sich ergebende Rauschen im Vergleich zur der jeweiligen vorgeschriebenen Spezifikation berücksichtigt werden. Dies betrifft beispielsweise die Auswahl des Überabtastungs- und Dezimations-Filters, die Auswahl der Konstruktion und des Wandlungsverfahrens des Analog-Digital-Wandlers und die oben erwähnten Vorgaben.

Gegenüber dem Stand der Technik nimmt in der erfindungsgemäßen Vorrichtung ein Rauschen mit einem erhöhen der Verstärkereingangsspannung Uₑ zu. Jedoch spielt das Rauschen bei einer großen Verstärkereingangsspannung Uₑ eine untergeordnete Rolle.

Die erfindungsgemäße Vorrichtung bietet den Vorteil, einer dynamischen Überabtastung (englisch Oversampling) in Abhängigkeit von der Verstärkereingangsspannung Uₑ. Bei kleinen Verstärkereingangsspannungen Uₑ kann die Abtastperiode sehr klein gewählt werden. Die durch die Zeitgebereinheit eingestellte Abtastperiode Tₛₘₚ kann bei kleinen Verstärkereingangsspannungen Uₑ deutlich kleiner sein als bei großen Verstärkereingangsspannungen Uₑ.

Die Abtastperiode T_{smpSDT} einer Vorrichtung gemäß dem Stand der Technik dagegen richtet sich nach der notwendigen Abtastrate für die maximal mögliche Verstärkereingangsspannung Uₑ.

Dadurch ergibt sich für eine Vorrichtung gemäß dem Stand der Technik der Nachteil, dass für kleine Verstärkereingangsspannung Uₑ und damit für kleine Leitungsströme I_{LTG} die Abtastrate T_{smpSDT} bei Vorrichtungen gemäß dem Stand der Technik schlechter ist als die Abtastperiode Tₛₘₚ bei der erfindungsgemäßen Vorrichtung.

### Bezugszeichenliste

- 100: Schaltungseinheit
- 101: erster Knoten
- 102: zweiter Knoten
- 103: dritter Knoten
- 104: vierter Knoten

- 111: erster Widerstand
- 112: zweiter Widerstand
- 113: Shunt-Widerstand

- 120: Vorfilter

- 130: Verstärker
- 131: erster Verstärkereingang
- 132: zweiter Verstärkereingang
- 133: Verstärkerausgang
- 134: Verstärker-Ausgangssignal

- 140: Analogmultiplexer oder analoger Verbindungsschalter

- 200: Analog-zu-Digital-Wandler
- 201: analoges Eingangssignal
- 202: digitales Ausgangssignal

- 300: Überabtastungs- und Dezimations-Filter
- 301: Dezimationsfiltereingangssignal
- 302: Dezimationsfilterausgangssignal

- 400: Zeitgebereinheit
- 401: Zeitgebereingangswertsignal / Zeitgebereingangswert
401a erster Zeitgebereingangswert
401b zweiter Zeitgebereingangswert
401c dritter Zeitgebereingangswert
- 402: Abtaststeuerleitung
- 403: Dezimationsfiltersteuerleitung
- 404: Verstärkersteuerungsleitung
- 405: Vorfiltersteuerleitung

- I_{LTG}: Leitungsstromes
- C: Kondensator
- U_{S}: Shunt-Widerstandsspannung
- Uₑ: Verstärkereingangsspannung
- fₒ: oberen Grenzfrequenz des Überabtastungs- und Dezimations-Filters
- f_{oV}: oberen Grenzfrequenz des Vorfilters
- Tₛ: Einschwingzeit am Verstärker
- Tₛₘₚ: Abtastperiode einer erfindungsgemäßen Vorrichtung
- T_{smpSDT}: Abtastperiode einer Vorrichtung nach dem Stand der Technik
- OA: Betriebsbereich
OA₀ nullter Betriebsbereich
OA₁ erster Betriebsbereich
OA₂ zweiter Betriebsbereich
OA₃ dritter Betriebsbereich
OA_{SDT} Betriebsbereich einer Vorrichtung gemäß dem Stand der Technik

## Patentansprüche

1. Vorrichtung zur Erfassung eines elektrischen Leitungsstromes (I_{LTG}) in einer Leitung, wobei der elektrische Leitungsstrom (I_{LTG}) von einem ersten Knoten (101) der Vorrichtung zu einem dritten Knoten (103) der Vorrichtung fließt, wobei
die Vorrichtung umfasst
- Einen Vorfilter (120)
- einen Verstärker (130), wobei der Verstärker (130) einen ersten Verstärkereingang (131), einen zweiten Verstärkereingang (132) und einen Verstärkerausgang (133) aufweist,
- einen Analog-Digital-Wandler (200), wobei der Analog-Digital-Wandler (200) einen Eingang und einen Ausgang aufweist, und
- einen Überabtastungs- und Dezimationsfilter (300), wobei der Überabtastungs- und Dezimationsfilter (300) einen Eingang und einen Ausgang aufweist, wobei
der Analog-Digital-Wandler (200) dazu eingerichtet ist einen analogen Wert eines analogen Eingangssignals (201) des Analog-Digital-Wandlers (200) zu Abtastzeitpunkten abzutasten, und wobei
der Analog-Digitalwandler (200) dazu eingerichtet ist zu diesen Abtastzeitpunkten den analogen Wert des analogen Eingangssignals (201) des Analog-zu-Digital-Wandlers (200) in einen digitalen Wert zu wandeln, und wobei
der Analog-Digital-Wandler (200) dazu eingerichtet ist diesen digitalen Wert über ein digitales Ausgangssignal (202) des Digital-Analog-Wandlers (200) an den Eingang des Überabtastungs- und Dezimations-Filters (300) zu signalisieren, und wobei
eine Mehrzahl von Ausgangswerten eines Dezimationsfilterausgangssignals (302) zumindest zeitweise die durch die Vorrichtung erfassten Stromwerte für den Leitungsstrom (I_{LTG}) darstellen,
**dadurch gekennzeichnet, dass**
die Vorrichtung eine Zeitgebereinheit (400) umfasst, wobei
die Zeitgebereinheit (400) dazu eingerichtet ist mindestens ein Zeitgebereingangswertsignal (401) mit mindestens einem jeweiligen Zeitgebereingangswert zu erfassen, und wobei
die Zeitgebereinheit (400) dazu eingerichtet ist mindestens eine Signalübertragungseigenschaft des Vorfilters (120) und/oder des Verstärkers (130) und/oder des Analog-Digital-Wandlers (200) und/oder des Überabtastungs- und Dezimations-Filters (300) in Abhängigkeit von dem mindestens einen erfassten jeweiligen Zeitgebereingangswert zumindest zeitweise zu beeinflussen.

2. Vorrichtung gemäß Anspruch 1, **dadurch gekennzeichnet,**
**dass** die von der Zeitgebereinheit (400) in Abhängigkeit von dem mindestens einen erfassten jeweiligen Zeitgebereingangswert beeinflusste mindestens eine Signalübertragungseigenschaft mindestens ein Abtastzeitpunkt und/oder mindestens eine Filtereigenschaft und/oder mindestens eine Verstärkereigenschaft ist.

3. Vorrichtung gemäß einem der Ansprüche 1 bis 2, **dadurch gekennzeichnet,**
**dass** die von der Zeitgebereinheit (400) in Abhängigkeit von dem mindestens einen erfassten jeweiligen Zeitgebereingangswert beeinflusste mindestens eine Signalübertragungseigenschaft mindestens eine Filterfrequenz und/oder mindestens eine Dämpfung und/oder mindestens eine Verstärkung des Vorfilters (120) und/oder des Überabtastungs- und Dezimations-Filters (300) ist.

4. Vorrichtung gemäß einem der vorstehenden Ansprüche, **dadurch gekennzeichnet,**
**dass** das mindestens eine Zeitgebereingangswertsignal (401) dem analogen Eingangssignal (201) des Analog-Digital-Wandlers (200) entspricht, wobei
der mindestens eine jeweilige Zeitgebereingangswert ein ADC-Eingangswert des analogen Eingangssignals (201) des Analog-Digital-Wandlers (200) ist.

5. Vorrichtung gemäß Anspruch 4, **dadurch gekennzeichnet,**
**dass** die Zeitgebereinheit (400) dazu eingerichtet ist zumindest zeitweise Werte des analogen Eingangssignals (201) des Analog-Digital-Wandlers (200) in Form erfasster ADC-Eingangswerte als Zeitgebereingangswerte zu erfassen und
wobei die Zeitgebereinheit (400) dazu eingerichtet ist Abtastzeitpunkte in Abhängigkeit der erfassten ADC-Eingangswerte zu beeinflussen.

6. Vorrichtung gemäß einem der Ansprüche 4 bis 5, **dadurch gekennzeichnet,**
**dass** die Zeitgebereinheit (400) dazu eingerichtet ist zumindest zeitweise Werte des analogen Eingangssignals (201) des Analog-Digital-Wandlers (200) in Form erfasster ADC-Eingangswerte als Zeitgebereingangswerte zu erfassen, wobei
die Zeitgebereinheit (400) dazu eingerichtet ist mindestens eine Eigenschaft des Vorfilters (120), und/oder des Verstärkers (130), und/oder des Überabtastungs- und Dezimationsfilters (300) in Abhängigkeit von den erfassten ADC-Eingangswerten zu beeinflussen, wobei
die durch die Zeitgebereinheit (400) beeinflusste Eigenschaft insbesondere mindestens eine Filterfrequenz und/oder mindestens eine Verstärkung und/oder mindestens eine Dämpfung des Vorfilters (120) und/oder des Überabtastungs- und Dezimationsfilters (300) ist, und/oder die durch die Zeitgebereinheit (400) beeinflusste Eigenschaft insbesondere mindestens eine Verstärkung und/oder mindestens eine Dämpfung des Verstärkers (130) ist.

7. Vorrichtung gemäß einem der vorstehenden Ansprüche, **dadurch gekennzeichnet,**
**dass** das Zeitgebereingangswertsignal (401) dem digitalen Ausgangssignal (202) des Analog-Digital-Wandlers (200) entspricht, wobei
der mindestens eine jeweilige Zeitgebereingangswert ein ADC-Ausgangswert des digitalen Ausgangssignals (202) des Analog-Digital-Wandlers (200) ist.

8. Vorrichtung gemäß Anspruch 7, **dadurch gekennzeichnet,**
**dass** die Zeitgebereinheit (400) dazu eingerichtet ist zumindest zeitweise Werte des Ausgangssignals (202) des Analog-Digital-Wandlers (200) in Form erfasster ADC-Ausgangswerte als Zeitgebereingangswerte zu erfassen, wobei
die Zeitgebereinheit (400) dazu eingerichtet ist Abtastzeitpunkte in Abhängigkeit der erfassten ADC-Ausgangswerte des digitalen Ausgangssignals (202) zu beeinflussen.

9. Vorrichtung gemäß einem der Ansprüche 7 bis 8, **dadurch gekennzeichnet,**
**dass** die Zeitgebereinheit (400) dazu eingerichtet ist zumindest zeitweise Werte des digitalen Ausgangssignals (202) des Analog-Digital-Wandlers (200) in Form erfasster ADC-Ausgangswerte als Zeitgebereingangswerte zu erfassen, wobei
die Zeitgebereinheit (400) dazu eingerichtet ist mindestens eine Eigenschaft des Vorfilters (120), und/oder des Verstärkers (130), und/oder des Überabtastungs- und Dezimationsfilters (300) in Abhängigkeit von diesen erfassten ADC-Ausgangswerten zu beeinflussen, wobei
die durch die Zeitgebereinheit (400) beeinflusste Eigenschaft insbesondere mindestens eine Filterfrequenz, und/oder mindestens eine Verstärkung, und/oder mindestens eine Dämpfung des Vorfilters (120) und/oder des Überabtastungs- und Dezimationsfilters (300) ist, und/oder die durch die Zeitgebereinheit (400) beeinflusste Eigenschaft insbesondere mindestens eine Verstärkung und/oder mindestens eine Dämpfung des Verstärkers (130) ist.

10. Vorrichtung gemäß einem der vorstehenden Ansprüche, **dadurch gekennzeichnet,**
**dass** das Zeitgebereingangswertsignal (401) einem Dezimationsfiltereingangssignal (301)des Überabtastungs- und Dezimations-Filters (300) entspricht, wobei
der mindestens eine jeweilige Zeitgebereingangswert ein Dezimationsfilter-Eingangswert des Überabtastungs- und Dezimations-Filters (300) ist.

11. Vorrichtung gemäß Anspruch 10, **dadurch gekennzeichnet,**
**dass** die Zeitgebereinheit (400) dazu eingerichtet ist zumindest zeitweise Werte des Dezimationsfiltereingangssignals (301) in Form erfasster Dezimationsfilter-Eingangswerte als Zeitgebereingangswerte des Zeitgebereingangswertsignals (401) zu erfassen, wobei die Zeitgebereinheit (400) dazu eingerichtet ist Abtastzeitpunkte in Abhängigkeit von erfassten Dezimationsfilter-Eingangswerten zu beeinflussen.

12. Vorrichtung gemäß einem der Ansprüche 10 bis 11, **dadurch gekennzeichnet,**
**dass** die Zeitgebereinheit (400) dazu eingerichtet ist zumindest zeitweise Werte des Dezimationsfiltereingangssignals (301) in Form erfasster Dezimationsfilter-Eingangswerte als Zeitgebereingangswerte des Zeitgebereingangswertsignals (401) zu erfassen, wobei
die Zeitgebereinheit (400) dazu eingerichtet ist mindestens eine Eigenschaft des Vorfilters (120), und/oder des Verstärkers (130), und/oder des Überabtastungs- und Dezimationsfilters (300) in Abhängigkeit von erfassten Dezimationsfilter-Eingangswerten zu beeinflussen, wobei die durch die Zeitgebereinheit (400) beeinflusste Eigenschaft insbesondere mindestens eine Filterfrequenz, und/oder mindestens eine Verstärkung, und/oder mindestens eine Dämpfung des Vorfilters (120) und/oder des Überabtastungs- und Dezimationsfilters (300) ist, und/oder die durch die Zeitgebereinheit (400) beeinflusste Eigenschaft insbesondere mindestens eine Verstärkung, und/oder mindestens eine Dämpfung des Verstärkers (130) ist.

13. Vorrichtung gemäß einem der vorstehenden Ansprüche, **dadurch gekennzeichnet,**
**dass** das Zeitgebereingangswertsignal (401) dem Dezimationsfilterausgangssignal (302) des Überabtastungs- und Dezimations-Filters (300) entspricht, wobei
der mindestens eine jeweilige Zeitgebereingangswert ein Dezimationsfilter-Ausgangswert des Dezimationsfilterausgangssignals (302) ist.

14. Vorrichtung gemäß Anspruch 13, **dadurch gekennzeichnet,**
**dass** die Zeitgebereinheit (400) dazu eingerichtet ist zumindest zeitweise Werte des Dezimationsfilterausgangssignals (302) in Form erfasster Dezimationsfilter-Ausgangswerte als Zeitgebereingangswerte des Zeitgebereingangswertsignals (401) zu erfassen, wobei
die Zeitgebereinheit (400) dazu eingerichtet ist Abtastzeitpunkte in Abhängigkeit von erfassten Dezimationsfilter-Ausgangswerten zu beeinflussen.

15. Vorrichtung gemäß einem der Ansprüche 13 bis 14, **dadurch gekennzeichnet,**
**dass** die Zeitgebereinheit (400) dazu eingerichtet ist zumindest zeitweise Werte des Dezimationsfilterausgangssignals (302) in Form erfasster Dezimationsfilter-Ausgangswerte als Zeitgebereingangswerte eines Zeitgebereingangswertsignals (401) zu erfassen, wobei die Zeitgebereinheit (400) dazu eingerichtet ist mindestens eine Eigenschaft des Vorfilters (120), und/oder des Verstärkers (130), und/oder des Überabtastungs- und Dezimationsfilters (300) in Abhängigkeit von erfassten Dezimationsfilter-Ausgangswerten zu beeinflussen,
wobei
die durch die Zeitgebereinheit (400) beeinflusste Eigenschaft insbesondere mindestens eine Filterfrequenz und/oder mindestens eine Verstärkung und/oder mindestens eine Dämpfung des Vorfilters (120) und/oder des Überabtastungs- und Dezimationsfilters (300) ist, und/oder die durch die Zeitgebereinheit (400) beeinflusste Eigenschaft insbesondere mindestens eine Verstärkung, und/oder mindestens eine Dämpfung des Verstärkers (130) ist.

16. Vorrichtung gemäß einem der vorstehenden Ansprüche, **dadurch gekennzeichnet,**
**dass** eine Abtastperiode einer Zeit zwischen einem ersten Abtastzeitpunkt der Abtastung des analogen Werts des analogen Eingangssignals (201) des Analog-Digital-Wandlers (200) durch den Analog-Digital-Wandler (200) und einem unmittelbar zeitlich nachfolgenden zweiten Abtastzeitpunkt der Abtastung des analogen Werts des analogen Eingangssignals (201) des Analog-Digital-Wandlers (200) durch den Analog-zu-Digitalwandler (200) darstellt, wobei
die Zeitgebereinheit (400) dazu eingerichtet ist die Abtastperiode des Analog-Digital-Wandlers (200) in Abhängigkeit von dem zumindest einem erfassten jeweiligen Zeitgebereingangswert zu beeinflussen.

17. Vorrichtung gemäß Anspruch 16, **dadurch gekennzeichnet,**
**dass** Abtastperiode über einem Abtastperiodengrenzwert liegt, wenn Beträge der erfassten ADC-Eingangswerte unter einem ersten ADC-Eingangsschwellwert liegen und wobei
die Abtastperiode unter dem Abtastperiodengrenzwert liegt, wenn Beträge der erfassten ADC-Eingangswerte über dem ersten ADC-Eingangsschwellwert liegen.

18. Vorrichtung gemäß einem der Ansprüche 16 bis 17, **dadurch gekennzeichnet,**
**dass** die Abtastperiode über einem Abtastperiodengrenzwert liegt, wenn Beträge der erfassten ADC-Ausgangswerte unter einem ersten ADC-Ausgangsschwellwert liegen, und
die Abtastperiode unter dem Abtastperiodengrenzwert liegt, wenn Beträge der erfassten ADC-Ausgangswerte über dem ersten ADC-Ausgangsschwellwert liegen.

19. Vorrichtung gemäß einem der Ansprüche 16 bis 18, **dadurch gekennzeichnet,**
**dass** die Abtastperiode über dem Abtastperiodengrenzwert liegt, wenn Beträge der erfassten Dezimationsfilter-Eingangswerte unter einem ersten Dezimationsfilter-Eingangsschwellwert liegen, und
die Abtastperiode unter dem Abtastperiodengrenzwert liegt, wenn Beträge der erfassten Dezimationsfilter-Eingangswerte über dem ersten Dezimationsfilter-Eingangsschwellwert liegen.

20. Vorrichtung gemäß einem der Ansprüche 16 bis 19, **dadurch gekennzeichnet,**
**dass** die Abtastperiode über einem Abtastperiodengrenzwert liegt, wenn Beträge der erfassten Dezimationsfilter-Ausgangswerte unter dem ersten Dezimationsfilter-Ausgangsschwellwert liegen und
die Abtastperiode unter dem Abtastperiodengrenzwert liegt, wenn Beträge der erfassten Dezimationsfilter-Ausgangswerte über dem ersten Dezimationsfilter-Ausgangsschwellwert liegen.

21. Vorrichtung gemäß einem der vorstehenden Ansprüche, **dadurch gekennzeichnet,**
**dass** der Überabtastungs- und Dezimations-Filter (300) eine obere Grenzfrequenz (fₒ) aufweist, wobei
der Überabtastungs- und Dezimations-Filter (300) dazu eingerichtet ist Signalanteile mit einer Signalanteilsfrequenz oberhalb der oberen Grenzfrequenz (fₒ) stärker zu bedämpfen als Signalanteile mit einer Signalanteilsfrequenz unmittelbar unterhalb der oberen Grenzfrequenz (fₒ) und wobei
die Zeitgebereinheit (400) dazu eingerichtet ist die obere Grenzfrequenz (fₒ) des Überabtastungs- und Dezimations-Filters (300) in Abhängigkeit von dem zumindest einem erfassten jeweiligen Zeitgebereingangswert zu beeinflussen.

22. Vorrichtung gemäß Anspruch 21, **dadurch gekennzeichnet,**
**dass** die obere Grenzfrequenz (fₒ) des Überabtastungs- und Dezimations-Filters (300) über einem Dezimationsgrenzfrequenzgrenzwert liegt, wenn Beträge der erfassten ADC-Eingangswerte unter einem zweiten ADC-Eingangsschwellwert liegen, und
die obere Grenzfrequenz (fₒ) des Überabtastungs- und Dezimations-Filters (300) unter dem Dezimationsgrenzfrequenzgrenzwert liegt, wenn Beträge der erfassten ADC-Eingangswerte über dem zweiten ADC-Eingangsschwellwert liegen.

23. Vorrichtung gemäß einem der Ansprüche 21 bis 22, **dadurch gekennzeichnet,**
**dass** die obere Grenzfrequenz (fₒ) des Überabtastungs- und Dezimations-Filters (300) über dem Dezimationsgrenzfrequenzgrenzwert liegt, wenn Beträge der erfassten ADC-Ausgangswerte unter einem zweiten ADC-Ausgangsschwellwert liegen, und
die obere Grenzfrequenz (fₒ) des Überabtastungs- und Dezimations-Filters (300) unter dem Dezimationsgrenzfrequenzgrenzwert liegt, wenn Beträge der erfassten ADC-Ausgangswerte über dem zweiten ADC-Ausgangsschwellwert liegen

24. Vorrichtung gemäß einem der Ansprüche 21 bis 23, **dadurch gekennzeichnet,**
**dass** die obere Grenzfrequenz (fₒ) des Überabtastungs- und Dezimations-Filters (300) über dem Dezimationsgrenzfrequenzgrenzwert liegt, wenn Beträge der erfassten Dezimationsfilter-Eingangswerte unter einem zweiten Dezimationsfilter-Eingangsschwellwert liegen, und
die obere Grenzfrequenz (fₒ) des Überabtastungs- und Dezimations-Filters (300) unter dem Dezimationsgrenzfrequenzgrenzwert liegt, wenn Beträge der erfassten Dezimationsfilter-Eingangswerte über dem zweiten Dezimationsfilter-Eingangsschwellwert liegen.

25. Vorrichtung gemäß einem der Ansprüche 21 bis 24, **dadurch gekennzeichnet,**
**dass** die obere Grenzfrequenz (fₒ) des Überabtastungs- und Dezimations-Filters (300) über dem Dezimationsgrenzfrequenzgrenzwert liegt, wenn Beträge der erfassten Dezimationsfilter-Ausgangswerte unter einem zweiten Dezimationsfilter-Ausgangsschwellwert liegen, und
die obere Grenzfrequenz (fₒ) des Überabtastungs- und Dezimations-Filters (300) über dem Dezimationsgrenzfrequenzgrenzwert liegt, wenn Beträge der erfassten Dezimationsfilter-Ausgangswerte über dem zweiten Dezimationsfilter-Ausgangsschwellwert liegen.

26. Vorrichtung gemäß einem der vorstehenden Ansprüche, **dadurch gekennzeichnet,**
**dass** der Vorfilter (120) eine obere Grenzfrequenz (f_{oV}) aufweist, wobei
der Vorfilter (120) dazu eingerichtet ist Signalanteile mit einer Signalanteilsfrequenz oberhalb der oberen Grenzfrequenz (f_{oV}) stärker zu bedämpfen als Signalanteile mit einer Signalanteilsfrequenz unmittelbar unterhalb der oberen Grenzfrequenz (f_{oV}), und wobei
die Zeitgebereinheit (400) dazu eingerichtet ist die oberen Grenzfrequenz (f_{oV}) des Vorfilters (120) in Abhängigkeit von dem zumindest einem erfassten jeweiligen Zeitgebereingangswert zu beeinflussen.

27. Vorrichtung gemäß Anspruch 26, **dadurch gekennzeichnet,**
**dass** die obere Grenzfrequenz (f_{oV}) des Vorfilters (120) über einem Vorfiltergrenzfrequenzgrenzwert liegt, wenn Beträge der erfassten ADC-Eingangswerte unter einem dritten ADC-Eingangsschwellwert liegen, und die obere Grenzfrequenz (f_{oV}) des Vorfilters (120) unter dem Vorfiltergrenzfrequenzgrenzwert liegt, wenn Beträge der erfassten ADC-Eingangswerte über dem dritten ADC-Eingangsschwellwert liegen.

28. Vorrichtung gemäß einem der Ansprüche 26 bis 27, **dadurch gekennzeichnet,**
**dass** die obere Grenzfrequenz (f_{oV}) des Vorfilters (120) über dem Vorfiltergrenzfrequenzgrenzwert liegt, wenn Beträge der erfassten ADC-Ausgangswerte unter dem dritten ADC-Ausgangsschwellwert liegen, und die obere Grenzfrequenz (f_{oV}) des Vorfilters (120) unter dem Vorfiltergrenzfrequenzgrenzwert liegt, wenn Beträge der erfassten ADC-Ausgangswerte über dem dritten ADC-Ausgangsschwellwert liegen.

29. Vorrichtung gemäß einem der Ansprüche 26 bis 28, **dadurch gekennzeichnet,**
**dass** die obere Grenzfrequenz (f_{oV}) des Vorfilters (120) über dem Vorfiltergrenzfrequenzgrenzwert liegt, wenn Beträge der erfassten Dezimationsfilter-Eingangswerte unter dem dritten Dezimationsfilter-Eingangsschwellwert liegen, und die obere Grenzfrequenz (f_{oV}) des Vorfilters (120) unter dem Vorfiltergrenzfrequenzgrenzwert liegt, wenn Beträge der erfassten Dezimationsfilter-Eingangswerte über dem dritten Dezimationsfilter-Eingangsschwellwert liegen.

30. Vorrichtung gemäß einem der Ansprüche 26 bis 29, **dadurch gekennzeichnet,**
**dass** die obere Grenzfrequenz (f_{oV}) des Vorfilters (120) über dem Vorfiltergrenzfrequenzgrenzwert liegt, wenn Beträge der erfassten Dezimationsfilter-Ausgangswerte unter dem dritten Dezimationsfilter-Ausgangsschwellwert liegen, und die obere Grenzfrequenz (f_{oV}) des Vorfilters (120) über dem Vorfiltergrenzfrequenzgrenzwert liegt, wenn Beträge der erfassten Dezimationsfilter-Ausgangswerte über dem dritten Dezimationsfilter-Ausgangsschwellwert liegen.

31. Vorrichtung gemäß einem der vorstehenden Ansprüche, **dadurch gekennzeichnet,**
**dass** der Verstärker (130) Eigenschaften, insbesondere eine Verstärkung und/oder eine Dämpfung des Verstärkers (130), mit einem jeweiligen Eigenschaftswerten aufweist, wobei die Zeitgebereinheit (400) dazu eingerichtet ist diese Eigenschaft des Verstärkers (130) in Abhängigkeit von dem zumindest einem erfassten jeweiligen Zeitgebereingangswert zu beeinflussen.

32. Vorrichtung gemäß Anspruch 31, **dadurch gekennzeichnet,**
**dass** der Eigenschaftswert der jeweiligen Eigenschaft des Verstärkers (130) über einem Verstärkereigenschaftsgrenzwert liegt, wenn Beträge der erfassten ADC-Eingangswerte unter einem vierten ADC-Eingangsschwellwert liegen, und
der Eigenschaftswert der jeweiligen Eigenschaft des Verstärkers (130) unter dem Verstärkereigenschaftsgrenzwert liegt, wenn Beträge der erfassten ADC-Eingangswerte über dem vierten ADC-Eingangsschwellwert liegen, oder
der Eigenschaftswert der jeweiligen Eigenschaft des Verstärkers (130) unter dem Verstärkereigenschaftsgrenzwert liegt, wenn Beträge der erfassten ADC-Eingangswerte unter dem vierten ADC-Eingangsschwellwert liegen, und
der Eigenschaftswert der jeweiligen Eigenschaft des Verstärkers (130) über dem Verstärkereigenschaftsgrenzwert liegt, wenn Beträge der erfassten ADC-Eingangswerte über dem vierten ADC-Eingangsschwellwert liegen.

33. Vorrichtung gemäß einem der Ansprüche 31 bis 32, **dadurch gekennzeichnet,**
**dass** der Eigenschaftswert der jeweiligen Eigenschaft des Verstärkers (130) über dem Verstärkereigenschaftsgrenzwert liegt, wenn Beträge der erfassten ADC-Ausgangswerte unter einem vierten ADC-Ausgangsschwellwert liegen, und
der Eigenschaftswert der jeweiligen Eigenschaft des Verstärkers (130) unter dem Verstärkereigenschaftsgrenzwert liegt, wenn Beträge der erfassten ADC-Ausgangswerte über dem vierten ADC-Ausgangsschwellwert liegen, oder
der Eigenschaftswert der jeweiligen Eigenschaft des Verstärkers (130) unter dem Verstärkereigenschaftsgrenzwert liegt, wenn Beträge der erfassten ADC-Ausgangswerte unter dem vierten ADC-Ausgangsschwellwert liegen, und
der Eigenschaftswert der jeweiligen Eigenschaft des Verstärkers (130) über dem Verstärkereigenschaftsgrenzwert, wenn Beträge der erfassten ADC-Ausgangswerte über dem vierten ADC-Ausgangsschwellwert liegen.

34. Vorrichtung gemäß einem der Ansprüche 31 bis 33, **dadurch gekennzeichnet,**
**dass** der Eigenschaftswert der jeweiligen Eigenschaft des Verstärkers (130) über dem Verstärkereigenschaftsgrenzwert liegt, wenn Beträge der erfassten Dezimationsfilter-Eingangswerte unter einem vierten Dezimationsfilter-Eingangsschwellwert liegen, und der Eigenschaftswert der jeweiligen Eigenschaft des Verstärkers (130) unter dem Verstärkereigenschaftsgrenzwert liegt, wenn Beträge der erfassten Dezimationsfilter-Eingangswerte über dem vierten Dezimationsfilter-Eingangsschwellwert liegen, oder der Eigenschaftswert der jeweiligen Eigenschaft des Verstärkers (130) unter dem Verstärkereigenschaftsgrenzwert liegt, wenn Beträge der erfassten Dezimationsfilter-Eingangswerte unter dem vierten Dezimationsfilter-Eingangsschwellwert liegen, und der Eigenschaftswert der jeweiligen Eigenschaft des Verstärkers (130) über dem Verstärkereigenschaftsgrenzwert liegt, wenn Beträge der erfassten Dezimationsfilter-Eingangswerte über dem vierten Dezimationsfilter-Eingangsschwellwert liegen.

35. Vorrichtung gemäß einem der Ansprüche 31 bis 34, **dadurch gekennzeichnet,**
**dass** der Eigenschaftswert der jeweiligen Eigenschaft des Verstärkers (130) unter dem Verstärkereigenschaftsgrenzwert liegt, wenn Beträge der erfassten Dezimationsfilter-Ausgangswerte unter einem vierten Dezimationsfilter-Ausgangsschwellwert liegen, und der Eigenschaftswert der jeweiligen Eigenschaft des Verstärkers (130) über dem Verstärkereigenschaftsgrenzwert liegt, wenn Beträge der erfassten Dezimationsfilter-Ausgangswerte über dem vierten Dezimationsfilter-Ausgangsschwellwert liegen, oder der Eigenschaftswert der jeweiligen Eigenschaft des Verstärkers (130) über dem Verstärkereigenschaftsgrenzwert liegt, wenn Beträge der erfassten Dezimationsfilter-Ausgangswerte unter dem vierten Dezimationsfilter-Ausgangsschwellwert liegen, und der Eigenschaftswert der jeweiligen Eigenschaft des Verstärkers (130) unter dem Verstärkereigenschaftsgrenzwert liegt, wenn Beträge der erfassten Dezimationsfilter-Ausgangswerte über dem vierten Dezimationsfilter-Ausgangsschwellwert liegen.

36. Vorrichtung zur Erfassung eines elektrischen Leitungsstromes (I_{LTG}) in einer Leitung, umfassend
- einen Shunt-Widerstand (113),
- einen Vorfilter (120),
- einen Verstärker (130),
- einen Analog-Digital-Wandler (200), und
- einen Überabtastungs- und Dezimations-Filter (300), wobei
der elektrische Leitungsstrom (I_{LTG}) durch den Shunt-Widerstand (113) fließt, und wobei über den Shunt-Widerstand (113) eine Shunt-Widerstandsspannung (U_{S}) abfällt, und wobei
der Vorfilter (120) dazu eingerichtet ist die Shunt-Widerstandsspannung (U_{S}) zu einer Verstärkereingangsspannung (Uₑ) vorzufiltern, und wobei
der Verstärker (130) dazu eingerichtet ist die Verstärkereingangsspannung (Uₑ) zu erfassen und zu einem Verstärkerausgangssignal (133) zu verstärken, und wobei
der Analog-Digital-Wandler (200) dazu eingerichtet ist das Verstärkerausgangssignal (133) mit einer Abtastrate abzutasten und zu einem Dezimationsfiltereingangssignal (301) zu wandeln, und wobei
der Überabtastungs- und Dezimations-Filter (300) dazu eingerichtet ist das Dezimationsfiltereingangssignal (301) zu einem Dezimationsfilterausgangssignal (302) zu filtern, und wobei
die Vorrichtung dazu eingerichtet ist das Dezimationsfilterausgangssignal (302) als Messwertsignal für zumindest einen Wert des elektrischen Leitungsstromes (I_{LTG}) in einer Leitung bereitzustellen,
**dadurch gekennzeichnet, dass**
der Vorfilter (120) dazu eingerichtet ist die Shunt-Widerstandsspannung (U_{S}) zu der Verstärkereingangsspannung (Uₑ) in Abhängigkeit von einem Wert des Verstärkerausgangssignals (133) als Zeitgebereingangswert zu filtern, und/oder
dass der Vorfilter (20) dazu eingerichtet ist die Shunt-Widerstandsspannung (U_{S}) zu der Verstärkereingangsspannung (Uₑ) in Abhängigkeit von einem Wert des Dezimationsfiltereingangssignals (301) als Zeitgebereingangswert zu filtern, und/oder
dass der Vorfilter (120) dazu eingerichtet ist die Shunt-Widerstandsspannung (U_{S}) zu der Verstärkereingangsspannung (Uₑ) in Abhängigkeit von einem Wert des Dezimationsfilterausgangssignals (302) als Zeitgebereingangswert zu filtern, und/oder
dass der Verstärker (130) dazu eingerichtet ist die Verstärkereingangsspannung (Uₑ) zu dem Verstärkerausgangssignal (133) in Abhängigkeit von dem Wert des Verstärkerausgangssignals (133) als Zeitgebereingangswert zu erfassen und zu verstärken, und/oder
dass der Verstärker (130) dazu eingerichtet ist die Verstärkereingangsspannung (Uₑ) zu dem Verstärkerausgangssignal (133) in Abhängigkeit von dem Wert des Dezimationsfiltereingangssignals (301) als Zeitgebereingangswert zu erfassen und zu verstärken, und/oder
dass der Verstärker (130) dazu eingerichtet ist die Verstärkereingangsspannung (Uₑ) zu dem Verstärkerausgangssignal (133) in Abhängigkeit von dem Wert des Dezimationsfilterausgangssignals (302) als Zeitgebereingangswert zu erfassen und zu verstärk, und/oder
dass der Analog-Digital-Wandler (200) dazu eingerichtet ist das Verstärkerausgangssignal (133) mit der Abtastrate zu dem Dezimationsfiltereingangssignal (301) in Abhängigkeit von dem Wert des Verstärkerausgangssignals (133) als Zeitgebereingangswert abzutasten, und/oder
dass der Analog-Digital-Wandler (200) dazu eingerichtet ist das Verstärkerausgangssignal (133) mit der Abtastrate zu dem Dezimationsfiltereingangssignal (301) in Abhängigkeit von dem Wert des Dezimationsfiltereingangssignals (301) als Zeitgebereingangswert abzutasten, und/oder
dass der Analog-Digital-Wandler (200) dazu eingerichtet ist das Verstärkerausgangssignal (133) mit der Abtastrate zu dem Dezimationsfiltereingangssignal (301) in Abhängigkeit von dem Wert des Dezimationsfilterausgangssignals (302) als Zeitgebereingangswert abzutasten, und/oder
dass der Überabtastungs- und Dezimations-Filter (300) dazu eingerichtet ist das Dezimationsfiltereingangssignal (301) zu dem Dezimationsfilterausgangssignal (302) in Abhängigkeit von dem Wert des Verstärkerausgangssignals (133) als Zeitgebereingangswert zu filtern, und/oder
dass der Überabtastungs- und Dezimations-Filter (300) dazu eingerichtet ist das Dezimationsfiltereingangssignal (301) zu dem Dezimationsfilterausgangssignal (302) in Abhängigkeit von dem Wert des Dezimationsfiltereingangssignals (301) als Zeitgebereingangswert zu filtern, und/oder
dass der Überabtastungs- und Dezimations-Filter (300) dazu eingerichtet ist das Dezimationsfiltereingangssignal (301) zu dem Dezimationsfilterausgangssignal (302) in Abhängigkeit von dem Wert des Dezimationsfilterausgangssignals (302) als Zeitgebereingangswert zu filtern.

37. Vorrichtung gemäß Anspruch 36, **dadurch gekennzeichnet,**
**dass** eine Filtereigenschaft des Vorfilters (120), insbesondere eine Vorfiltergrenzfrequenz (f_{oV}), von dem Zeitgebereingangswert abhängt.

38. Vorrichtung gemäß Anspruch 36, **dadurch gekennzeichnet,**
**dass** eine Eigenschaft des Verstärkers (130), insbesondere eine Verstärkung oder eine Dämpfung, von dem Zeitgebereingangswert abhängt.

39. Vorrichtung gemäß Anspruch 36, **dadurch gekennzeichnet,**
**dass** eine Eigenschaft des Analog-Digital-Wandlers (200), insbesondere ein Abtastzeitpunkt und/oder die Abtastperiode, von dem Zeitgebereingangswert abhängt.

40. Vorrichtung gemäß Anspruch 36, **dadurch gekennzeichnet,**
**dass** eine Eigenschaft des Überabtastungs- und Dezimations-Filters (300), insbesondere eine Filtergrenzfrequenz (fₒ), von dem Zeitgebereingangswert abhängt.

41. Vorrichtung gemäß Anspruch 37, **dadurch gekennzeichnet,**
**dass** die Vorfiltergrenzfrequenz (f_{oV}) über einem Vorfiltergrenzwert liegt, wenn Beträge von Zeitgebereingangswerten unter einem ersten Eingangsschwellwert liegen, und
die Vorfiltergrenzfrequenz (f_{oV}) unter dem Vorfiltergrenzwert liegt, wenn Beträge von Zeitgebereingangswerten über dem ersten Eingangsschwellwert liegen, oder
die Vorfiltergrenzfrequenz (f_{oV}) unter dem Vorfiltergrenzwert liegt, wenn Beträge von Zeitgebereingangswerten unter dem ersten Eingangsschwellwert liegen, und
die Vorfiltergrenzfrequenz (f_{oV}) über dem Vorfiltergrenzwert liegt, wenn Beträge von Zeitgebereingangswerten über dem ersten Eingangsschwellwert liegen.

42. Vorrichtung gemäß Anspruch 38, **dadurch gekennzeichnet,**
**dass** ein Betrag der Verstärkung über einem Verstärkungsgrenzwert liegt, wenn Beträge von Zeitgebereingangswerten unter einem zweiten Eingangsschwellwert liegen, und
der Betrag der Verstärkung unter dem Verstärkungsgrenzwert liegt, wenn Beträge von Zeitgebereingangswerten über dem zweiten Eingangsschwellwert liegen, oder
der Betrag der Verstärkung unter dem Verstärkungsgrenzwert liegt, wenn Beträge von Zeitgebereingangswerten unter dem zweiten Eingangsschwellwert liegen, und
der Betrag der Verstärkung über dem Verstärkungsgrenzwert liegt, wenn Beträge von Zeitgebereingangswerten über dem zweiten Eingangsschwellwert liegen.

43. Vorrichtung gemäß Anspruch 39, **dadurch gekennzeichnet,**
**dass** die Abtastperiode über einem Abtastperiodengrenzwert liegt, wenn Beträge von Zeitgebereingangswerten unter einem dritten Eingangsschwellwert liegen, und
die Abtastperiode unter dem Abtastperiodengrenzwert liegt, wenn Beträge von Zeitgebereingangswerten über dem dritten Eingangsschwellwert liegen, oder
die Abtastperiode unter dem Abtastperiodengrenzwert liegt, wenn Beträge von Zeitgebereingangswerten unter dem dritten Eingangsschwellwert liegen, und
die Abtastperiode über dem Abtastperiodengrenzwert liegt, wenn Beträge von Zeitgebereingangswerten über dem dritten Eingangsschwellwert liegen.

44. Vorrichtung gemäß Anspruch 40, **dadurch gekennzeichnet,**
**dass** ein Betrag der Filtergrenzfrequenz (fₒ) über einem Filtergrenzfrequenzgrenzwert liegt, wenn Beträge von Zeitgebereingangswerten unter einem vierten Eingangsschwellwert liegen, und
der Betrag der Filtergrenzfrequenz (fₒ) unter dem Filtergrenzfrequenzgrenzwert liegt, wenn Beträge von Zeitgebereingangswerten über dem vierten Eingangsschwellwert liegen, oder
der Betrag der Filtergrenzfrequenz (fₒ) unter dem Filtergrenzfrequenzgrenzwert liegt, wenn Beträge von Zeitgebereingangswerten unter einem vierten Eingangsschwellwert liegen, und der Betrag der Filtergrenzfrequenz (fₒ) über dem Filtergrenzfrequenzgrenzwert liegt, wenn Beträge von Zeitgebereingangswerten über dem vierten Eingangsschwellwert liegen.

45. Vorrichtung zur Erfassung eines elektrischen Leitungsstromes (I_{LTG}) in einer Leitung, umfassend
- eine erste Schaltungseinheit (100),
- einen Analog-Digital-Wandler (200), und
- einen Überabtastungs- und Dezimations-Filter (300), wobei
der elektrische Leitungsstrom durch die erste Schaltungseinheit (100) fliest, und wobei die erste Schaltungseinheit (100) dazu eingerichtet ist den zeitlichen Verlauf des Werts des elektrischen Leitungsstromes (I_{LTG}) in der Leitung zu erfassen und zu einem Verstärkerausgangssignal (133) zu wandeln, und wobei
der Analog-Digital-Wandler (200) dazu eingerichtet ist das Verstärkerausgangssignal (133) mit einer Abtastrate abzutasten und zu einem Dezimationsfiltereingangssignal (301) zu wandeln, und wobei
der Überabtastungs- und Dezimations-Filter (300) dazu eingerichtet ist das Dezimationsfiltereingangssignal (301) zu einem Dezimationsfilterausgangssignal (302) zu filtern, und wobei
die Vorrichtung dazu eingerichtet ist das Dezimationsfilterausgangssignal (302) als Messwertsignal für zumindest einen Wert des elektrischen Leitungsstromes (I_{LTG}) in einer Leitung bereitzustellen,
**dadurch gekennzeichnet, dass**
der Analog-zu-Digital-Wandler (200) dazu eingerichtet ist das Verstärkerausgangssignal (133) mit der Abtastrate zu dem Dezimationsfiltereingangssignal (301) in Abhängigkeit von einem Wert des Verstärkerausgangssignals (133) als Zeitgebereingangswert abzutasten, und/oder dass der Analog-Digital-Wandler (200) dazu eingerichtet ist das Verstärkerausgangssignal (133) mit der Abtastrate zu dem Dezimationsfiltereingangssignal (301) in Abhängigkeit von einem Wert des Dezimationsfiltereingangssignals (301) als Zeitgebereingangswert abzutasten, und/oder
dass der Analog-zu-Digital-Wandler (200) dazu eingerichtet ist das Verstärkerausgangssignal (133) mit einer Abtastrate zu dem Dezimationsfiltereingangssignal (301) in Abhängigkeit von einem Wert des Dezimationsfilterausgangssignals (302) als Zeitgebereingangswert abzutasten, und/oder
dass der Überabtastungs- und Dezimations-Filter (300) dazu eingerichtet ist das Dezimationsfiltereingangssignal (301) zu dem Dezimationsfilterausgangssignal (302) in Abhängigkeit von dem Wert des Verstärkerausgangssignals (133) als Zeitgebereingangswert zu filtern, und/oder
dass der Überabtastungs- und Dezimations-Filter (300) dazu eingerichtet ist das Dezimationsfiltereingangssignal (301) zu dem Dezimationsfilterausgangssignal (302) in Abhängigkeit von dem Wert des Dezimationsfiltereingangssignals (301) als Zeitgebereingangswert zu filtern, und/oder
dass der Überabtastungs- und Dezimations-Filter (300) dazu eingerichtet ist das Dezimationsfiltereingangssignal (301) zu dem Dezimationsfilterausgangssignal (302) in Abhängigkeit von dem Wert des Dezimationsfilterausgangssignals (302) als Zeitgebereingangswert zu filtern.

46. Vorrichtung gemäß Anspruch 45, **dadurch gekennzeichnet,**
**dass** die erste Schaltungseinheit (100) umfasst
- einen Shunt-Widerstand (113)
- einen Vorfilter (120), und
- einen Verstärker (130), wobei
der elektrische Leitungsstrom (I_{LTG}) durch den Shunt-Widerstand (113) fließt, und wobei über den Shunt-Widerstand (113) eine Shunt-Widerstandsspannung (U_{S}) abfällt, wobei der Vorfilter (120) dazu eingerichtet ist die Shunt-Widerstandsspannung (U_{S}) zu einer Verstärkereingangsspannung (Uₑ) vorzufiltern, und wobei
der Verstärker (130) dazu eingerichtet ist die Verstärkereingangsspannung (Uₑ) zu erfassen und zu dem Verstärkerausgangssignal (133) zu verstärken.

47. Vorrichtung gemäß einem der Ansprüche 45 bis 46, **dadurch gekennzeichnet,**
**dass** eine Eigenschaft des Analog-Digital-Wandlers (200), insbesondere ein Abtastzeitpunkt und/oder die Abtastperiode, von dem Zeitgebereingangswert abhängt.

48. Vorrichtung gemäß einem der Ansprüche 45 bis 46, **dadurch gekennzeichnet,**
**dass** eine Eigenschaft des Überabtastungs- und Dezimations-Filters (300), insbesondere eine Filtergrenzfrequenz (fₒ), von dem Zeitgebereingangswert abhängt.

49. Vorrichtung gemäß Anspruch 47, **dadurch gekennzeichnet,**
**dass** die Abtastperiode über einem Abtastperiodengrenzwert liegt, wenn Beträge von Zeitgebereingangswerten unter einem dritten Eingangsschwellwert liegen, und
die Abtastperiode unter dem Abtastperiodengrenzwert liegt, wenn Beträge von Zeitgebereingangswerten über dem dritten Eingangsschwellwert liegen, oder
die Abtastperiode unter dem Abtastperiodengrenzwert liegt, wenn Beträge von Zeitgebereingangswerten unter dem dritten Eingangsschwellwert liegen, und
die Abtastperiode über dem Abtastperiodengrenzwert liegt, wenn Beträge von Zeitgebereingangswerten über dem dritten Eingangsschwellwert liegen.

50. Vorrichtung gemäß Anspruch 48, **dadurch gekennzeichnet,**
**dass** ein Betrag der Filtergrenzfrequenz (fₒ) über einem Filtergrenzfrequenzgrenzwert liegt, wenn Beträge von Zeitgebereingangswerten unter einem vierten Eingangsschwellwert liegen, und
der Betrag der Filtergrenzfrequenz (fₒ) unter dem Filtergrenzfrequenzgrenzwert liegt, wenn Beträge von Zeitgebereingangswerten über dem vierten Eingangsschwellwert liegen, oder
der Betrag der Filtergrenzfrequenz (fₒ) unter dem Filtergrenzfrequenzgrenzwert liegt, wenn Beträge von Zeitgebereingangswerten unter einem vierten Eingangsschwellwert liegen, und der Betrag der Filtergrenzfrequenz (fₒ) über dem Filtergrenzfrequenzgrenzwert liegt, wenn Beträge von Zeitgebereingangswerten über dem vierten Eingangsschwellwert liegen.

51. Verfahren zur Erfassung eines elektrischen Leitungsstromes (I_{LTG}) in einer Leitung mittels einer Vorrichtung gemäß einer der vorstehenden Ansprüche, wobei der elektrische Leitungsstrom (I_{LTG}) durch einen Shunt-Widerstand (113) fließt und über den Shunt-Widerstand (113) eine Shunt-Widerstandsspannung (U_{S}) abfällt, wobei
das Verfahren folgende Schritte umfasst:
- Vorfiltern der Shunt-Widerstandsspannung (U_{S}) zu einer Verstärkereingangsspannung (Uₑ);
- Erfassen und Verstärken der Verstärkereingangsspannung (Uₑ) zu einem Verstärkerausgangssignal (133);
- Abtasten des Verstärkerausgangssignals (133) mit einer Abtastrate zu einem Dezimationsfiltereingangssignal (301);
- Filtern des Dezimationsfiltereingangssignals (301) zu einem Dezimationsfilterausgangssignal (302);
- Bereitstellen des Dezimationsfilterausgangssignals (302) als Messwertsignal für zumindest einen Wert des elektrischen Leitungsstromes (I_{LTG}) in einer Leitung,
**gekennzeichnet dadurch,**
**dass** das Vorfiltern der Shunt-Widerstandsspannung (U_{S}) zu der Verstärkereingangsspannung (Uₑ) und/oder
das Erfassen und Verstärken der Verstärkereingangsspannung (Uₑ) zu dem Verstärkerausgangssignal (133), und/oder
das Abtasten des Verstärkerausgangssignals (133) mit der Abtastrate zu dem Dezimationsfiltereingangssignal (301), und/oder
das Filtern des Dezimationsfiltereingangssignals (301) zu dem Dezimationsfilterausgangssignal (302)
- von einem Wert des Verstärkerausgangssignals (133) als Zeitgebereingangswert abhängt, und/oder
- von einem Wert des Dezimationsfiltereingangssignals (301) als Zeitgebereingangswert abhängt, und/oder
- von einem Wert des Dezimationsfilterausgangssignals (302) als Zeitgebereingangswert abhängt.

52. Verfahren gemäß Anspruch 51, **dadurch gekennzeichnet,**
**dass** eine Filtereigenschaft des Vorfilterns der Shunt-Widerstandsspannung (U_{S}) zu der Verstärkereingangsspannung (Uₑ), insbesondere eine Vorfiltergrenzfrequenz (f_{oV}), von dem Zeitgebereingangswert abhängt.

53. Verfahren gemäß Anspruch 51, **dadurch gekennzeichnet,**
**dass** eine Eigenschaft des Erfassens und Verstärken der Verstärkereingangsspannung (Uₑ) zu dem Verstärkerausgangssignal (133), insbesondere eine Verstärkung oder eine Dämpfung, von dem Zeitgebereingangswert abhängt.

54. Verfahren gemäß Anspruch 51, **dadurch gekennzeichnet,**
**dass** eine Eigenschaft des Abtastens des Verstärkerausgangssignals (133) zu dem Dezimationsfiltereingangssignal (301), insbesondere ein Abtastzeitpunkt und/oder eine mit einer Abtastperiode, von dem Zeitgebereingangswert abhängt.

55. Verfahren gemäß Anspruch 51, **dadurch gekennzeichnet,**
**dass** eine Eigenschaft des Filterns des Dezimationsfiltereingangssignals (301) zu dem Dezimationsfilterausgangssignal (302), insbesondere eine Filtergrenzfrequenz (fₒ), von dem Zeitgebereingangswert abhängt.

56. Verfahren gemäß Anspruch 52, **dadurch gekennzeichnet,**
**dass** die Vorfiltergrenzfrequenz (f_{oV}) über einem Vorfiltergrenzwert liegt, wenn Beträge von Zeitgebereingangswerten unter einem ersten Eingangsschwellwert liegen, und
die Vorfiltergrenzfrequenz (f_{oV}) unter dem Vorfiltergrenzwert liegt, wenn Beträge von Zeitgebereingangswerten über dem ersten Eingangsschwellwert liegen, oder
die Vorfiltergrenzfrequenz (f_{oV}) unter dem Vorfiltergrenzwert liegt, wenn Beträge von Zeitgebereingangswerten unter dem ersten Eingangsschwellwert liegen, und
die Vorfiltergrenzfrequenz (f_{oV}) über dem Vorfiltergrenzwert liegt, wenn Beträge von Zeitgebereingangswerten über dem ersten Eingangsschwellwert liegen.

57. Verfahren gemäß Anspruch 53, **dadurch gekennzeichnet,**
**dass** ein Betrag der Verstärkung über einem Verstärkungsgrenzwert liegt, wenn Beträge von Zeitgebereingangswerten unter einem zweiten Eingangsschwellwert liegen, und
der Betrag der Verstärkung unter dem Verstärkungsgrenzwert liegt, wenn Beträge von Zeitgebereingangswerten über dem zweiten Eingangsschwellwert liegen, oder
der Betrag der Verstärkung unter dem Verstärkungsgrenzwert liegt, wenn Beträge von Zeitgebereingangswerten unter dem zweiten Eingangsschwellwert liegen, und
der Betrag der Verstärkung über dem Verstärkungsgrenzwert liegt, wenn Beträge von Zeitgebereingangswerten über dem zweiten Eingangsschwellwert liegen.

58. Verfahren gemäß Anspruch 54, **dadurch gekennzeichnet,**
**dass** die Abtastperiode über einem Abtastperiodengrenzwert liegt, wenn Beträge von Zeitgebereingangswerten unter einem dritten Eingangsschwellwert liegen, und
die Abtastperiode unter dem Abtastperiodengrenzwert liegt, wenn Beträge von Zeitgebereingangswerten über dem dritten Eingangsschwellwert liegen, oder
die Abtastperiode unter dem Abtastperiodengrenzwert liegt, wenn Beträge von Zeitgebereingangswerten unter dem dritten Eingangsschwellwert liegen, und
die Abtastperiode über dem Abtastperiodengrenzwert liegt, wenn Beträge von Zeitgebereingangswerten über dem dritten Eingangsschwellwert liegen.

59. Verfahren gemäß Anspruch 55, **dadurch gekennzeichnet,**
**dass** ein Betrag der Filtergrenzfrequenz (fₒ) über einem Filtergrenzfrequenzgrenzwert liegt, wenn Beträge von Zeitgebereingangswerten unter einem vierten Eingangsschwellwert liegen, und
der Betrag der Filtergrenzfrequenz (fₒ) unter dem Filtergrenzfrequenzgrenzwert liegt, wenn Beträge von Zeitgebereingangswerten über dem vierten Eingangsschwellwert liegen, oder
der Betrag der Filtergrenzfrequenz (fₒ) unter dem Filtergrenzfrequenzgrenzwert liegt, wenn Beträge von Zeitgebereingangswerten unter dem vierten Eingangsschwellwert liegen, und
der Betrag der Filtergrenzfrequenz (fₒ) über dem Filtergrenzfrequenzgrenzwert liegt, wenn Beträge von Zeitgebereingangswerten über dem vierten Eingangsschwellwert liegen.

## Claims

1. Device for detecting an electrical line current (I_{LTG} ) in a line, wherein the electrical line current (I_{LTG} ) flows from a first node (101) of the device to a third node (103) of the device, wherein
the device comprises
- a prefilter (120)
- an amplifier (130), wherein the amplifier (130) has a first amplifier input (131), a second amplifier input (132) and an amplifier output (133),
- an analog-to-digital converter (200), the analog-to-digital converter (200) having an input and an output, and
- an oversampling and decimation filter (300), the oversampling and decimation filter (300) having an input and an output, wherein
the analog-to-digital converter (200) is designed to sample an analog value of an analog input signal (201) of the analog-to-digital converter (200) at sampling times, and wherein
the analog-to-digital converter (200) is designed to convert the analog value of the analog input signal (201) of the analog-to-digital converter (200) into a digital value at these sampling times, and wherein
the analog-to-digital converter (200) is designed to signal this digital value via a digital output signal (202) of the digital-to-analog converter (200) to the input of the oversampling and decimation filter (300), and wherein
a plurality of output values of a decimation filter output signal (302) represent, at least temporarily, the current values for the line current (I_{LTG}) detected by the device,
**characterized in that**
the device comprises a timer unit (400), wherein
the timer unit (400) is designed to detect at least one timer input value signal (401) with at least one respective timer input value, and wherein
the timer unit (400) is designed to at least temporarily influence at least one signal transmission property of the prefilter (120) and/or the amplifier (130) and/or the analog-to-digital converter (200) and/or the oversampling and decimation filter (300) in dependence on the at least one detected respective timer input value at least temporarily.

2. Device according to claim 1, **characterized in that**
the at least one signal transmission characteristic influenced by the timer unit (400) as a function of the at least one detected respective timer input value is at least one sampling time and/or at least one filter characteristic and/or at least one amplifier characteristic.

3. Device according to one of claims 1 to 2, **characterized in that**
the at least one signal transmission property influenced by the timing unit (400) as a function of the at least one detected respective timing input value is at least one filter frequency and/or at least one attenuation and/or at least one amplification of the prefilter (120) and/or the oversampling and decimation filter (300).

4. Device according to one of the preceding claims, **characterized in that**
that the at least one clock input value signal (401) corresponds to the analog input signal (201) of the analog-to-digital converter (200), wherein
the at least one respective timer input value is an ADC input value of the analog input signal (201) of the analog-to-digital converter (200).

5. Device according to claim 4, **characterized in that**
the timer unit (400) is designed to at least temporarily detect values of the analog input signal (201) of the analog-to-digital converter (200) in the form of detected ADC input values as timer input values, and
wherein the timer unit (400) is designed to influence sampling times as a function of the detected ADC input values.

6. Device according to one of claims 4 to 5, **characterized in that**
that the timer unit (400) is designed to at least temporarily detect values of the analog input signal (201) of the analog-to-digital converter (200) in the form of detected ADC input values as timer input values, wherein
the timer unit (400) is designed to influence at least one property of the prefilter (120) and/or the amplifier (130) and/or the oversampling and decimation filter (300) as a function of the detected ADC input values, wherein
the property influenced by the timer unit (400) is, in particular, at least one filter frequency and/or at least one gain and/or at least one attenuation of the prefilter (120) and/or the oversampling and decimation filter (300) , and/or
the property influenced by the timer unit (400) is, in particular, at least one gain and/or at least one attenuation of the amplifier (130).

7. Device according to one of the preceding claims, **characterized in that**
that the timer input value signal (401) corresponds to the digital output signal (202) of the analog-to-digital converter (200), wherein
the at least one respective timer input value is an ADC output value of the digital output signal (202) of the analog-to-digital converter (200).

8. Device according to claim 7, **characterized in that**
the timer unit (400) is designed to at least temporarily detect values of the output signal (202) of the analog-to-digital converter (200) in the form of detected ADC output values as timer input values, wherein
the timer unit (400) is designed to influence sampling times as a function of the detected ADC output values of the digital output signal (202).

9. Device according to one of claims 7 to 8, **characterized in that**
the timer unit (400) is designed to at least temporarily detect values of the digital output signal (202) of the analog-to-digital converter (200) in the form of detected ADC output values as timer input values, wherein
the timer unit (400) is designed to influence at least one property of the prefilter (120) and/or the amplifier (130) and/or the oversampling and decimation filter (300) depending on these detected ADC output values, wherein
the property influenced by the timer unit (400) is, in particular, at least one filter frequency, and/or at least one gain, and/or at least one attenuation of the prefilter (120) and/or the oversampling and decimation filter (300), and/or
the property influenced by the timer unit (400) is, in particular, at least one gain and/or at least one attenuation of the amplifier (130).

10. Device according to one of the preceding claims, **characterized in that**
that the timer input value signal (401) corresponds to a decimation filter input signal (301) of the oversampling and decimation filter (300), wherein
the at least one respective clock input value is a decimation filter input value of the oversampling and decimation filter (300).

11. Device according to claim 10, **characterized in that**
that the timer unit (400) is designed to at least temporarily detect values of the decimation filter input signal (301) in the form of detected decimation filter input values as timer input values of the timer input value signal (401), wherein the timer unit (400) is designed to influence sampling times as a function of detected decimation filter input values.

12. Device according to one of claims 10 to 11, **characterized in that**
that the timer unit (400) is designed to at least temporarily detect values of the decimation filter input signal (301) in the form of detected decimation filter input values as timer input values of the timer input value signal (401), wherein
the timer unit (400) is designed to influence at least one property of the prefilter (120) and/or the amplifier (130) and/or the oversampling and decimation filter (300) as a function of detected decimation filter input values, wherein
the property influenced by the timer unit (400) is, in particular, at least one filter frequency, and/or at least one gain, and/or at least one attenuation of the prefilter (120) and/or the oversampling and decimation filter (300), and/or
the property influenced by the timer unit (400) is, in particular, at least one gain and/or at least one attenuation of the amplifier (130).

13. Device according to one of the preceding claims, **characterized in that**
that the timer input value signal (401) corresponds to the decimation filter output signal (302) of the oversampling and decimation filter (300), wherein
the at least one respective time base input value is a decimation filter output value of the decimation filter output signal (302).

14. Device according to claim 13, **characterized in that**
the timer unit (400) is designed to at least temporarily detect values of the decimation filter output signal (302) in the form of detected decimation filter output values as timer input values of the timer input value signal (401), wherein
the timer unit (400) is designed to influence sampling times as a function of detected decimation filter output values.

15. Device according to one of claims 13 to 14, **characterized in that**
the timer unit (400) is designed to at least temporarily detect values of the decimation filter output signal (302) in the form of detected decimation filter output values as timer input values of a timer input value signal (401), wherein
the timer unit (400) is designed to influence at least one property of the prefilter (120) and/or the amplifier (130) and/or the oversampling and decimation filter (300) as a function of detected decimation filter output values, wherein
the property influenced by the timer unit (400) is, in particular, at least one filter frequency and/or at least one gain and/or at least one attenuation of the prefilter (120) and/or the oversampling and decimation filter (300), and/or
the property influenced by the timer unit (400) is, in particular, at least one gain and/or at least one attenuation of the amplifier (130).

16. Device according to one of the preceding claims, **characterized in that**
that a sampling period of a time between a first sampling time of the sampling of the analog value of the analog input signal (201) of the analog-to-digital converter (200) by the analog-to-digital converter (200) and an immediately subsequent second sampling time of the sampling of the analog value of the analog input signal (201) of the analog-to-digital converter (200) by the analog-to-digital converter (200), wherein
the timer unit (400) is designed to influence the sampling period of the analog-to-digital converter (200) depending on the at least one detected respective timer input value.

17. Device according to claim 16, **characterized in that**
that the sampling period is above a sampling period limit value when amounts of the detected ADC input values are below a first ADC input threshold value and wherein
the sampling period is below the sampling period limit value when amounts of the detected ADC input values are above the first ADC input threshold value.

18. Device according to one of claims 16 to 17, **characterized in that**
that the sampling period is above a sampling period limit value when amounts of the detected ADC output values are below a first ADC output threshold value, and
the sampling period is below the sampling period limit value when amounts of the detected ADC output values are above the first ADC output threshold value.

19. Device according to any one of claims 16 to 18, **characterized in that**
that the sampling period is above the sampling period limit value when amounts of the detected decimation filter input values are below a first decimation filter input threshold value, and
the sampling period is below the sampling period limit value when amounts of the detected decimation filter input values are above the first decimation filter input threshold value.

20. Device according to one of claims 16 to 19, **characterized in that**
that the sampling period is above a sampling period limit value when amounts of the detected decimation filter output values are below the first decimation filter output threshold value and
the sampling period is below the sampling period limit value when amounts of the detected decimation filter output values are above the first decimation filter output threshold value.

21. Device according to one of the preceding claims, **characterized in that**
that the oversampling and decimation filter (300) has an upper cut-off frequency (fₒ),
wherein
the oversampling and decimation filter (300) is designed to attenuate signal components with a signal component frequency above the upper cut-off frequency (fₒ) more strongly than signal components with a signal component frequency immediately below the upper cut-off frequency (fₒ) and wherein
the clock unit (400) is designed to influence the upper cut-off frequency (fₒ) of the oversampling and decimation filter (300) as a function of the at least one detected respective clock input value.

22. Device according to claim 21, **characterized in that**
the upper limit frequency (fₒ) of the oversampling and decimation filter (300) is above a decimation limit frequency limit value when amounts of the detected ADC input values are below a second ADC input threshold value, and
the upper cut-off frequency (fₒ) of the oversampling and decimation filter (300) is below the decimation cut-off frequency limit value when amounts of the detected ADC input values are above the second ADC input threshold value.

23. Device according to one of claims 21 to 22, **characterized in that**
the upper cut-off frequency (fₒ) of the oversampling and decimation filter (300) is above the decimation cut-off frequency limit value when amounts of the detected ADC output values are below a second ADC output threshold value, and
the upper cut-off frequency (fₒ) of the oversampling and decimation filter (300) is below the decimation cut-off frequency limit value when amounts of the detected ADC output values are above the second ADC output threshold value.

24. Device according to one of claims 21 to 23, **characterized in that**
that the upper cut-off frequency (fₒ) of the oversampling and decimation filter (300) is above the decimation cut-off frequency limit value when amounts of the detected decimation filter input values are below a second decimation filter input threshold value, and
the upper cut-off frequency (fₒ) of the oversampling and decimation filter (300) is below the decimation cut-off frequency limit value when amounts of the detected decimation filter input values are above the second decimation filter input threshold value.

25. Device according to any one of claims 21 to 24, **characterized in that**
the upper cut-off frequency (fₒ) of the oversampling and decimation filter (300) is above the decimation cut-off frequency limit value when amounts of the detected decimation filter output values are below a second decimation filter output threshold value, and
the upper cut-off frequency (fₒ) of the oversampling and decimation filter (300) is above the decimation cut-off frequency limit value when amounts of the detected decimation filter output values are above the second decimation filter output threshold value.

26. Device according to one of the preceding claims, **characterized in that**
the prefilter (120) has an upper cut-off frequency (f_{oV}), wherein
the prefilter (120) is designed to attenuate signal components with a signal component frequency above the upper cut-off frequency (f_{oV}) more strongly than signal components with a signal component frequency immediately below the upper cut-off frequency (f_{oV}), and wherein
the timer unit (400) is designed to influence the upper cut-off frequency (f_{oV}) of the prefilter (120) depending on the at least one detected respective timer input value.

27. Device according to claim 26, **characterized in that**
that the upper limit frequency (f_{oV}) of the prefilter (120) is above a prefilter limit frequency limit value when amounts of the detected ADC input values are below a third ADC input threshold value, and the upper limit frequency (f_{oV}) of the prefilter (120) is below the prefilter cut-off frequency limit value when amounts of the detected ADC input values are above the third ADC input threshold value.

28. Device according to one of claims 26 to 27, **characterized in that**
that the upper cut-off frequency (f_{oV}) of the prefilter (120) is above the prefilter cut-off frequency limit value when amounts of the detected ADC output values are below the third ADC output threshold value, and the upper cut-off frequency (f_{oV}) of the prefilter (120) is below the prefilter cut-off frequency limit value when amounts of the detected ADC output values are above the third ADC output threshold value.

29. Device according to one of claims 26 to 28, **characterized in that**
that the upper cut-off frequency (f_{oV}) of the prefilter (120) is above the prefilter cut-off frequency limit value when amounts of the detected decimation filter input values are below the third decimation filter input threshold value, and the upper cut-off frequency (f_{oV}) of the prefilter (120) is below the prefilter cutoff frequency limit value when amounts of the detected decimation filter input values are above the third decimation filter input threshold value.

30. Device according to one of claims 26 to 29, **characterized in that**
that the upper limit frequency (f_{oV}) of the prefilter (120) is above the prefilter limit frequency limit value when amounts of the detected decimation filter output values are below the third decimation filter output threshold value, and the upper limit frequency (f_{oV}) of the prefilter (120) is above the prefilter cutoff frequency limit value when amounts of the detected decimation filter output values are above the third decimation filter output threshold value.

31. Device according to one of the preceding claims, **characterized in that**
the amplifier (130) has properties, in particular an amplification and/or an attenuation of the amplifier (130), with respective property values, wherein the time-giver unit (400) is designed to influence this property of the amplifier (130) as a function of the at least one detected respective time-giver input value.

32. Device according to claim 31, **characterized in that**
the characteristic value of the respective characteristic of the amplifier (130) is above an amplifier characteristic limit value when amounts of the detected ADC input values are below a fourth ADC input threshold value, and
the property value of the respective property of the amplifier (130) is below the amplifier property limit value when amounts of the detected ADC input values are above the fourth ADC input threshold value, or
the property value of the respective property of the amplifier (130) is below the amplifier property limit value when amounts of the detected ADC input values are below the fourth ADC input threshold value, and
the property value of the respective property of the amplifier (130) is above the amplifier property limit value when amounts of the detected ADC input values are above the fourth ADC input threshold value.

33. Device according to any one of claims 31 to 32, **characterized in that**
that the characteristic value of the respective characteristic of the amplifier (130) is above the amplifier characteristic limit value when amounts of the detected ADC output values are below a fourth ADC output threshold value, and
the characteristic value of the respective characteristic of the amplifier (130) is below the amplifier characteristic limit value when amounts of the detected ADC output values are above the fourth ADC output threshold value, or
the property value of the respective property of the amplifier (130) is below the amplifier property limit value when amounts of the detected ADC output values are below the fourth ADC output threshold value, and
the property value of the respective property of the amplifier (130) is above the amplifier property limit value when amounts of the detected ADC output values are above the fourth ADC output threshold value.

34. Device according to one of claims 31 to 33, **characterized in that**
that the property value of the respective property of the amplifier (130) is above the amplifier property limit value when amounts of the detected decimation filter input values are below a fourth decimation filter input threshold value, and
the property value of the respective property of the amplifier (130) is below the amplifier property limit value when amounts of the detected decimation filter input values are above the fourth decimation filter input threshold value, or
the property value of the respective property of the amplifier (130) is below the amplifier property limit value when amounts of the detected decimation filter input values are below the fourth decimation filter input threshold value, and
the property value of the respective property of the amplifier (130) is above the amplifier property limit value when amounts of the detected decimation filter input values are above the fourth decimation filter input threshold value.

35. Device according to any one of claims 31 to 34, **characterized in that**
that the property value of the respective property of the amplifier (130) is below the amplifier property limit value when amounts of the detected decimation filter output values are below a fourth decimation filter output threshold value, and
the characteristic value of the respective characteristic of the amplifier (130) is above the amplifier characteristic limit value when amounts of the detected decimation filter output values are above the fourth decimation filter output threshold value, or
the property value of the respective property of the amplifier (130) is above the amplifier property limit value if amounts of the detected decimation filter output values are below the fourth decimation filter output threshold value, and
the property value of the respective property of the amplifier (130) is below the amplifier property limit value when amounts of the detected decimation filter output values are above the fourth decimation filter output threshold value.

36. Device for detecting an electrical line current (I_{LTG}) in a line, comprising
- a shunt resistor (113),
- a prefilter (120),
- an amplifier (130),
- an analog-to-digital converter (200), and
- an oversampling and decimation filter (300), wherein
the electrical line current (I_{LTG}) flows through the shunt resistor (113), and wherein
a shunt resistance voltage (U_{S}) drops across the shunt resistance (113), and wherein the prefilter (120) is designed to prefilter the shunt resistance voltage (U_{S}) to an amplifier input voltage (Uₑ), and wherein
the amplifier (130) is designed to detect the amplifier input voltage (Uₑ) and amplify it to an amplifier output signal (133), and wherein
the analog-to-digital converter (200) is designed to sample the amplifier output signal (133) at a sampling rate and convert it into a decimation filter input signal (301), and wherein the oversampling and decimation filter (300) is designed to filter the decimation filter input signal (301) to produce a decimation filter output signal (302), and wherein
the device is designed to provide the decimation filter output signal (302) as a measured value signal for at least one value of the electrical line current (I_{LTG}) in a line,
**characterized in that**
the prefilter (120) is designed to filter the shunt resistance voltage (U_{S}) to the amplifier input voltage (Uₑ) as a function of a value of the amplifier output signal (133) as a time base input value, and/or
the prefilter (20) is designed to filter the shunt resistance voltage (U_{S}) to the amplifier input voltage (Uₑ) as a function of a value of the decimation filter input signal (301) as a timer input value, and/or
the prefilter (120) is designed to filter the shunt resistance voltage (U_{S}) to the amplifier input voltage (Uₑ) as a timer input value depending on a value of the decimation filter output signal (302), and/or
that the amplifier (130) is designed to detect and amplify the amplifier input voltage (Uₑ) to the amplifier output signal (133) as a function of the value of the amplifier output signal (133) as a timer input value, and/or
the amplifier (130) is designed to detect and amplify the amplifier input voltage (Uₑ) to the amplifier output signal (133) as a timer input value depending on the value of the decimation filter input signal (301), and/or
the amplifier (130) is designed to detect and amplify the amplifier input voltage (Uₑ) to the amplifier output signal (133) as a timer input value depending on the value of the decimation filter output signal (302), and/or
the analog-to-digital converter (200) is designed to sample the amplifier output signal (133) at the sampling rate with respect to the decimation filter input signal (301) as a clock input value depending on the value of the amplifier output signal (133), and/or
the analog-to-digital converter (200) is set up to sample the amplifier output signal (133) at the sampling rate to the decimation filter input signal (301) depending on the value of the decimation filter input signal (301) as a timer input value, and/or
that the analog-to-digital converter (200) is designed to sample the amplifier output signal (133) at the sampling rate to the decimation filter input signal (301) as a time clock input value depending on the value of the decimation filter output signal (302), and/or
that the oversampling and decimation filter (300) is designed to filter the decimation filter input signal (301) to the decimation filter output signal (302) as a clock input value depending on the value of the amplifier output signal (133), and/or
that the oversampling and decimation filter (300) is designed to filter the decimation filter input signal (301) to the decimation filter output signal (302) as a function of the value of the decimation filter input signal (301) as a timer input value, and/or
the oversampling and decimation filter (300) is designed to filter the decimation filter input signal (301) to the decimation filter output signal (302) as a time clock input value depending on the value of the decimation filter output signal (302).

37. Device according to claim 36, **characterized in that**
that a filter characteristic of the prefilter (120), in particular a prefilter cutoff frequency (f_{oV}), depends on the timer input value.

38. Device according to claim 36, **characterized in that**
that a property of the amplifier (130), in particular a gain or attenuation, depends on the timer input value.

39. Device according to claim 36, **characterized in that**
that a property of the analog-to-digital converter (200), in particular a sampling time point and/or the sampling period, depends on the timer input value.

40. Device according to claim 36, **characterized in that**
that a property of the oversampling and decimation filter (300), in particular a filter cutoff frequency (fₒ), depends on the timer input value.

41. Device according to claim 37, **characterized in that**
that the prefilter cut-off frequency (f_{oV}) is above a prefilter cut-off value when amounts of timer input values are below a first input threshold value, and
the prefilter limit frequency (f_{oV}) is below the prefilter limit value when amounts of timer input values are above the first input threshold value, or
the prefilter cutoff frequency (f_{oV}) is below the prefilter cutoff value when amounts of timer input values are below the first input threshold value, and
the prefilter limit frequency (f_{oV}) is above the prefilter limit value when amounts of timer input values are above the first input threshold value.

42. Device according to claim 38, **characterized in that**
that a gain amount is above a gain limit value when amounts of timer input values are below a second input threshold value, and
the amount of amplification is below the amplification limit value when amounts of timer input values are above the second input threshold value, or
the amount of amplification is below the amplification limit value when amounts of timer input values are below the second input threshold value, and
the amount of amplification is above the amplification limit value when amounts of timer input values are above the second input threshold value.

43. Device according to claim 39, **characterized in that**
that the sampling period is above a sampling period limit value when amounts of clock input values are below a third input threshold value, and
the sampling period is below the sampling period limit value when amounts of clock input values are above the third input threshold value, or
the sampling period is below the sampling period limit value when amounts of timer input values are below the third input threshold value, and
the sampling period is above the sampling period limit value when amounts of timer input values are above the third input threshold value.

44. Device according to claim 40, **characterized in that**
that an amount of the filter cutoff frequency (fₒ ) is above a filter cutoff frequency limit value when amounts of timer input values are below a fourth input threshold value, and
the amount of the filter cutoff frequency (fₒ ) is below the filter cutoff frequency limit value when amounts of timer input values are above the fourth input threshold value, or
the amount of the filter cutoff frequency (fₒ ) is below the filter cutoff frequency limit value when amounts of timer input values are below a fourth input threshold value, and
the amount of the filter cutoff frequency (fₒ ) is above the filter cutoff frequency limit value when amounts of timer input values are above the fourth input threshold value.

45. Device for detecting an electrical line current (I_{LTG}) in a line, comprising
- a first circuit unit (100),
- an analog-to-digital converter (200), and
- an oversampling and decimation filter (300), wherein
the electrical line current flows through the first circuit unit (100), and wherein
the first circuit unit (100) is designed to detect the temporal progression of the value of the electrical line current (I_{LTG} ) in the line and convert it into an amplifier output signal (133), and wherein
the analog-to-digital converter (200) is designed to sample the amplifier output signal (133) at a sampling rate and convert it into a decimation filter input signal (301), and wherein
the oversampling and decimation filter (300) is designed to filter the decimation filter input signal (301) to a decimation filter output signal (302), and wherein
the device is designed to provide the decimation filter output signal (302) as a measured value signal for at least one value of the electrical line current (I_{LTG}) in a line,
**characterized in that**
the analog-to-digital converter (200) is designed to sample the amplifier output signal (133) at the sampling rate to the decimation filter input signal (301) as a clock input value depending on a value of the amplifier output signal (133) that is , and/or
that the analog-to-digital converter (200) is designed to sample the amplifier output signal (133) at the sampling rate to the decimation filter input signal (301) as a function of a value of the decimation filter input signal (301) as a clock input value, and/or
the analog-to-digital converter (200) is set up to sample the amplifier output signal (133) at a sampling rate to the decimation filter input signal (301) depending on a value of the decimation filter output signal (302) as a clock input value, and/or
that the oversampling and decimation filter (300) is designed to filter the decimation filter input signal (301) to the decimation filter output signal (302) as a clock input value depending on the value of the amplifier output signal (133), and/or
that the oversampling and decimation filter (300) is designed to filter the decimation filter input signal (301) to the decimation filter output signal (302) as a function of the value of the decimation filter input signal (301) as a timer input value, and/or
the oversampling and decimation filter (300) is designed to filter the decimation filter input signal (301) to the decimation filter output signal (302) depending on the value of the decimation filter output signal (302) as a clock input value.

46. Device according to claim 45, **characterized in that**
the first circuit unit (100) comprises
- a shunt resistor (113)
- a prefilter (120), and
- an amplifier (130), wherein
the electrical line current (I_{LTG}) flows through the shunt resistor (113), and wherein
a shunt resistance voltage (U_{S}) drops across the shunt resistor (113), wherein
the prefilter (120) is designed to prefilter the shunt resistor voltage (U_{S}) to an amplifier input voltage (Uₑ), and wherein
the amplifier (130) is designed to detect the amplifier input voltage (Uₑ) and amplify it to the amplifier output signal (133).

47. Device according to one of claims 45 to 46, **characterized in that**
that a property of the analog-to-digital converter (200), in particular a sampling time and/or the sampling period, depends on the clock input value.

48. Device according to one of claims 45 to 46, **characterized in that**
that a property of the oversampling and decimation filter (300), in particular a filter cutoff frequency (fₒ), depends on the timer input value.

49. Device according to claim 47, **characterized in that**
that the sampling period is above a sampling period limit value when amounts of clock input values are below a third input threshold value, and
the sampling period is below the sampling period limit value when amounts of clock input values are above the third input threshold value, or
the sampling period is below the sampling period limit value when amounts of timer input values are below the third input threshold value, and
the sampling period is above the sampling period limit value when amounts of timer input values are above the third input threshold value.

50. Device according to claim 48, **characterized in that**
that an amount of the filter cutoff frequency (fₒ) is above a filter cutoff frequency limit value when amounts of clock input values are below a fourth input threshold value, and
the amount of the filter cutoff frequency (fₒ) is below the filter cutoff frequency limit value when amounts of timer input values are above the fourth input threshold value, or
the amount of the filter cutoff frequency (fₒ) is below the filter cutoff frequency limit value when amounts of timer input values are below a fourth input threshold value, and
the amount of the filter cutoff frequency (fₒ) is above the filter cutoff frequency limit value when amounts of timer input values are above the fourth input threshold value.

51. Method for detecting an electrical line current (I_{LTG}) in a line by means of a device according to one of the preceding claims, wherein the electrical line current (I_{LTG}) flows through a shunt resistor (113) and a shunt resistor voltage (U_{S}) drops across the shunt resistor (113), wherein the method comprises the following steps:
- pre-filtering the shunt resistance voltage (U_{S}) to an amplifier input voltage (Uₑ);
- detecting and amplifying the amplifier input voltage (Uₑ) to an amplifier output signal (133);
- sampling the amplifier output signal (133) at a sampling rate to form a decimation filter input signal (301);
- filtering the decimation filter input signal (301) to a decimation filter output signal (302);
- providing the decimation filter output signal (302) as a measured value signal for at least one value of the electrical line current (I_{LTG}) in a line,
**characterized in that**
that the prefiltering of the shunt resistance voltage (U_{S}) to the amplifier input voltage (Uₑ) and/or
the detection and amplification of the amplifier input voltage (Uₑ) to the amplifier output signal (133), and/or
sampling the amplifier output signal (133) at the sampling rate to the decimation filter input signal (301), and/or
filtering the decimation filter input signal (301) to the decimation filter output signal (302)
- depends on a value of the amplifier output signal (133) as a clock input value, and/or
- depends on a value of the decimation filter input signal (301) as a timer input value, and/or
- depends on a value of the decimation filter output signal (302) as a timer input value.

52. Method according to claim 51, **characterized in that**
that a filter characteristic of the prefiltering of the shunt resistance voltage (U_{S}) to the amplifier input voltage (Uₑ), in particular a prefilter cutoff frequency (f_{oV}), depends on the timer input value.

53. Method according to claim 51, **characterized in that**
that a property of detecting and amplifying the amplifier input voltage (Uₑ) to the amplifier output signal (133), in particular an amplification or an attenuation, depends on the timer input value.

54. Method according to claim 51, **characterized in that**
that a property of sampling the amplifier output signal (133) to the decimation filter input signal (301), in particular a sampling time and/or a sampling period, depends on the clock input value.

55. Method according to claim 51, **characterized in that**
that a property of the filtering of the decimation filter input signal (301) to the decimation filter output signal (302), in particular a filter cutoff frequency (fₒ), depends on the clock input value.

56. Method according to claim 52, **characterized in that**
that the prefilter cutoff frequency (f_{oV}) is above a prefilter cutoff value when amounts of clock input values are below a first input threshold value, and
the prefilter limit frequency (f_{oV}) is below the prefilter limit value when amounts of timer input values are above the first input threshold value, or
the prefilter limit frequency (f_{oV}) is below the prefilter limit value when amounts of timer input values are below the first input threshold value, and
the prefilter limit frequency (f_{oV}) is above the prefilter limit value when amounts of timer input values are above the first input threshold value.

57. Method according to claim 53, **characterized in that**
that an amount of the gain is above a gain limit value when amounts of timer input values are below a second input threshold value, and
the amount of gain is below the gain limit value when amounts of timer input values are above the second input threshold value, or
the amount of amplification is below the amplification limit value when amounts of timer input values are below the second input threshold value, and
the amount of gain is above the gain limit value when amounts of timer input values are above the second input threshold value.

58. Method according to claim 54, **characterized in that**
the sampling period is above a sampling period limit value when amounts of clock input values are below a third input threshold value, and
the sampling period is below the sampling period limit value when amounts of clock input values are above the third input threshold value, or
the sampling period is below the sampling period limit value when amounts of timer input values are below the third input threshold value, and
the sampling period is above the sampling period limit value when amounts of timer input values are above the third input threshold value.

59. Method according to claim 55, **characterized in that**
that an amount of the filter cutoff frequency (fₒ) is above a filter cutoff frequency limit value when amounts of timer input values are below a fourth input threshold value, and
the amount of the filter cutoff frequency (fₒ) is below the filter cutoff frequency limit value when amounts of timer input values are above the fourth input threshold value, or
the amount of the filter cutoff frequency (fₒ) is below the filter cutoff frequency limit value when amounts of timer input values are below the fourth input threshold value, and
the amount of the filter cutoff frequency (fₒ) is above the filter cutoff frequency limit value when amounts of timer input values are above the fourth input threshold value.

## Revendications

1. Dispositif pour détecter un courant électrique (I_{LTG}) dans une ligne, le courant électrique (I_{LTG}) circulant d'un premier noeud (101) du dispositif vers un troisième noeud (103) du dispositif, le dispositif comprenant
- un préfiltre (120)
- un amplificateur (130), l'amplificateur (130) présentant une première entrée d'amplificateur (131), une deuxième entrée d'amplificateur (132) et une sortie d'amplificateur (133),
- un convertisseur analogique-numérique (200), le convertisseur analogique-numérique (200) comportant une entrée et une sortie, et
- un filtre de suréchantillonnage et de décimation (300), le filtre de suréchantillonnage et de décimation (300) comportant une entrée et une sortie,
le convertisseur analogique-numérique (200) est conçu pour échantillonner une valeur analogique d'un signal d'entrée analogique (201) du convertisseur analogique-numérique (200) à des instants d'échantillonnage, et
le convertisseur analogique-numérique (200) est conçu pour convertir, à ces instants d'échantillonnage, la valeur analogique du signal d'entrée analogique (201) du convertisseur analogique-numérique (200) en une valeur numérique, et dans lequel
le convertisseur analogique-numérique (200) est conçu pour signaler cette valeur numérique à l'entrée du filtre de suréchantillonnage et de décimation (300) via un signal de sortie numérique (202) du convertisseur numérique-analogique (200), et dans lequel
une pluralité de valeurs de sortie d'un signal de sortie de filtre de décimation (302) représentent au moins temporairement les valeurs de courant pour le courant de ligne (I_{LTG}) détectées par le dispositif,
**caractérisé en ce que**
le dispositif comprend une unité de synchronisation (400),
l'unité de synchronisation (400) est conçue pour détecter au moins un signal de valeur d'entrée de synchronisation (401) avec au moins une valeur d'entrée de synchronisation respective, et dans lequel
l'unité de temporisation (400) est conçue pour influencer au moins une propriété de transmission de signal du préfiltre (120) et/ou de l'amplificateur (130) et/ou du convertisseur analogique-numérique (200) et/ou du filtre de suréchantillonnage et de décimation (300) en fonction de la au moins une valeur d'entrée de temporisation respective détectée, au moins temporairement.

2. Dispositif selon la revendication 1, **caractérisé en ce que**
que la ou les propriétés de transmission de signaux influencées par l'unité de synchronisation (400) en fonction de la ou des valeurs d'entrée de synchronisation respectives détectées sont au moins un moment d'échantillonnage et/ou au moins une propriété de filtre et/ou au moins une propriété d'amplificateur.

3. Dispositif selon l'une des revendications 1 à 2, **caractérisé en ce que**
que la ou les propriétés de transmission du signal influencées par l'unité de synchronisation (400) en fonction de la ou des valeurs d'entrée de synchronisation respectives détectées sont au moins une fréquence de filtrage et/ou au moins une atténuation et/ou au moins une amplification du préfiltre (120) et/ou du filtre de suréchantillonnage et de décimation (300).

4. Dispositif selon l'une des revendications précédentes, **caractérisé en ce que**
**en ce que** le au moins un signal de valeur d'entrée de temporisation (401) correspond au signal d'entrée analogique (201) du convertisseur analogique-numérique (200),
la au moins une valeur d'entrée de temporisation respective est une valeur d'entrée ADC du signal d'entrée analogique (201) du convertisseur analogique-numérique (200).

5. Dispositif selon la revendication 4, caractérisé en
que l'unité de temporisation (400) est conçue pour enregistrer au moins temporairement des valeurs du signal d'entrée analogique (201) du convertisseur analogique-numérique (200) sous forme de valeurs d'entrée ADC enregistrées en tant que valeurs d'entrée de temporisation et
l'unité de temporisation (400) étant conçue pour influencer les instants d'échantillonnage en fonction des valeurs d'entrée ADC détectées.

6. Dispositif selon l'une des revendications 4 à 5, **caractérisé en ce que**
que l'unité de temporisation (400) est conçue pour enregistrer au moins temporairement des valeurs du signal d'entrée analogique (201) du convertisseur analogique-numérique (200) sous forme de valeurs d'entrée ADC enregistrées en tant que valeurs d'entrée de temporisation,
l'unité de temporisation (400) est conçue pour influencer au moins une propriété du préfiltre (120) et/ou de l'amplificateur (130) et/ou du filtre de suréchantillonnage et de décimation (300) en fonction des valeurs d'entrée ADC enregistrées,
la propriété influencée par l'unité de temporisation (400) est en particulier au moins une fréquence de filtrage et/ou au moins une amplification et/ou au moins une atténuation d' e du préfiltre (120) et/ou du filtre de suréchantillonnage et de décimation (300), et/ou la propriété influencée par l'unité de synchronisation (400) est en particulier au moins un gain et/ou au moins une atténuation de l'amplificateur (130).

7. Dispositif selon l'une des revendications précédentes, **caractérisé en ce que**
que le signal de valeur d'entrée de l'horloge (401) correspond au signal de sortie numérique (202) du convertisseur analogique-numérique (200),
la au moins une valeur d'entrée de temporisation respective est une valeur de sortie ADC du signal de sortie numérique (202) du convertisseur analogique-numérique (200).

8. Dispositif selon la revendication 7, **caractérisé en ce que**
que l'unité de temporisation (400) est conçue pour enregistrer au moins temporairement des valeurs du signal de sortie (202) du convertisseur analogique-numérique (200) sous forme de valeurs de sortie ADC enregistrées en tant que valeurs d'entrée de temporisation, l'unité de temporisation (400) étant conçue pour influencer des instants d'échantillonnage en fonction des valeurs de sortie ADC enregistrées du signal de sortie numérique (202).
l'unité de temporisation (400) est conçue pour influencer les instants d'échantillonnage en fonction des valeurs de sortie ADC enregistrées du signal de sortie numérique (202).

9. Dispositif selon l'une des revendications 7 à 8, **caractérisé en ce que**
l'unité de synchronisation (400) est conçue pour enregistrer au moins temporairement des valeurs du signal de sortie numérique (202) du convertisseur analogique-numérique (200) sous forme de valeurs de sortie ADC enregistrées en tant que valeurs d'entrée de synchronisation,
l'unité de synchronisation (400) est conçue pour influencer au moins une propriété du préfiltre (120) et/ou de l'amplificateur (130) et/ou du filtre de suréchantillonnage et de décimation (300) en fonction de ces valeurs de sortie ADC détectées,
la propriété influencée par l'unité de synchronisation (400) est en particulier au moins une fréquence de filtrage et/ou au moins un gain et/ou au moins une atténuation du préfiltre (120) et/ou du filtre de suréchantillonnage et de décimation (300), et/ou
la propriété influencée par l'unité de synchronisation (400) est en particulier au moins un gain et/ou au moins une atténuation de l'amplificateur (130).

10. Dispositif selon l'une des revendications précédentes, **caractérisé en ce que**
que le signal de valeur d'entrée de l'horloge (401) correspond à un signal d'entrée de filtre de décimation (301) du filtre de suréchantillonnage et de décimation (300),
la au moins une valeur d'entrée de temporisation respective est une valeur d'entrée de filtre de décimation du filtre de suréchantillonnage et de décimation (300).

11. Dispositif selon la revendication 10, **caractérisé en ce que**
que l'unité de synchronisation (400) est conçue pour enregistrer au moins temporairement des valeurs du signal d'entrée du filtre de décimation (301) sous forme de valeurs d'entrée du filtre de décimation enregistrées en tant que valeurs d'entrée de synchronisation du signal de valeur d'entrée de synchronisation (401), l'unité de temporisation (400) étant conçue pour influencer les instants d'échantillonnage en fonction des valeurs d'entrée du filtre de décimation détectées.

12. Dispositif selon l'une des revendications 10 à 11, **caractérisé en ce que**
l'unité de synchronisation (400) est conçue pour enregistrer au moins temporairement des valeurs du signal d'entrée du filtre de décimation (301) sous forme de valeurs d'entrée du filtre de décimation enregistrées en tant que valeurs d'entrée de l'horloge du signal de valeur d'entrée de l'horloge (401), l'unité de synchronisation (400) étant conçue pour enregistrer au moins une propriété du préfiltre (120) et/ou de l'amplificateur (130) et/ou du filtre de décimation (301) et/ou de la valeur de décimation enregistrée en tant
l'unité de temporisation (400) est conçue pour influencer au moins une propriété du préfiltre (120) et/ou de l'amplificateur (130) et/ou du filtre de suréchantillonnage et de décimation (300) en fonction des valeurs d'entrée du filtre de décimation détectées,
la propriété influencée par l'unité de synchronisation (400) est en particulier au moins une fréquence de filtrage et/ou au moins un gain et/ou au moins une atténuation du préfiltre (120) et/ou du filtre de suréchantillonnage et de décimation (300), et/ou
la propriété influencée par l'unité de synchronisation (400) est en particulier au moins un gain et/ou au moins une atténuation de l'amplificateur (130).

13. Dispositif selon l'une des revendications précédentes, **caractérisé en ce que**
que le signal de valeur d'entrée de l'horloge (401) correspond au signal de sortie du filtre de décimation (302) du filtre de suréchantillonnage et de décimation (300),
la au moins une valeur d'entrée de synchronisation respective est une valeur de sortie du filtre de décimation du signal de sortie du filtre de décimation (302).

14. Dispositif selon la revendication 13, **caractérisé en ce que**
l'unité de synchronisation (400) est conçue pour enregistrer au moins temporairement des valeurs du signal de sortie du filtre de décimation (302) sous forme de valeurs de sortie du filtre de décimation enregistrées en tant que valeurs d'entrée de synchronisation du signal de valeur d'entrée de synchronisation (401), l'unité de synchronisation (400) étant conçue pour influencer les instants d'échantillonnage en fonction des valeurs de sortie du filtre de décimation enregistrées.
l'unité de temporisation (400) est conçue pour influencer les instants d'échantillonnage en fonction des valeurs de sortie du filtre de décimation détectées.

15. Dispositif selon l'une des revendications 13 à 14, **caractérisé en ce que**
l'unité de synchronisation (400) est conçue pour enregistrer au moins temporairement des valeurs du signal de sortie du filtre de décimation (302) sous forme de valeurs de sortie du filtre de décimation enregistrées en tant que valeurs d'entrée de synchronisation d'un signal de valeur d'entrée de synchronisation (401), l'unité de synchronisation (400) étant conçue pour enregistrer au moins une propriété du préfiltre (120) et/ou de l'amplificateur (130) et/ou du filtre de décimation (140) et/ou de la valeur de sortie du filtre de décimation (3 l'unité de temporisation (400) est conçue pour influencer au moins une propriété du préfiltre (120) et/ou de l'amplificateur (130) et/ou du filtre de suréchantillonnage et de décimation (300) en fonction des valeurs de sortie du filtre de décimation détectées,
la propriété influencée par l'unité de synchronisation (400) est en particulier au moins une fréquence de filtrage et/ou au moins une amplification et/ou au moins une atténuation du préfiltre (120) et/ou du filtre de suréchantillonnage et de décimation (300), et/ou
la propriété influencée par l'unité de synchronisation (400) est en particulier au moins un gain et/ou au moins une atténuation de l'amplificateur (130).

16. Dispositif selon l'une des revendications précédentes, **caractérisé en ce qu'**
**en ce qu'**une période d'échantillonnage d'un temps compris entre un premier instant d'échantillonnage de la valeur analogique du signal d'entrée analogique (201) du convertisseur analogique-numérique (200) par le convertisseur analogique-numérique (200) et un deuxième instant d'échantillonnage suivant immédiatement dans le temps de l'échantillonnage de la valeur analogique du signal d'entrée analogique (201) du convertisseur analogique-numérique (200) par le convertisseur analogique-numérique (200), l'unité de synchronisation (400) étant agencée pour influencer la période d'échantillonnage du convertisseur analogique-numérique (200) en fonction de la ou des valeurs d'entrée l'unité de synchronisation (400) est conçue pour influencer la période d'échantillonnage du convertisseur analogique-numérique (200) en fonction de la au moins une valeur d'entrée de synchronisation respective détectée.

17. Dispositif selon la revendication 16, **caractérisé en ce que**
que la période d'échantillonnage est supérieure à une valeur limite de période d'échantillonnage lorsque les valeurs des valeurs d'entrée ADC détectées sont inférieures à une première valeur seuil d'entrée ADC et
la période d'échantillonnage est inférieure à la valeur limite de la période d'échantillonnage lorsque les valeurs des entrées ADC détectées sont supérieures à la première valeur seuil d'entrée ADC.

18. Dispositif selon l'une des revendications 16 à 17, **caractérisé en ce que**
que la période d'échantillonnage est supérieure à une valeur limite de période d'échantillonnage lorsque les valeurs des valeurs de sortie ADC enregistrées sont inférieures à une première valeur seuil de sortie ADC, et
la période d'échantillonnage est inférieure à la valeur limite de la période d'échantillonnage lorsque les valeurs de sortie ADC enregistrées sont supérieures à la première valeur de seuil de sortie ADC.

19. Dispositif selon l'une des revendications 16 à 18, **caractérisé en ce que**
que la période d'échantillonnage est supérieure à la valeur limite de la période d'échantillonnage lorsque les valeurs enregistrées du filtre de décimation sont inférieures à une première valeur seuil d'entrée du filtre de décimation, et
la période d'échantillonnage est inférieure à la valeur limite de la période d'échantillonnage lorsque les valeurs des entrées du filtre de décimation détectées sont supérieures à la première valeur seuil d'entrée du filtre de décimation.

20. Dispositif selon l'une des revendications 16 à 19, **caractérisé en ce que**
que la période d'échantillonnage est supérieure à une valeur limite de période d'échantillonnage lorsque les valeurs des valeurs de sortie du filtre de décimation détectées sont inférieures à la première valeur seuil de sortie du filtre de décimation et
la période d'échantillonnage est inférieure à la valeur limite de la période d'échantillonnage lorsque les valeurs des filtres de décimation détectées sont supérieures à la première valeur de seuil de sortie du filtre de décimation.

21. Dispositif selon l'une des revendications précédentes, **caractérisé en ce que**
le filtre de suréchantillonnage et de décimation (300) présente une fréquence limite supérieure (fₒ),
le filtre de suréchantillonnage et de décimation (300) est conçu pour atténuer plus fortement les composantes de signal ayant une fréquence de composante de signal supérieure à la fréquence limite supérieure (fₒ) que les composantes de signal ayant une fréquence de composante de signal immédiatement inférieure à la fréquence limite supérieure (fₒ) et dans lequel
l'unité de synchronisation (400) est conçue pour influencer la fréquence limite supérieure (fₒ) du filtre de suréchantillonnage et de décimation (300) en fonction de la au moins une valeur d'entrée de synchronisation respective détectée.

22. Dispositif selon la revendication 21, **caractérisé en ce que**
que la fréquence limite supérieure (fₒ) du filtre de suréchantillonnage et de décimation (300) est supérieure à une valeur limite de fréquence limite de décimation lorsque les valeurs des valeurs d'entrée ADC détectées sont inférieures à une deuxième valeur seuil d'entrée ADC, et la fréquence limite supérieure (fₒ) du filtre de suréchantillonnage et de décimation (300) est inférieure à la valeur limite de fréquence de décimation lorsque les valeurs des entrées ADC détectées sont supérieures à la deuxième valeur seuil d'entrée ADC.

23. Dispositif selon l'une des revendications 21 à 22, **caractérisé en ce que**
que la fréquence limite supérieure (fₒ) du filtre de suréchantillonnage et de décimation (300) est supérieure à la valeur limite de fréquence de décimation lorsque les valeurs des valeurs de sortie ADC détectées sont inférieures à une deuxième valeur seuil de sortie ADC, et
la fréquence limite supérieure (fₒ) du filtre de suréchantillonnage et de décimation (300) est inférieure à la valeur limite de fréquence de décimation lorsque les valeurs des valeurs de sortie ADC détectées sont supérieures à la deuxième valeur seuil de sortie ADC.

24. Dispositif selon l'une des revendications 21 à 23, caractérisé en
que la fréquence limite supérieure (fₒ) du filtre de suréchantillonnage et de décimation (300) est supérieure à la valeur limite de fréquence de décimation lorsque les valeurs des entrées du filtre de décimation détectées sont inférieures à une deuxième valeur seuil d'entrée du filtre de décimation, et
la fréquence limite supérieure (fₒ) du filtre de suréchantillonnage et de décimation (300) est inférieure à la valeur limite de fréquence limite de décimation lorsque les valeurs des entrées du filtre de décimation détectées sont supérieures à la deuxième valeur seuil d'entrée du filtre de décimation.

25. Dispositif selon l'une des revendications 21 à 24, **caractérisé en ce que**
que la fréquence limite supérieure (fₒ) du filtre de suréchantillonnage et de décimation (300) est supérieure à la valeur limite de fréquence de décimation lorsque les valeurs des valeurs de sortie du filtre de décimation détectées sont inférieures à une deuxième valeur seuil de sortie du filtre de décimation, et
la fréquence limite supérieure (fₒ) du filtre de suréchantillonnage et de décimation (300) est supérieure à la valeur limite de fréquence de décimation lorsque les valeurs des valeurs de sortie du filtre de décimation détectées sont supérieures à la deuxième valeur seuil de sortie du filtre de décimation.

26. Dispositif selon l'une des revendications précédentes, **caractérisé en ce que**
que le préfiltre (120) présente une fréquence limite supérieure (f_{oV}),
le préfiltre (120) est conçu pour atténuer plus fortement les composantes de signal ayant une fréquence de composante de signal supérieure à la fréquence limite supérieure (f_{oV}) que les composantes de signal ayant une fréquence de composante de signal immédiatement inférieure à la fréquence limite supérieure (f_{oV}), et dans lequel
l'unité de temporisation (400) est conçue pour influencer la fréquence limite supérieure (f_{oV}) du préfiltre (120) en fonction de la ou des valeurs d'entrée de temporisation respectives détectées.

27. Dispositif selon la revendication 26, **caractérisé en ce que**
que la fréquence limite supérieure (f_{oV}) du préfiltre (120) est supérieure à une valeur limite de fréquence limite du préfiltre lorsque les valeurs des valeurs d'entrée ADC détectées sont inférieures à une troisième valeur seuil d'entrée ADC, et que la fréquence limite supérieure (f_{oV}) du préfiltre (120) est inférieure à la valeur limite de fréquence limite du préfiltre lorsque les valeurs des entrées ADC détectées sont supérieures à la troisième valeur seuil d'entrée ADC.

28. Dispositif selon l'une des revendications 26 à 27, **caractérisé en ce que**
que la fréquence limite supérieure (f_{oV}) du préfiltre (120) est supérieure à la valeur limite de fréquence limite du préfiltre lorsque les valeurs des valeurs de sortie ADC détectées sont inférieures à la troisième valeur seuil de sortie ADC, et que la fréquence limite supérieure (f_{oV}) du préfiltre (120) est inférieure à la valeur limite de fréquence limite du préfiltre lorsque les valeurs des valeurs de sortie ADC détectées sont supérieures à la troisième valeur de seuil de sortie ADC.

29. Dispositif selon l'une des revendications 26 à 28, **caractérisé en ce que**
que la fréquence limite supérieure (f_{oV}) du préfiltre (120) est supérieure à la valeur limite de fréquence limite du préfiltre lorsque les valeurs des valeurs d'entrée du filtre de décimation détectées sont inférieures à la troisième valeur seuil d'entrée du filtre de décimation, et que la fréquence limite supérieure (f_{oV}) du préfiltre (120) est inférieure à la valeur limite de fréquence limite du préfiltre lorsque les valeurs des valeurs d'entrée du filtre de décimation détectées sont supérieures à la troisième valeur seuil d'entrée du filtre de décimation.

30. Dispositif selon l'une des revendications 26 à 29, **caractérisé en ce que**
que la fréquence limite supérieure (f_{oV}) du préfiltre (120) est supérieure à la valeur limite de fréquence limite du préfiltre lorsque les valeurs des valeurs de sortie du filtre de décimation détectées sont inférieures à la troisième valeur seuil de sortie du filtre de décimation, et que la fréquence limite supérieure (f_{oV}) du préfiltre (120) est supérieure à la valeur limite de fréquence limite du préfiltre lorsque les valeurs des valeurs de sortie du filtre de décimation détectées sont supérieures à la troisième valeur seuil de sortie du filtre de décimation.

31. Dispositif selon l'une des revendications précédentes, **caractérisé en ce que**
que l'amplificateur (130) présente des propriétés, en particulier une amplification et/ou une atténuation de l'amplificateur (130), avec des valeurs de propriétés respectives, l'unité de temporisation (400) étant conçue pour influencer cette propriété de l'amplificateur (130) en fonction de la au moins une valeur d'entrée de temporisation respective détectée.

32. Dispositif selon la revendication 31, **caractérisé en ce que**
que la valeur de la propriété respective de l'amplificateur (130) est supérieure à une valeur limite de propriété de l'amplificateur lorsque les valeurs des valeurs d'entrée ADC enregistrées sont inférieures à une quatrième valeur seuil d'entrée ADC, et
la valeur de la propriété respective de l'amplificateur (130) est inférieure à la valeur limite de la propriété de l'amplificateur lorsque les valeurs des entrées ADC détectées sont supérieures à la quatrième valeur seuil d'entrée ADC, ou
la valeur de la propriété correspondante de l'amplificateur (130) est inférieure à la valeur limite de la propriété de l'amplificateur lorsque les valeurs de l'entrée ADC détectées sont inférieures à la quatrième valeur seuil d'entrée ADC, et
la valeur de la propriété correspondante de l'amplificateur (130) est supérieure à la valeur limite de la propriété de l'amplificateur lorsque les valeurs des entrées ADC détectées sont supérieures à la quatrième valeur seuil d'entrée ADC.

33. Dispositif selon l'une des revendications 31 à 32, **caractérisé en ce que**
que la valeur de la propriété correspondante de l'amplificateur (130) est supérieure à la valeur limite de la propriété de l'amplificateur lorsque les valeurs de sortie ADC enregistrées sont inférieures à un quatrième seuil de sortie ADC, et
la valeur de la propriété respective de l'amplificateur (130) est inférieure à la valeur limite de la propriété de l'amplificateur lorsque les valeurs de sortie ADC enregistrées sont supérieures à la quatrième valeur seuil de sortie ADC, ou
la valeur de la propriété correspondante de l'amplificateur (130) est inférieure à la valeur limite de la propriété de l'amplificateur lorsque les valeurs de sortie ADC enregistrées sont inférieures à la quatrième valeur de seuil de sortie ADC, et
la valeur de la propriété correspondante de l'amplificateur (130) est supérieure à la valeur limite de la propriété de l'amplificateur lorsque les valeurs de sortie ADC enregistrées sont supérieures à la quatrième valeur seuil de sortie ADC.

34. Dispositif selon l'une des revendications 31 à 33, **caractérisé en ce que**
que la valeur de la propriété correspondante de l'amplificateur (130) est supérieure à la valeur limite de la propriété de l'amplificateur lorsque les valeurs enregistrées des entrées du filtre de décimation sont inférieures à une quatrième valeur seuil d'entrée du filtre de décimation, et
la valeur de la propriété correspondante de l'amplificateur (130) est inférieure à la valeur limite de la propriété de l'amplificateur lorsque les valeurs des entrées du filtre de décimation détectées sont supérieures à la quatrième valeur seuil d'entrée du filtre de décimation, ou
la valeur de la propriété correspondante de l'amplificateur (130) est inférieure à la valeur limite de la propriété de l'amplificateur lorsque les valeurs des valeurs d'entrée du filtre de décimation détectées sont inférieures à la quatrième valeur seuil d'entrée du filtre de décimation, et
la valeur de la propriété correspondante de l'amplificateur (130) est supérieure à la valeur limite de la propriété de l'amplificateur lorsque les valeurs des valeurs d'entrée du filtre de décimation détectées sont supérieures à la quatrième valeur seuil d'entrée du filtre de décimation.

35. Dispositif selon l'une des revendications 31 à 34, **caractérisé en ce que**
que la valeur de la propriété correspondante de l'amplificateur (130) est inférieure à la valeur limite de la propriété de l'amplificateur lorsque les valeurs des valeurs de sortie du filtre de décimation détectées sont inférieures à un quatrième seuil de sortie du filtre de décimation, et
la valeur de la propriété respective de l'amplificateur (130) est supérieure à la valeur limite de la propriété de l'amplificateur lorsque les valeurs des valeurs de sortie du filtre de décimation détectées sont supérieures à la quatrième valeur seuil de sortie du filtre de décimation, ou
la valeur de la propriété correspondante de l'amplificateur (130) est supérieure à la valeur limite de la propriété de l'amplificateur lorsque les valeurs des valeurs de sortie du filtre de décimation détectées sont inférieures à la quatrième valeur seuil de sortie du filtre de décimation, et
la valeur de la propriété correspondante de l'amplificateur (130) est inférieure à la valeur limite de la propriété de l'amplificateur lorsque les valeurs des valeurs de sortie du filtre de décimation détectées sont supérieures à la quatrième valeur seuil de sortie du filtre de décimation.

36. Dispositif pour détecter un courant électrique (I_{LTG}) dans une ligne, comprenant
- une résistance shunt (113),
- un préfiltre (120),
- un amplificateur (130),
- un convertisseur analogique-numérique (200), et
- un filtre de suréchantillonnage et de décimation (300), dans lequel
le courant électrique (I_{LTG}) traverse la résistance shunt (113), et
une tension de résistance shunt (U_{S}) chute aux bornes de la résistance shunt (113), et dans lequel le préfiltre (120) est conçu pour préfiltrer la tension de résistance shunt (U_{S}) en une tension d'entrée d'amplificateur (Uₑ), et dans lequel
l'amplificateur (130) est conçu pour détecter la tension d'entrée de l'amplificateur (Uₑ) et pour l'amplifier en un signal de sortie de l'amplificateur (133), et dans lequel
le convertisseur analogique-numérique (200) est conçu pour échantillonner le signal de sortie de l'amplificateur (133) à une fréquence d'échantillonnage et pour le convertir en un signal d'entrée de filtre de décimation (301), et dans lequel
le filtre de suréchantillonnage et de décimation (300) est conçu pour filtrer le signal d'entrée du filtre de décimation (301) en un signal de sortie du filtre de décimation (302), et dans lequel
le dispositif est conçu pour fournir le signal de sortie de filtre de décimation (302) en tant que signal de valeur mesurée pour au moins une valeur du courant électrique de ligne (I_{LTG}) dans une ligne,
**caractérisé en ce que**
le préfiltre (120) est conçu pour filtrer la tension de résistance shunt (U_{S}) par rapport à la tension d'entrée de l'amplificateur (Uₑ) en fonction d'une valeur du signal de sortie de l'amplificateur (133) en tant que valeur d'entrée de la minuterie, et/ou
le préfiltre (20) est conçu pour filtrer la tension de résistance shunt (U_{S}) par rapport à la tension d'entrée de l'amplificateur (Uₑ) en fonction d'une valeur du signal d'entrée du filtre de décimation (301) en tant que valeur d'entrée de la minuterie, et/ou
le préfiltre (120) étant conçu pour filtrer la tension de résistance shunt (U_{S}) par rapport à la tension d'entrée de l'amplificateur (Uₑ) en fonction d'une valeur du signal de sortie du filtre de décimation (302) en tant que valeur d'entrée de la horloge, et/ou
que l'amplificateur (130) est conçu pour détecter et amplifier la tension d'entrée de l'amplificateur (Uₑ) vers le signal de sortie de l'amplificateur (133) en fonction de la valeur du signal de sortie de l'amplificateur (133) en tant que valeur d'entrée de la horloge, et/ou
que l'amplificateur (130) est conçu pour détecter et amplifier la tension d'entrée de l'amplificateur (Uₑ) vers le signal de sortie de l'amplificateur (133) en fonction de la valeur du signal d'entrée du filtre de décimation (301) en tant que valeur d'entrée de la minuterie, et/ou
que l'amplificateur (130) est conçu pour détecter et amplifier la tension d'entrée de l'amplificateur (Uₑ) vers le signal de sortie de l'amplificateur (133) en fonction de la valeur du signal de sortie du filtre de décimation (302) en tant que valeur d'entrée de la horloge, et/ou
le convertisseur analogique-numérique (200) est conçu pour échantillonner le signal de sortie de l'amplificateur (133) à la fréquence d'échantillonnage du signal d'entrée du filtre de décimation (301) en fonction de la valeur du signal de sortie de l'amplificateur (133) en tant que valeur d'entrée de la hor, et/ou
que le convertisseur analogique-numérique (200) est conçu pour échantillonner le signal de sortie de l'amplificateur (133) à la fréquence d'échantillonnage du signal d'entrée du filtre de décimation (301) en fonction de la valeur du signal d'entrée du filtre de décimation (301) en tant que valeur d'entrée de la horloge, et/ou
que le convertisseur analogique-numérique (200) est conçu pour échantillonner le signal de sortie de l'amplificateur (133) à la fréquence d'échantillonnage vers le signal d'entrée du filtre de décimation (301) en fonction de la valeur du signal de sortie du filtre de décimation (302) en tant que valeur d'entrée de l'horloge, et/ou
que le filtre de suréchantillonnage et de décimation (300) est conçu pour filtrer le signal d'entrée du filtre de décimation (301) vers le signal de sortie du filtre de décimation (302) en fonction de la valeur du signal de sortie de l'amplificateur (133) en tant que valeur d'entrée de l'horloge, et/ou
que le filtre de suréchantillonnage et de décimation (300) est conçu pour filtrer le signal d'entrée du filtre de décimation (301) vers le signal de sortie du filtre de décimation (302) en fonction de la valeur du signal d'entrée du filtre de décimation (301) en tant que valeur d'entrée de la horloge, et/ou
que le filtre de suréchantillonnage et de décimation (300) est conçu pour filtrer le signal d'entrée du filtre de décimation (301) vers le signal de sortie du filtre de décimation (302) en fonction de la valeur du signal de sortie du filtre de décimation (302) en tant que valeur d'entrée de l'horloge.

37. Dispositif selon la revendication 36, **caractérisé en ce que**
qu'une propriété de filtrage du préfiltre (120), en particulier une fréquence de coupure du préfiltre (f_{oV}), dépend de la valeur d'entrée de la source d'horloge.

38. Dispositif selon la revendication 36, **caractérisé en ce qu'**
qu'une propriété de l'amplificateur (130), en particulier un gain ou une atténuation, dépend de la valeur d'entrée de la source d'horloge.

39. Dispositif selon la revendication 36, **caractérisé en ce qu'**
qu'une propriété du convertisseur analogique-numérique (200), en particulier un instant d'échantillon et/ou la période d'échantillonnage, dépend de la valeur d'entrée de l'horloge.

40. Dispositif selon la revendication 36, **caractérisé en ce qu'**
qu'une propriété du filtre de suréchantillonnage et de décimation (300), en particulier une fréquence de coupure du filtre (fₒ), dépend de la valeur d'entrée de la horloge.

41. Dispositif selon la revendication 37, **caractérisé en ce que**
que la fréquence limite du préfiltre (f_{oV}) est supérieure à une valeur limite du préfiltre lorsque les valeurs des entrées de la source d'horloge sont inférieures à une première valeur seuil d'entrée, et
la fréquence limite du préfiltre (f_{oV}) est inférieure à la valeur limite du préfiltre lorsque les valeurs d'entrée de la source d'horloge sont supérieures à la première valeur d'entrée seuil, ou
la fréquence limite du préfiltre (f_{oV}) est inférieure à la valeur limite du préfiltre lorsque les valeurs d'entrée de la valeur d'entrée du temps sont inférieures à la première valeur d'entrée seuil, et
la fréquence limite du préfiltre (f_{oV}) est supérieure à la valeur limite du préfiltre lorsque les valeurs d'entrée de la valeur d'entrée de l'horloge sont supérieures à la première valeur seuil d'entrée.

42. Dispositif selon la revendication 38, **caractérisé en ce qu'**
qu'une valeur de l'amplification est supérieure à une valeur limite d'amplification lorsque des valeurs d'entrée de la valeur d'entrée de l'horloge sont inférieures à une deuxième valeur seuil d'entrée, et
la valeur de l'amplification est inférieure à la valeur limite d'amplification lorsque les valeurs de l'entrée de la valeur de consigne sont supérieures à la deuxième valeur d'entrée seuil, ou la valeur de l'amplification est inférieure à la valeur limite d'amplification lorsque les valeurs d'entrée de l'horloge sont inférieures à la deuxième valeur seuil d'entrée, et
la valeur de l'amplification est supérieure à la valeur limite d'amplification lorsque les valeurs des entrées de temporisation sont supérieures à la deuxième valeur seuil d'entrée.

43. Dispositif selon la revendication 39, **caractérisé en ce que**
que la période d'échantillonnage est supérieure à une valeur limite de période d'échantillonnage lorsque les valeurs des entrées de temporisation sont inférieures à une troisième valeur seuil d'entrée, et
la période d'échantillonnage est inférieure à la valeur limite de période d'échantillonnage lorsque les valeurs d'entrée de l'horloge sont supérieures à la troisième valeur seuil d'entrée, ou
la période d'échantillonnage est inférieure à la valeur limite de la période d'échantillonnage lorsque les valeurs d'entrée de l'horloge sont inférieures à la troisième valeur seuil d'entrée, et
la période d'échantillonnage est supérieure à la valeur limite de la période d'échantillonnage lorsque les valeurs d'entrée de la temporisation sont supérieures à la troisième valeur d'entrée.

44. Dispositif selon la revendication 40, **caractérisé en ce que**
qu'une valeur de la fréquence de coupure du filtre (fₒ) est supérieure à une valeur limite de fréquence de coupure du filtre lorsque des valeurs d'entrée de l'horloge sont inférieures à une quatrième valeur seuil d'entrée, et
la valeur de la fréquence limite du filtre (fₒ) est inférieure à la valeur limite de la fréquence limite du filtre lorsque les valeurs des entrées de la minuterie sont supérieures à la quatrième valeur seuil d'entrée, ou
la valeur de la fréquence de coupure du filtre (fₒ) est inférieure à la valeur limite de la fréquence de coupure du filtre lorsque les valeurs de l'entrée de la horloge sont inférieures à une quatrième valeur seuil d'entrée, et
la valeur de la fréquence limite du filtre (fₒ) est supérieure à la valeur limite de la fréquence limite du filtre lorsque les valeurs de l'entrée de la horloge sont supérieures à la quatrième valeur seuil d'entrée.

45. Dispositif pour détecter un courant électrique (I_{LTG}) dans une ligne, comprenant
- une première unité de commutation (100),
- un convertisseur analogique-numérique (200), et
- un filtre de suréchantillonnage et de décimation (300), dans lequel
le courant électrique circule à travers la première unité de commutation (100), et
la première unité de circuit (100) est conçue pour détecter l'évolution dans le temps de la valeur du courant électrique (I_{LTG} ) dans la ligne et pour la convertir en un signal de sortie d'amplificateur (133), et dans lequel
le convertisseur analogique-numérique (200) est conçu pour échantillonner le signal de sortie de l'amplificateur (133) à une fréquence d'échantillonnage et pour le convertir en un signal d'entrée de filtre de décimation (301), et dans lequel
le filtre de suréchantillonnage et de décimation (300) est conçu pour filtrer le signal d'entrée du filtre de décimation (301) en un signal de sortie du filtre de décimation (302), et dans lequel
le dispositif est conçu pour fournir le signal de sortie du filtre de décimation (302) comme signal de mesure pour au moins une valeur du courant électrique de ligne (I_{LTG}) dans une ligne,
**caractérisé en ce que**
le convertisseur analogique-numérique (200) est conçu pour échantillonner le signal de sortie de l'amplificateur (133) avec la fréquence d'échantillonnage vers le signal d'entrée du filtre de décimation (301) en fonction d'une valeur d' e du signal de sortie de l'amplificateur (133) en tant que valeur d'entrée de l'horloge, et/ou
le convertisseur analogique-numérique (200) est conçu pour échantillonner le signal de sortie de l'amplificateur (133) à la fréquence d'échantillonnage vers le signal d'entrée du filtre de décimation (301) en fonction d'une valeur du signal d'entrée du filtre de décimation (301) en tant que valeur d'entrée de la horloge, et/ou
que le convertisseur analogique-numérique (200) est conçu pour échantillonner le signal de sortie de l'amplificateur (133) avec une fréquence d'échantillonnage vers le signal d'entrée du filtre de décimation (301) en fonction d'une valeur du signal de sortie du filtre de décimation (302) en tant que valeur d'entrée de l'horloge, et/ou
que le filtre de suréchantillonnage et de décimation (300) est conçu pour filtrer le signal d'entrée du filtre de décimation (301) vers le signal de sortie du filtre de décimation (302) en fonction de la valeur du signal de sortie de l'amplificateur (133) en tant que valeur d'entrée de la horloge, et/ou
que le filtre de suréchantillonnage et de décimation (300) est conçu pour filtrer le signal d'entrée du filtre de décimation (301) vers le signal de sortie du filtre de décimation (302) en fonction de la valeur du signal d'entrée du filtre de décimation (301) en tant que valeur d'entrée de la horloge, et/ou
que le filtre de suréchantillonnage et de décimation (300) est conçu pour filtrer le signal d'entrée du filtre de décimation (301) vers le signal de sortie du filtre de décimation (302) en fonction de la valeur du signal de sortie du filtre de décimation (302) en tant que valeur d'entrée de l'horloge.

46. Dispositif selon la revendication 45, **caractérisé en ce que**
que la première unité de commutation (100) comprend
- une résistance shunt (113)
- un préfiltre (120), et
- un amplificateur (130), dans lequel
le courant électrique de ligne (I_{LTG}) passe à travers la résistance shunt (113), et
une tension de résistance shunt (U_{S}) chute à travers la résistance shunt (113), la
le préfiltre (120) est conçu pour préfiltrer la tension de résistance shunt (U_{S}) en une tension d'entrée d'amplificateur (Uₑ), et dans lequel
l'amplificateur (130) est conçu pour détecter la tension d'entrée de l'amplificateur (Uₑ) et pour l'amplifier vers le signal de sortie de l'amplificateur (133).

47. Dispositif selon l'une des revendications 45 à 46, **caractérisé en ce qu'**
qu'une propriété du convertisseur analogique-numérique (200), en particulier un instant d'échantillonnage et/ou la période d'échantillonnage, dépend de la valeur d'entrée de l'horloge.

48. Dispositif selon l'une des revendications 45 à 46, **caractérisé en ce qu'**
qu'une propriété du filtre de suréchantillonnage et de décimation (300), en particulier une fréquence de coupure du filtre (fₒ), dépend de la valeur d'entrée de l'horloge.

49. Dispositif selon la revendication 47, **caractérisé en ce que**
que la période d'échantillonnage est supérieure à une valeur limite de période d'échantillonnage lorsque les valeurs d'entrée de l'horloge sont inférieures à une troisième valeur seuil d'entrée, et
la période d'échantillonnage est inférieure à la valeur limite de la période d'échantillonnage lorsque les valeurs d'entrée de l'horloge sont supérieures à la troisième valeur seuil d'entrée, ou
la période d'échantillonnage est inférieure à la valeur limite de la période d'échantillonnage lorsque les valeurs d'entrée de la minuterie sont inférieures à la troisième valeur seuil d'entrée, et
la période d'échantillonnage est supérieure à la valeur limite de la période d'échantillonnage lorsque les valeurs d'entrée de la minuterie sont supérieures à la troisième valeur d'entrée seuil.

50. Dispositif selon la revendication 48, **caractérisé en ce que**
qu'une valeur de la fréquence de coupure du filtre (fₒ) est supérieure à une valeur limite de fréquence de coupure du filtre lorsque des valeurs de signaux d'entrée de la horloge sont inférieures à une quatrième valeur seuil d'entrée, et
la valeur de la fréquence de coupure du filtre (fₒ) est inférieure à la valeur limite de la fréquence de coupure du filtre lorsque les valeurs d'entrée de l'horloge sont supérieures à la quatrième valeur seuil d'entrée, ou
la valeur de la fréquence de coupure du filtre (fₒ) est inférieure à la valeur limite de la fréquence de coupure du filtre lorsque les valeurs de l'entrée de la horloge sont inférieures à une quatrième valeur seuil d'entrée, et
la valeur de la fréquence limite du filtre (fₒ) est supérieure à la valeur limite de la fréquence limite du filtre lorsque les valeurs de l'entrée de la horloge sont supérieures à la quatrième valeur seuil d'entrée.

51. Procédé pour détecter un courant électrique (I_{LTG}) dans une ligne au moyen d'un dispositif selon l'une des revendications précédentes, le courant électrique (I_{LTG}) circulant à travers une résistance shunt (113) et une tension de résistance shunt (U_{S}) chutant à travers la résistance shunt (113),
le procédé comprenant les étapes suivantes :
- préfiltrage de la tension de résistance shunt (U_{S}) en une tension d'entrée d'amplificateur (Uₑ) ;
- détection et amplification de la tension d'entrée de l'amplificateur (Uₑ) en un signal de sortie de l'amplificateur (133) ;
- échantillonnage du signal de sortie de l'amplificateur (133) à une fréquence d'échantillonnage pour obtenir un signal d'entrée de filtre de décimation (301) ;
- filtrage du signal d'entrée du filtre de décimation (301) en un signal de sortie du filtre de décimation (302) ;
- fournir le signal de sortie du filtre de décimation (302) comme signal de mesure pour au moins une valeur du courant électrique de ligne (I_{LTG}) dans une ligne,
**caractérisé en ce que**
que le préfiltrage de la tension de résistance shunt (U_{S}) vers la tension d'entrée de l'amplificateur (Uₑ) et/ou
la détection et l'amplification de la tension d'entrée de l'amplificateur (Uₑ) vers le signal de sortie de l'amplificateur (133), et/ou
l'échantillonnage du signal de sortie de l'amplificateur (133) avec la fréquence d'échantillonnage vers le signal d'entrée du filtre de décimation (301), et/ou
le filtrage du signal d'entrée du filtre de décimation (301) vers le signal de sortie du filtre de décimation (302)
- dépend d'une valeur du signal de sortie de l'amplificateur (133) en tant que valeur d'entrée de l'horloge, et/ou
- dépend d'une valeur du signal d'entrée du filtre de décimation (301) en tant que valeur d'entrée de l'horloge, et/ou
- dépend d'une valeur du signal de sortie du filtre de décimation (302) en tant que valeur d'entrée de l'horloge.

52. Procédé selon la revendication 51, **caractérisé en ce que**
qu'une propriété de filtrage du préfiltre de la tension de résistance shunt (U_{S}) vers la tension d'entrée de l'amplificateur (Uₑ), en particulier une fréquence limite du préfiltre (f_{oV}), dépend de la valeur d'entrée de l'horloge.

53. Procédé selon la revendication 51, **caractérisé en ce qu'**
qu'une propriété de détection et d'amplification de la tension d'entrée de l'amplificateur (Uₑ) par rapport au signal de sortie de l'amplificateur (133), en particulier une amplification ou une atténuation, dépend de la valeur d'entrée de l'horloge.

54. Procédé selon la revendication 51, **caractérisé en ce qu'**
qu'une propriété de l'échantillonnage du signal de sortie de l'amplificateur (133) vers le signal d'entrée du filtre de décimation (301), en particulier un moment d'échantillonnage et/ou une période d'échantillonnage, dépend de la valeur d'entrée de l'horloge.

55. Procédé selon la revendication 51, **caractérisé en ce qu'**
qu'une propriété du filtrage du signal d'entrée du filtre de décimation (301) vers le signal de sortie du filtre de décimation (302), en particulier une fréquence de coupure du filtre (fₒ), dépend de la valeur d'entrée de l'horloge.

56. Procédé selon la revendication 52, **caractérisé en ce que**
que la fréquence de coupure du préfiltre (f_{oV}) est supérieure à une valeur limite du préfiltre lorsque les valeurs des entrées de la horloge sont inférieures à une première valeur seuil d'entrée, et
la fréquence limite du préfiltre (f_{oV}) est inférieure à la valeur limite du préfiltre lorsque les valeurs des entrées de la valeur d'entrée de l'horloge sont supérieures à la première valeur seuil d'entrée, ou
la fréquence limite du préfiltre (f_{oV}) est inférieure à la valeur limite du préfiltre lorsque les valeurs d'entrée de la valeur d'entrée de l'horloge sont inférieures à la première valeur d'entrée seuil, et
la fréquence limite du préfiltre (f_{oV}) est supérieure à la valeur limite du préfiltre lorsque les valeurs d'entrée de l'horloge sont supérieures à la première valeur seuil d'entrée.

57. Procédé selon la revendication 53, **caractérisé en ce**
**qu'**une valeur de l'amplification est supérieure à une valeur limite d'amplification lorsque des valeurs de valeurs d'entrée de l'horloge sont inférieures à une deuxième valeur d'entrée seuil, et
la valeur du gain est inférieure à la valeur limite de gain lorsque les valeurs des entrées de temporisation sont supérieures à la deuxième valeur d'entrée seuil, ou
la valeur de l'amplification est inférieure à la valeur limite d'amplification lorsque les valeurs des entrées de temporisation sont inférieures à la deuxième valeur d'entrée seuil, et
la valeur du gain est supérieure à la valeur limite de gain lorsque les valeurs des entrées de temporisation sont supérieures à la deuxième valeur d'entrée seuil.

58. Procédé selon la revendication 54, **caractérisé en ce que**
que la période d'échantillonnage est supérieure à une valeur limite de période d'échantillonnage lorsque les valeurs des entrées de la source d'horloge sont inférieures à une troisième valeur seuil d'entrée, et
la période d'échantillonnage est inférieure à la valeur limite de période d'échantillonnage lorsque les valeurs des entrées de la valeur d'entrée de l'horloge sont supérieures à la troisième valeur seuil d'entrée, ou
la période d'échantillonnage est inférieure à la valeur limite de la période d'échantillonnage lorsque les valeurs d'entrée de la horloge sont inférieures à la troisième valeur seuil d'entrée, et
la période d'échantillonnage est supérieure à la valeur limite de la période d'échantillonnage lorsque les valeurs d'entrée de la minuterie sont supérieures à la troisième valeur d'entrée seuil.

59. Procédé selon la revendication 55, **caractérisé en ce que**
qu'une valeur de la fréquence limite du filtre (fₒ) est supérieure à une valeur limite de fréquence limite du filtre lorsque des valeurs des entrées de la source d'horloge sont inférieures à une quatrième valeur seuil d'entrée, et
la valeur de la fréquence limite du filtre (fₒ) est inférieure à la valeur limite de la fréquence limite du filtre lorsque les valeurs des entrées de la valeur d'entrée de l'horloge sont supérieures à la quatrième valeur seuil d'entrée, ou
la valeur de la fréquence de coupure du filtre (fₒ) est inférieure à la valeur limite de la fréquence de coupure du filtre lorsque les valeurs de l'entrée de l'horloge sont inférieures à la quatrième valeur seuil d'entrée, et
la valeur de la fréquence limite du filtre (fₒ) est supérieure à la valeur limite de la fréquence limite du filtre lorsque les valeurs de l'entrée de la horloge sont supérieures à la quatrième valeur seuil d'entrée.
